(19) Europäisches Patentamt
European Patent Office
Office européen des brevets

(11) EP 2 677 559 B1

(12) # EUROPEAN PATENT SPECIFICATION

(45) Date of publication and mention of the grant of the patent:
**13.09.2017 Bulletin 2017/37**

(51) Int Cl.:
***H01L 51/54*** *(2006.01)*

(21) Application number: **13172420.5**

(22) Date of filing: **18.06.2013**

(54) **Organic electroluminescent element, display device and lighting device**

Organisches elektrolumineszentes Element, Anzeigevorrichtung und Beleuchtungsvorrichtung

Élément électroluminescent organique, dispositif d'affichage et dispositif d'éclairage

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **21.06.2012 JP 2012139328**

(43) Date of publication of application:
**25.12.2013 Bulletin 2013/52**

(73) Proprietor: **Konica Minolta, Inc.**
**Tokyo 100-7015 (JP)**

(72) Inventors:
- **Hakoi, Yutaro**
  **Tokyo, Tokyo 100-7015 (JP)**
- **Yasukawa, Noriko**
  **Tokyo, Tokyo 100-7015 (JP)**

(74) Representative: **Gille Hrabal**
**Brucknerstrasse 20**
**40593 Düsseldorf (DE)**

(56) References cited:
**US-A1- 2011 204 333**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 677 559 B1

**Description**

BACKGROUND OF THE INVENTION

1. Field of the Invention

The present invention relates to an organic electroluminescent element, a display device including the organic EL element(s) and an lighting device including the organic EL element(s).

2. Description of Related art

In an organic electroluminescent element (hereinafter also referred to as an "organic EL element"), a light-emitting layer containing a light-emitting compound is provided between an anode and cathode. Electrons and electron holes are inj ected in the light-emitting layer to be combined to each other, thereby generating excitons. An organic EL element emits light (fluorescence, phosphorescence and the like) produced upon deactivation of the excitons and requires a voltage of only a few to a few dozen volt for light emission. Thus, an organic EL element is of particular interest as a future material for planar displays and lighting devices.

Princeton University has published a report regarding the organic electroluminescent element using phosphorescence produced from the triplet excited state in a maximum internal quantum efficiency of 100% (seeM. A. Baldo et al. (1998), Nature Vol. 395, pp. 151-154). After that, research for materials producing phosphorescence at room temperature was disclosed by M. A. Baldo et al. (2000), Nature Vol. 403-17, pp. 750-753 and US patent No. 6,097,147, for example.

In addition, as the material emitting phosphorescence at room temperature, heavy-metal complexes such as iridium complexes have been studied and disclosed in C. Adachi et al. (2001), Appl. Phys. Lett., vol. 79, pp. 2082-2084, for example.

As for iridium complexes as heavy-metal complexes, tris (2-phenylpyridine) iridium complexes are widely known, for example (see M. A. Baldo et al. (2000), Nature Vol. 403-17, for example). Further, an iridium complex containing a ligand where a tris(2-phenylpyridine) moiety is introduced into a silyl group for improving durability of dopants and efficiency of light emission is disclosed in Japanese Patent Application Laid-Open Publication No. 2005-327526, for example.

However, the above dopants in an organic EL element has not been able to provide an element with sufficient performance in relation to lifetime of light emission and the like.

In addition to tris (2-phenylpyridine) iridium complexes, iridium complexes containing phenylimidazole ligands or carbene ligands are disclosed (see International Patent Publications WO2006/046980 and WO2005/019373, for example). Such compounds are of particular interest because these compounds provide light of shorter wavelength comparing to complexes containing phenylpyridine ligands.

Meanwhile, iridium complexes where phenylimidazole ligands are substituted with compounds having ring-fused structures such as dibenzofuran are disclosed (see US Patent Application Publication No. 2011-0204333, for example). These disclosed complexes improve lifetime of elements because phosphorescence lifetimes are shorter, however causing further problems such as requiring high driving voltage and lowering light-emitting efficiency. A light-emitting layer of an organic EL element, which layer is composed of dopants and hosts, may cause problems such as concentration quenching due to transportability of carrier and aggregation of light-emitting dopants, and quenching due to mutual interaction between excitons. Thus, it is desirable that light-emitting dopants are evenly dispersed with hosts. In addition, continuous light emission for a long time and/or high temperature and humidity change states of the dopants and hosts in a light-emitting layer, which may degrade performance of an element, for example, increase driving voltage and lower luminance. However, US Patent Application Publication No. 2011-0204333 has no description regarding stability against change in performance in such a case of long-time use. Thus, further research and improvement are needed.

Furthermore, US 2011/204333 relates to to organic light emitting devices (OLEDs) comprising phosphorescent organic materials (iridium complexes) containing ligands with a dibenzo-fused 5 -membered ring substituent.

SUMMARY OF THE INVENTION

The present invention is made in view of the above problems and provides an organic electroluminescent (EL) element that can be driven at a low voltage and has high light-emitting efficiency, long lifetime and excellent stability after long-time storage (also referred to as "long-term stability"); a display device and lighting device each of which has the organic electroluminescent element(s).

The present invention is made because the present inventors reveal that an organic EL element including a

hexa-coordinated ortho-metalated iridium complex having a specific structure as an iridium complex can be driven at a low voltage and has high light-emitting efficiency, long lifetime and excellent long-term stability.

To achieve at least one of the above advantages, according to a first aspect of the present invention, there is provided an organic electroluminescent element including constituent layers, an anode and a cathode, the constituent layers provided between the anode and the cathode and including at least one light-emitting layer,
wherein at least one layer of the constituent layers includes a hexa-coordinated ortho-metalated iridium complex represented by the following general formula (1)

General formula (1)

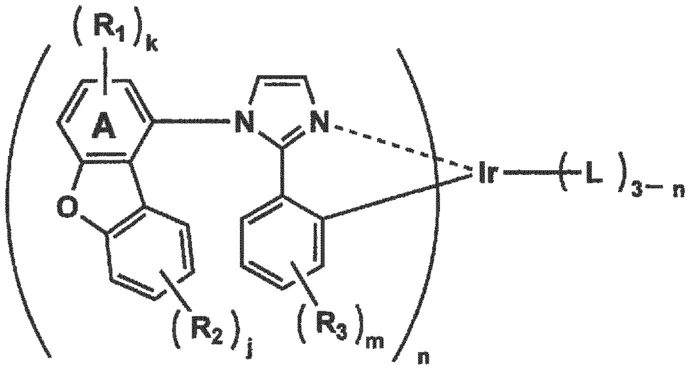

and
wherein in the general formula (1), $R_1$ represents an alkyl group; the total carbon number summed over all of the substituents $(R_1)_k$ on the ring A is five or less; $R_2$ and $R_3$ each represents a substituent group; n represents an integer from 1 to 3; k represents an integer from 1 to 3; j and m each represents an integer from 0 to 4; and L represents a monoanionic bidentate ligand having coordinate covalent bonds to Ir.

According to a second aspect of the present invention, there is provided a display device including the above organic electroluminescent element(s).

According to a third aspect of the present invention, there is provided a lighting device including the above organic electroluminescent element(s).

BRIEF DESCRIPTION OF THE DRAWINGS

The above and other objects, advantages and features of the present invention will become more fully understood from the detailed description given hereinbelow and the appended drawings which are given by way of illustration only, and thus are not intended as a definition of the limits of the present invention, and wherein:

Fig. 1 is a schematic diagram of an example of a display device including organic EL element(s);
Fig. 2 is a schematic diagram of an example of a display unit A illustrated in Fig. 1;
Fig. 3 is a schematic diagram of a configuration of a pixel illustrated in Fig. 2;
Fig. 4 is a schematic diagram of an example of a full-color display device using a passive matrix method;
Fig. 5 is a schematic diagram of a lighting device including the organic EL element(s); and
Fig. 6 is a cross-sectional view of a lighting device including the organic EL element(s).

DESCRIPTION OF THE PREFERRED EMBODIMENTS

In an organic electroluminescent (EL) element of the present invention, constituent layers including at least one light-emitting layer is provided between an anode and cathode, and at least one layer of the constituent layers contains a hexa-coordinated ortho-metalated iridium complex represented by the general formula (1). Accordingly, the organic EL element of the present invention is driven at a low voltage and has high efficiency of light emission, long lifetime and excellent long-term stability. This feature is common among embodiments of the present invention.

As embodiments of the present invention, to achieve advantages of the present invention more effectively, the hexa-coordinated ortho-metalated iridium complex represented by the general formula (1) is preferably a hexa-coordinated ortho-metalated iridium complex represented by a general formula (2), (3), (4) or (5) described later.

Further, the hexa-coordinated ortho-metalated iridium complex represented by the general formula (1) is preferably contained in the light-emitting layer. The organic EL element of the present invention preferably emits white light.

A lighting device of the present invention and a display device of the present invention are characterized by including the organic EL element(s) of the present invention.

Accordingly, the organic EL element of the present invention, and the lighting device and display device of the present invention including the organic EL element(s) of the present invention which can be driven at a low voltage and which has high efficiency of light emission, long lifetime and excellent long-term stability can be provided.

The configurations of the present invention solve the above problems presumably because of the following reasons.

As described above, it is already known that using a compound having a fused ring structure such as dibenzofuran as a ligand of a metal complex shortens lifetime of phosphorescence and thereby improving lifetime of an organic EL element, as disclosed in U.S. patent publication No. 2011-024333. The present invention reveals that, by bonding phenylimidazole to dibenzofuran at a specific position and introducing a specific substituent group into dibenzofuran, an organic EL element that is driven with lower driving voltage and has higher efficiency of light emission can be achieved. Hence, the present invention is made.

Specifically, in the present invention, phenylimidazole is bonded to dibenzofuran at position 1 of dibenzofuran. Hence, it is presumed that a plane of pi electrons is present near iridium which is the central metal, and an interacting region with a host is present near the metal center; thus, carriers move smoothly from a host to a dopant and efficiency of light emission is improved. In addition, it is presumed that surrounding environment of the imidazole structure is sterically hindered, and thus a dopant is less likely to be deteriorated and less likely to be affected by external environment such as temperature and humidity. Therefore, an organic EL element is provided with long-term stability. In terms of improving stability, dispersibility and dissolvability of a compound, introduction of an alkyl group is effective. However, when a bulky alkyl group is introduced near the imidazole structure, dispersibility is reduced because interaction between such alkyl groups are strong. In the present invention, the total number of carbons of an alkyl group on the dibenzofuran ring near the imidazole structure is defined as five or less. Therefore, it is presumed that metal complexes are effectively avoided from aggregation, carrier trapping in a light-emitting layer is suppressed, and thus an organic EL element is driven at a low driving voltage.

Hereinafter, the present invention, and elements and embodiments of the present invention are described in detail.

In the present application, a plurality of ranges of values are described. Each of the ranges is described with " (from) A to B". Here, A and B are numeral values, and represent the minimum and maximum values of each range, respectively.

<<Organic EL element>>

The organic EL element of the present invention includes the constituent layers including at least one light-emitting layer, the constituent layers being provided between an anode and cathode. The organic EL element of the present invention contains the hexa-coordinated ortho-metalated iridium complex represented by the general formula (1).

[Hexa-coordinated ortho-metalated iridium complex]

The hexa-coordinated ortho-metalated iridium complex of the present invention (hereinafter also referred to as an "ortho-metalated iridium complex" or just as "iridium complex of the present invention") may be used in any of the layers of the organic EL element of the present invention. To greatly enhance the advantages of the present invention (i.e., increasing efficiency of light emission of the element (specifically, external quantum efficiency referred to also as just "efficiency"), increasing half-life time and lowering driving voltage), the hexa-coordinated ortho-metalated iridium complex of the present invention is preferably contained in the light-emitting layer which is one of the constituent layers of the organic EL element and further preferably used as a light-emitting dopant (hereinafter also referred to as just "dopant") in the light-emitting layer. The layers of the organic EL element of the present invention will be described later in detail.

The ortho-metalated iridium complex of the present invention is represented by the general formula (1) below.

General formula (1)

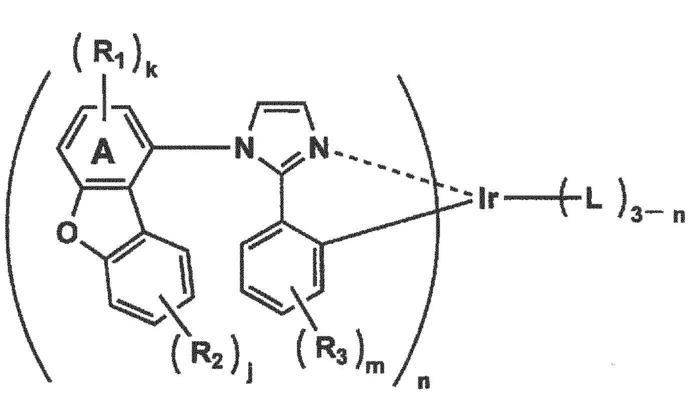

In the above formula (1), $R_1$ represent an alkyl group, and the total number of carbons of $(R_1)_k$ on the ring A is five or less.

Specific examples of the alkyl group of $R_1$ include the following A-1 to A-17, but not limited thereto.

A−1

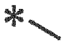

A−2

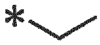

A−3

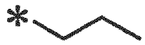

A−4

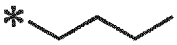

A−5

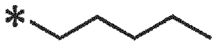

A−6

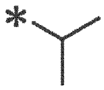

A−7

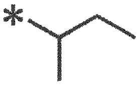

A−8

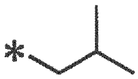

A−9

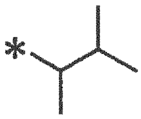

A−10

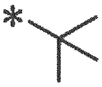

A−11

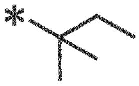

A−12

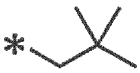

A−13

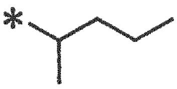

A−14

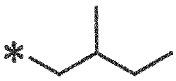

A−15

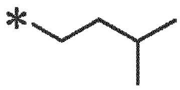

A−16

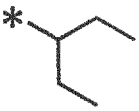

A−17

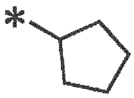

In the above A-1 to A17, "*" represents each a binding position to the ring A. Preferable alkyl groups include

A-6, A-8 and A-15, but not limited thereto.

In the general formula (1), $R_2$ and $R_3$ each represents a substituent group. Examples of the substituent groups represented by $R_2$ and $R_3$ include, for example, a hydrogen atom, halogen atoms (such as a fluorine atom, chlorine atom and bromine atom), a cyano group, alkyl groups (such as a methyl group, ethyl group, propyl group, isopropyl group, t-butyl group, pentyl group, hexyl group, octyl group, dodecyl group, tridecyl group, tetradecyl group and pentadecyl group), alkenyl groups (such as a vinyl group and aryl group), alkynyl groups (such as an ethynyl group and propargyl group), alkoxy groups (such as a methoxy group, ethoxy group, propyloxy group, pentyloxy group, hexyloxy group, octyloxy group and dodecyloxy group), amino groups (such as an amino group, ethylamino group, dimethylamino group, butylamino group, cyclopentylamino group, 2-etylhexylamino group, dodecylamino group, anilino group, naphtylamino group and 2-pyridylamino group), silyl groups (such as atrimethylsilyl group, triisopropylsilyl group, triphonylsilyl group and phenyldiethylsilyl group), aryl groups (such as a phenyl group, p-chlorophenyl group, mesityl group, tolyl group, xylyl group, naphtyl group, anthryl group, azulenyl group, acenaphthenyl group, fluorenyl group, phenanthryl group, indenyl group, pyrenyl group and biphenylyl group), heteroaryl groups (such as a furyl group, thienyl group, pyridyl group, pyridazyl group, pyrimizyl group, pyrazyl group, triazyl group, imidazolyl group, pyrazolyl group, thiazolyl group, benzoimidazolyl group, benzoxazolyl group, quinazolyl group and phthalazyl group), non-aromatic cyclic hydrocarbon groups (such as a cyclopentyl group and cyclohexyl group) and non-aromatic heterocyclic groups (such as a pyrollidyl group, imidazolidyl group, morpholyl group and oxazolidyl group). Preferable examples include a hydrogen atom, halogen atoms (such as a fluorine atom, chlorine atom and bromine atom), alkyl groups (such as a methyl group, ethyl group, propyl group, isopropyl group, *t*-butyl group, pentyl group, hexyl group, octyl group, dodecyl group, tridecyl group, tetradecyl group and pentadecyl group), alkenyl groups (such as a vinyl group and aryl group), alkynyl groups (such as an ethynyl group and propargyl group) and alkoxy groups (such as a methoxy group, ethoxy group, propyloxy group, pentyloxy group, hexyloxy group, octyloxy group and dodecyloxy group). Further preferable examples include alkyl groups (such as a methyl group, ethyl group, propyl group, isopropyl group, *t*-butyl group, pentyl group, hexyl group, octyl group, dodecyl group, tridecyl group, tetradecyl group, and pentadecyl group) and alkenyl groups (such as a vinyl group and aryl group) and alkynyl groups (such as an ethynyl group and propargyl group). The above-exemplified substituent groups may be substituted with substituent group(s) selected from the following list of examples.

The list include halogen atoms (such as a fluorine atom, chlorine atom and bromine atom), a cyano group, alkyl groups (such as a methyl group, ethyl group, propyl group, isopropyl group, *t*-butyl group, pentyl group, hexyl group, octyl group, dodecyl group, tridecyl group, tetradecyl group and pentadecyl group), alkenyl groups (such as a vinyl group and aryl group), alkynyl groups (such as an ethynyl group and propargyl group), alkoxy groups (such as a methoxy group, ethoxy group, propyloxy group, pentyloxy group, hexyloxy group, octyloxy group and dodecyloxy group), amino groups (such as an amino group, ethylamino group, dimethylamino group, butylamino group, cyclopentylamino group, 2-etylhexylamino group, dodecylamino group, anilino group, naphtylamino group and 2-pyridylamino group), silyl groups (such as a trimethylsilyl group, triisopropylsilyl group, triphonylsilyl group and phenyldiethylsilyl group), aryl groups (such as a phenyl group, *p*-chlorophenyl group, mesityl group, tolyl group, xylyl group, naphtyl group, anthryl group, azulenyl group, acenaphthenyl group, fluorenyl group, phenanthryl group, indenyl group, pyrenyl group and biphenylyl group), heteroaryl groups (such as a furyl group, thienyl group, pyridyl group, pyridazyl group, pyrimizyl group, pyrazyl group, triazyl group, imidazolyl group, pyrazolyl group, thiazolyl group, benzoimidazolyl group, benzoxazolyl group, quinazolyl group and phthalazyl group), non-aromatic cyclic hydrocarbon groups (such as a cyclopentyl group and cyclohexyl group) and non-aromatic heterocyclic groups (such as a pyrollidyl group, imidazolidyl group, morpholyl group, oxazolidyl group). Examplary fused rings include 9,9'-dimethylfluorene, carbazol and dibenzofuran may be given as examples.

In the general formula (1), n represents an integer from 1 to 3, preferably 1 to 2, and more preferably 1; k represents an integer from 1 to 3, preferably 1 to 2, and more preferably 2; j represents an integer from 0 to 4, preferably 1 to 3, and more preferably 1 or 2; m represents an integer from 0 to 4, preferably 1 to 3, more preferably 1 or 2, and particularly 0; and L represents a monoanionic bidentate ligand having the coordinate covalent bonds to Ir. Examples of L are described below, but not limited thereto.

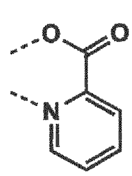
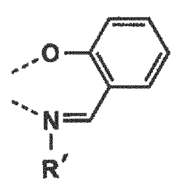
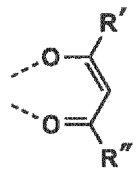
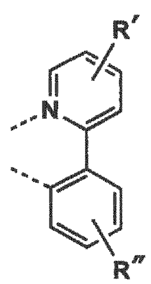

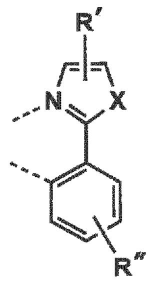
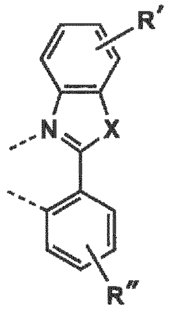
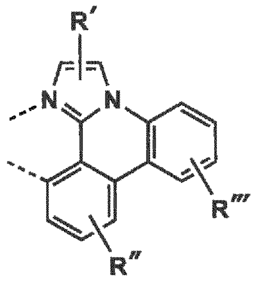

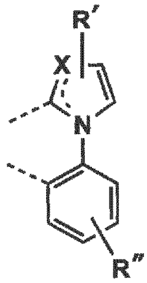
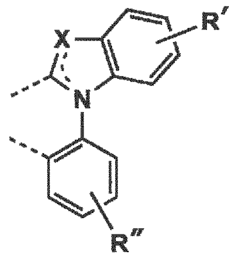

In the above-exemplified structures, R', R" and R"' each represents a hydrogen atom or substituent group, and X represents C-R or N-R. Substituent groups represented by R', R" and R"' may be selected from the above list of examples of substituent groups.

In the present invention, the ortho-metalated iridium complex represented by the general formula (1) is preferably an ortho-metalated iridium complex represented by the general formula (2).

General formula (2)

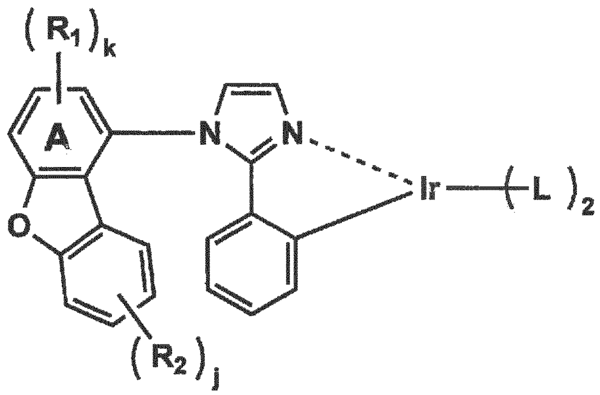

In the general formula (2), $R_1$ represents an alkyl group, and preferable examples of the alkyl group are the same as the $R_1$ of the general formula (1); the total number of carbons of $(R_1)_k$ on the ring A is five or less; $R_2$ represents a substituent group, and preferable examples of the substituent group are the same as the $R_2$ and $R_3$ of the general formula (1); k represents an integer from 1 to 3, preferably 1 or 2, and more preferably 1; j represents an integer from 0 to 4, preferably 1 to 3, and more preferably 1 or 2; and L represents the same as the above L of the general formula (1).

In the present invention, the ortho-metalated iridium complex represented by the general formula (2) is preferably an ortho-metalated iridium complex represented by the general formula (3).

General formula (3)

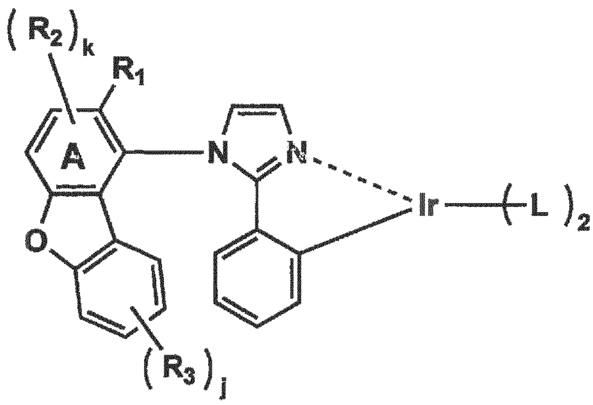

In the general formula (3), $R_1$ and $R_2$ each represents an alkyl group, and preferable examples of the alkyl group are the same as the $R_1$ of the general formula (1); the total number of carbons of $R_1$ and $(R_2)_k$ on the ring A is five or less; $R_3$ represents a substituent group, and preferable examples of the substituent group are the same as the $R_2$ and $R_3$ of the general formula (1); k represents an integer from 0 to 2, preferably 1 or 2, and more preferably 1; and j and L represent the same as the above j and L of the general formula (2), respectively.

In the present invention, the ortho-metalated iridium complex represented by the general formula (3) is preferably an ortho-metalated iridium complex represented by the general formula (4).

General formula (4)

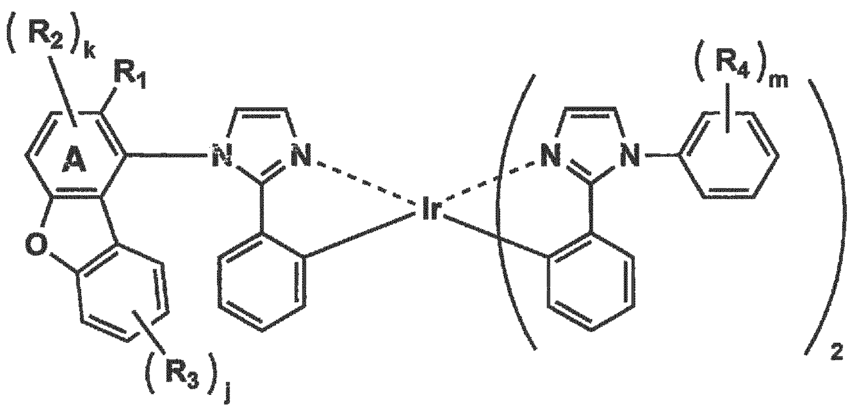

In the general formula (4), $R_1$ and $R_2$ each represents an alkyl group, and preferable examples of the alkyl group are the same as the $R_1$ of the general formula (1); the total number of carbons of $R_1$ and $(R_2)_k$ on the ring A is five or less; $R_3$ and $R_4$ each represents a substituent group, and preferable examples of the substituent group are the same as the $R_2$ and $R_3$ of the general formula (1); k represents an integer from 0 to 2; j represents an integer from 0 to 4; and m represents an integer from 0 to 5.

In the present invention, the ortho-metalated iridium complex represented by the general formula (4) is preferably an ortho-metalated iridium complex represented by the general formula (5).

General formula (5)

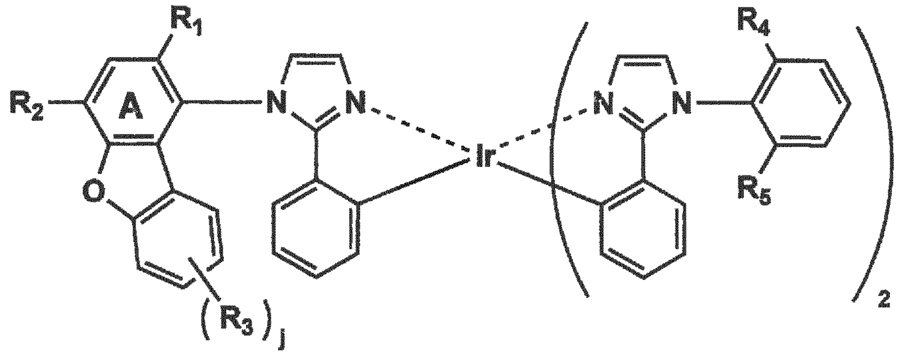

In the general formula (5), $R_1$ and $R_2$ each represents an alkyl group, and preferable examples of the alkyl group are the same as the $R_1$ of the general formula (1); the total number of carbons of $R_1$ and $(R_2)_k$ on the ring A is five or less; $R_3$ to $R_5$ each represents a substituent group, and preferable examples of the substituent group are the same as the $R_2$ and $R_3$ of the general formula (1); and j represents 1 or 2.

Specific examples of the ortho-metalated iridium complex represented by any one of the general formulae (1) to (5) are shown below, but the present invention is not limited thereto.

Examples of syntheses of the exemplary ortho-metalated iridium complexes represented by the general formula (1) of the present invention will be described in detail in Examples.

1

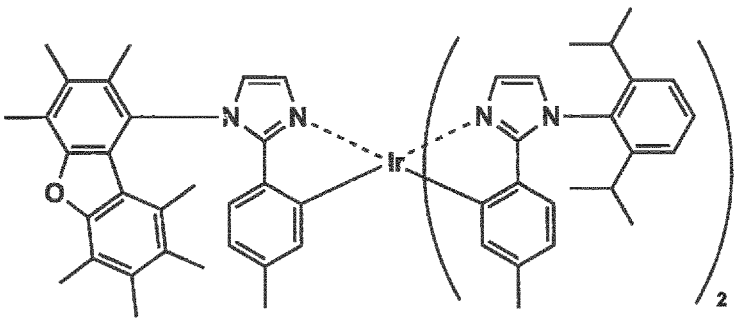

2

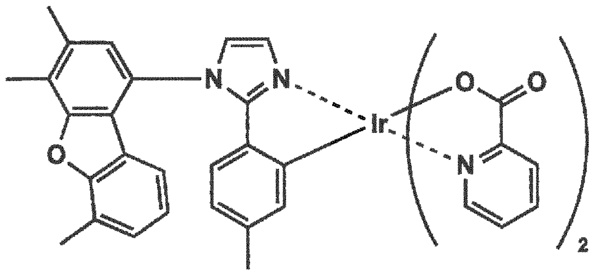

3

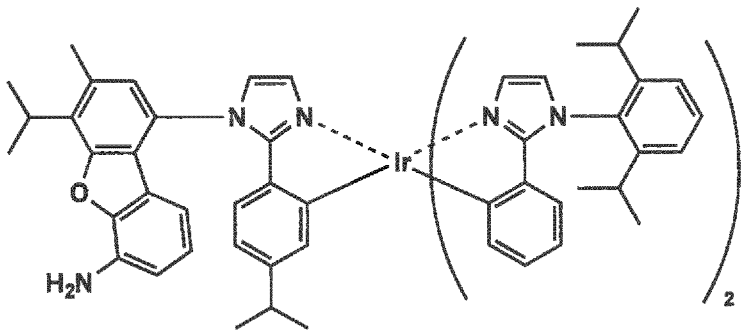

4

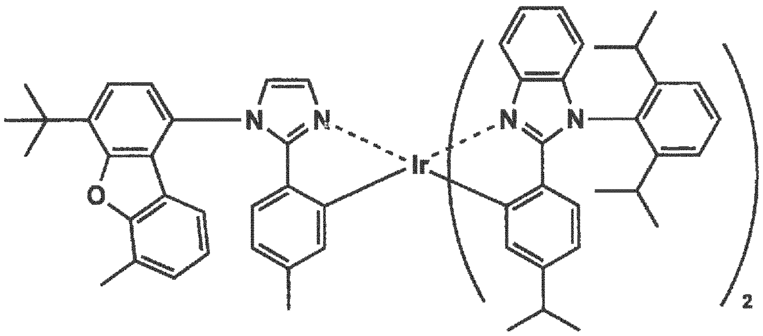

5

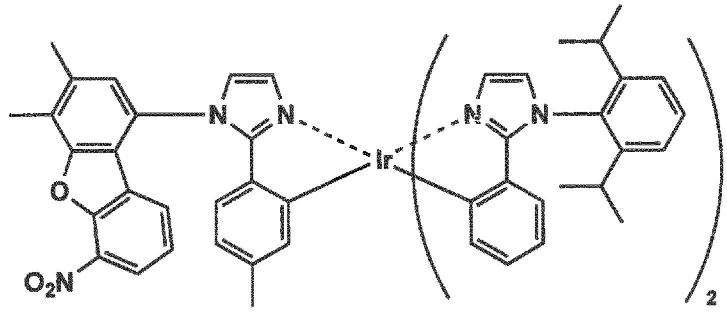

6

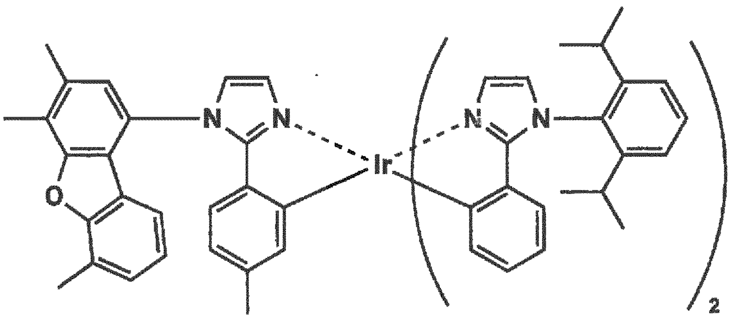

7

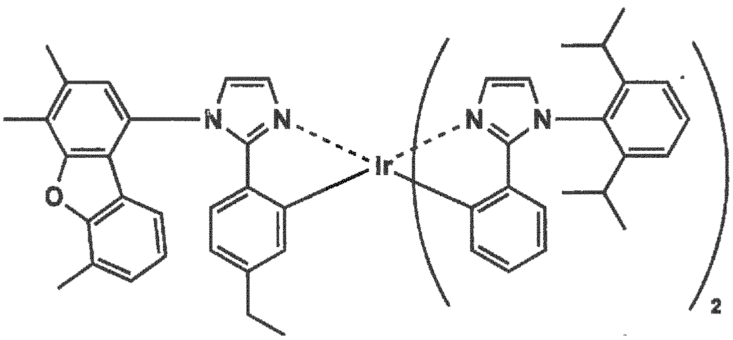

8

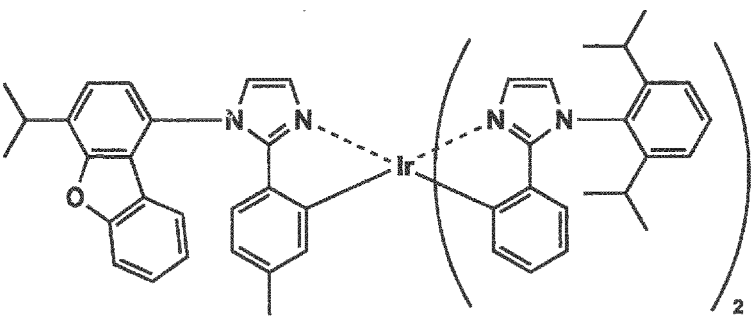

9

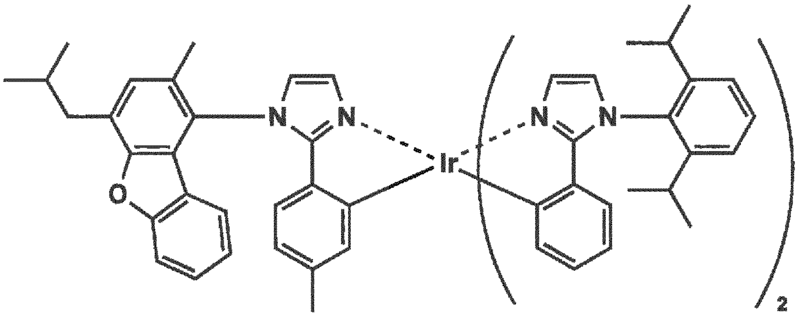

10

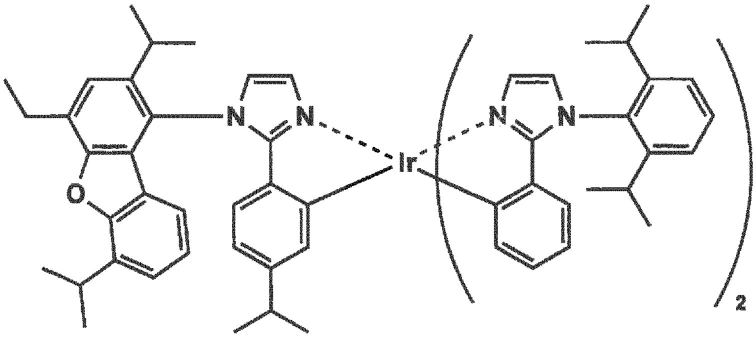

11

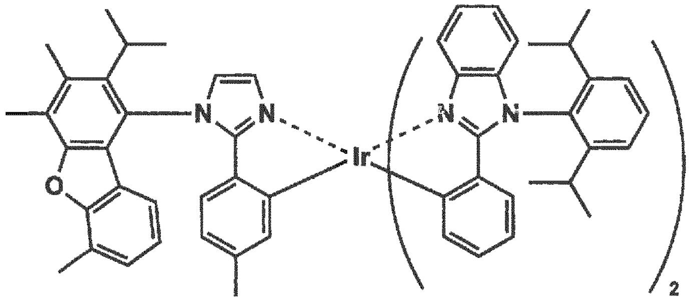

12

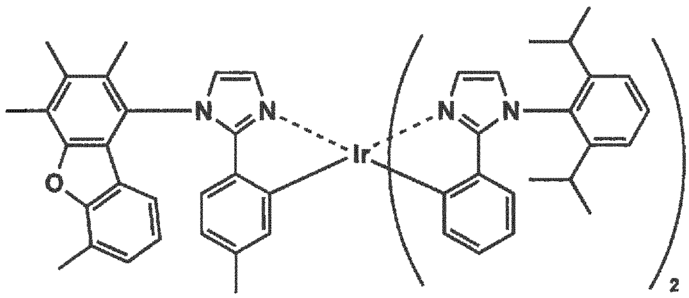

13

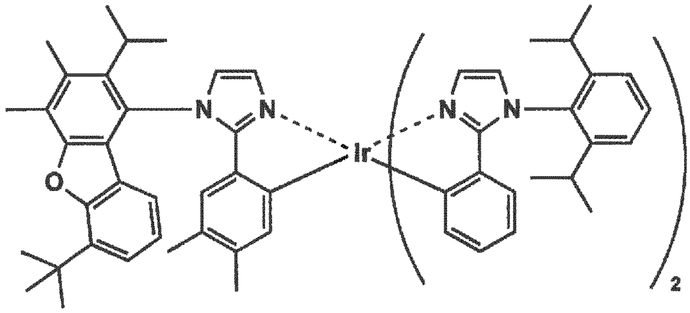

14

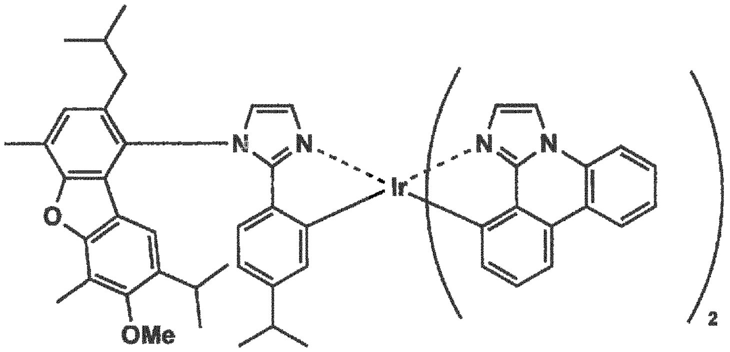

15

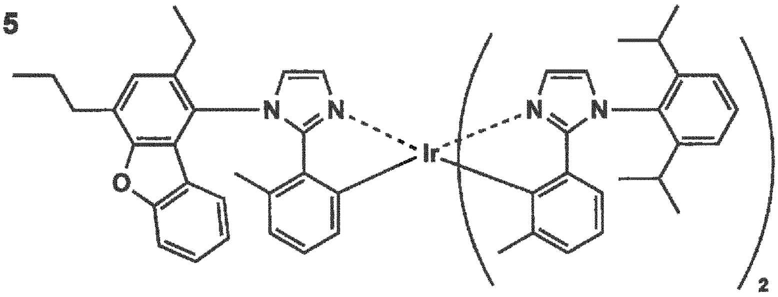

16

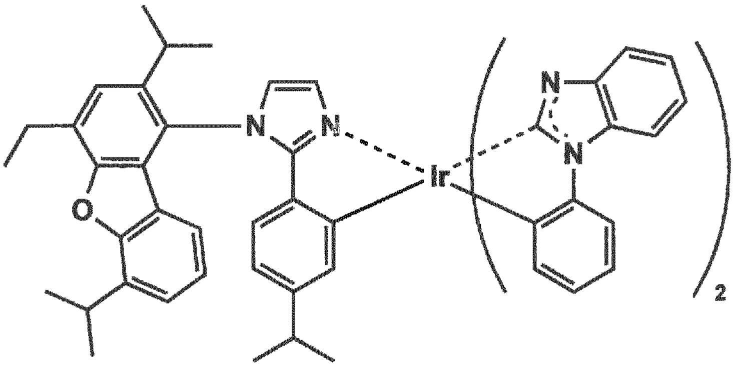

17

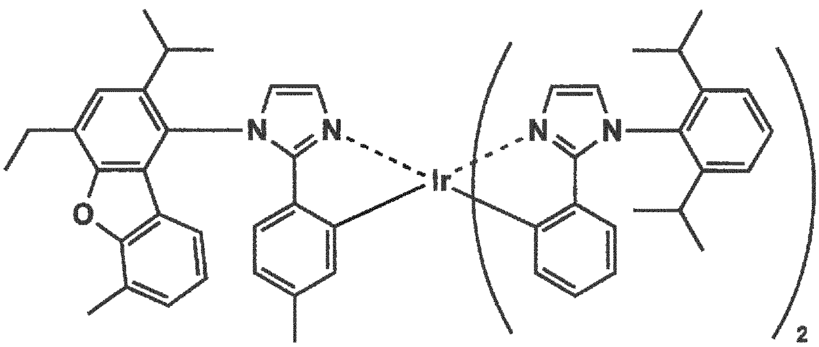

18

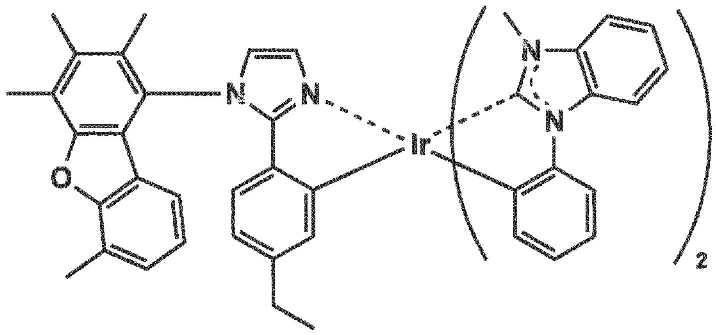

19

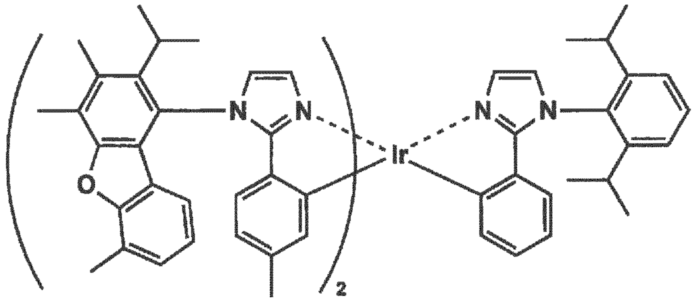

20

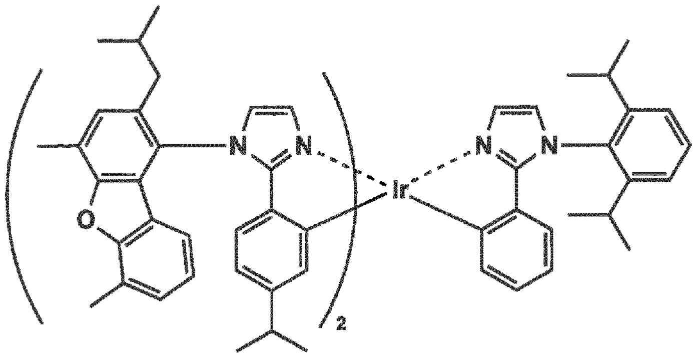

21

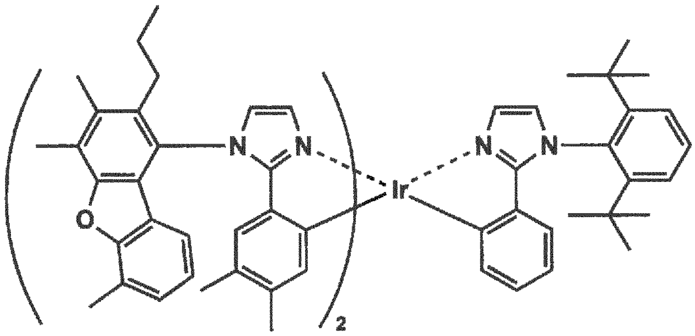

22

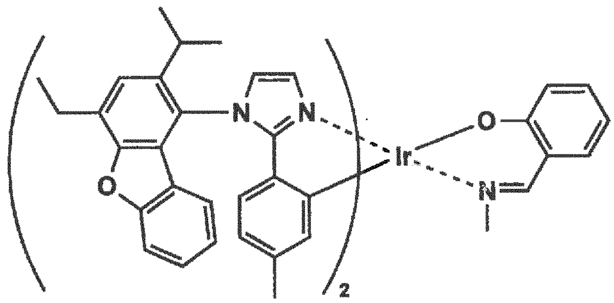

23

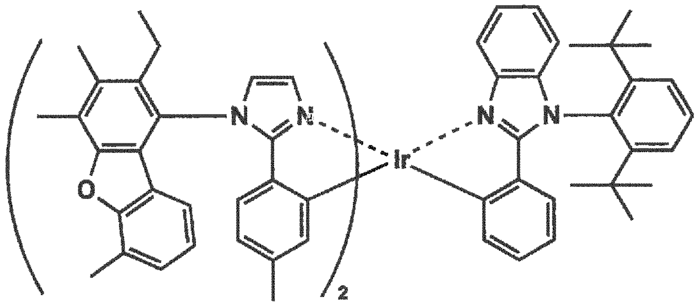

24

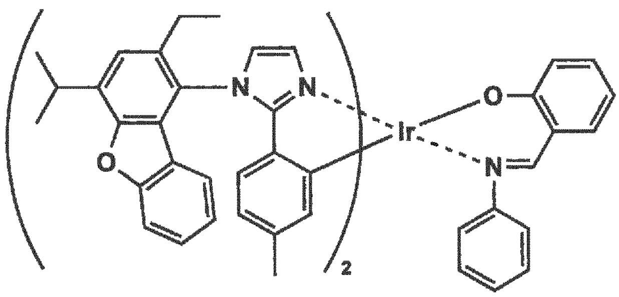

25

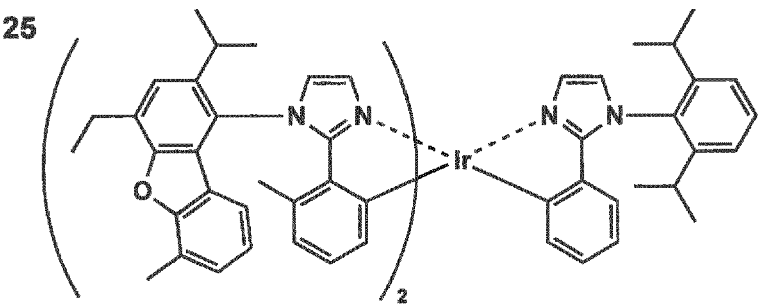

26

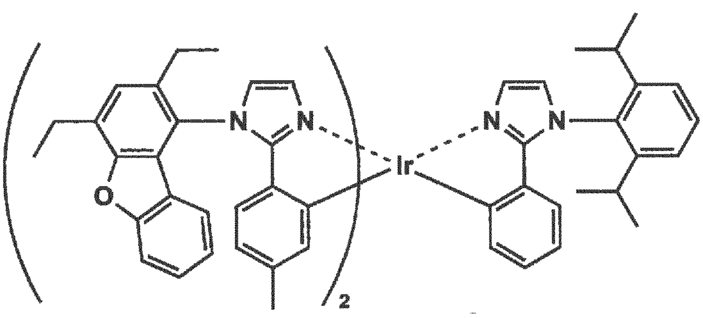

27

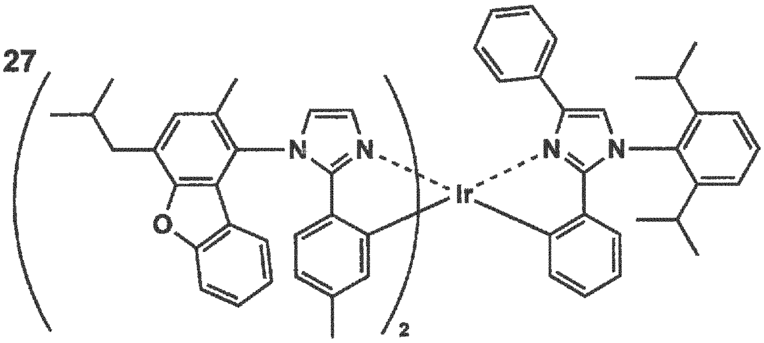

28

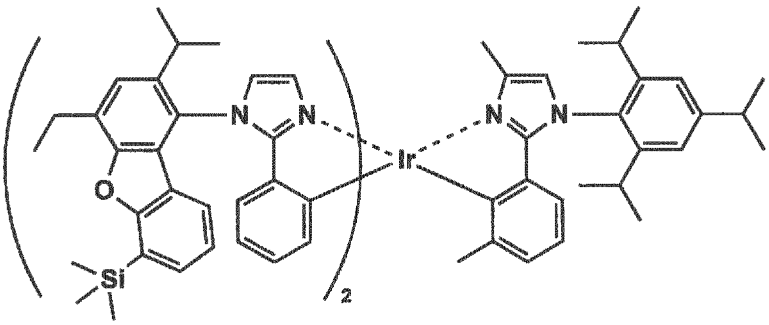

29

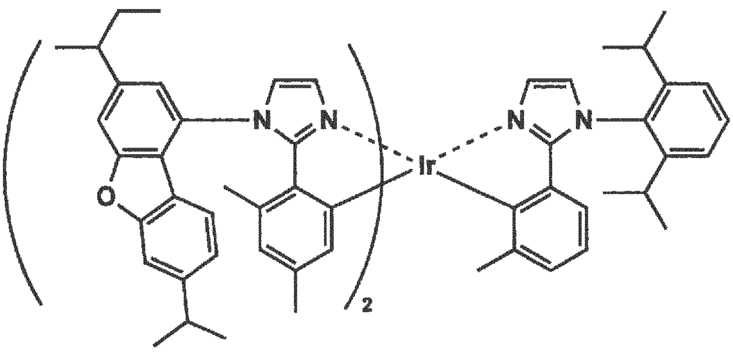

30

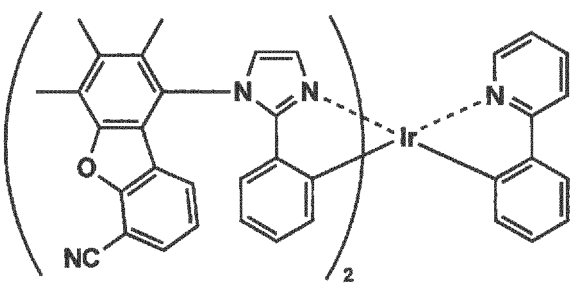

31

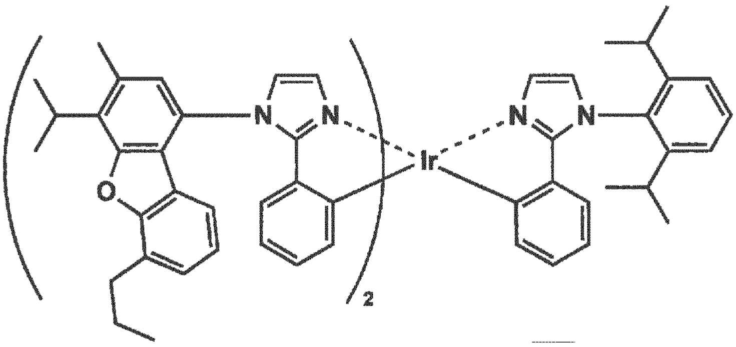

32

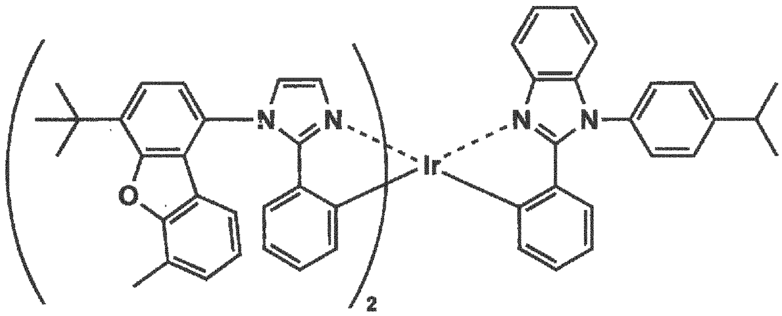

33

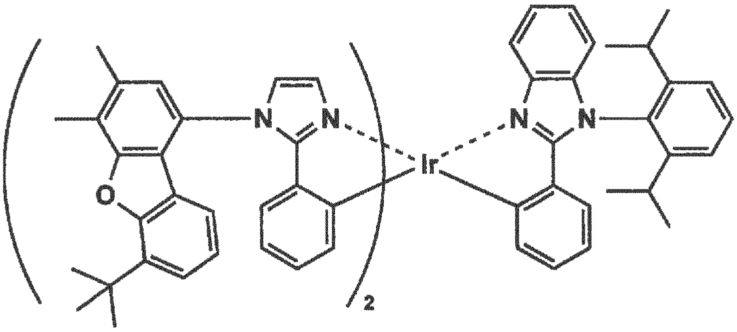

34

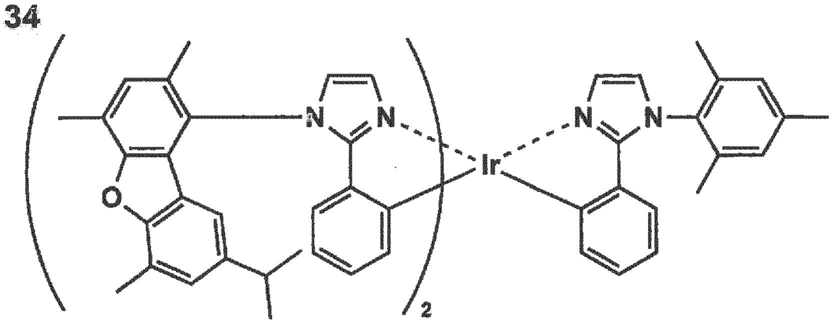

35

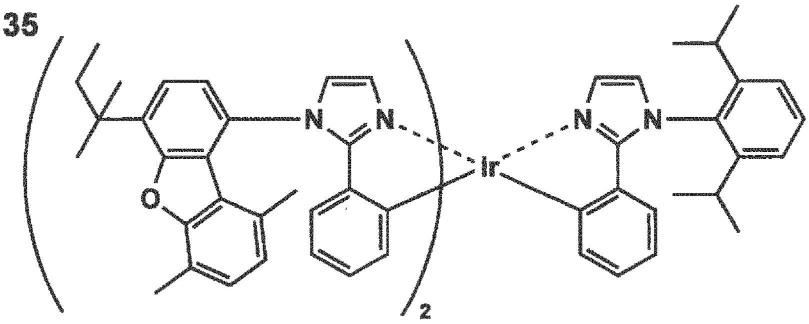

36

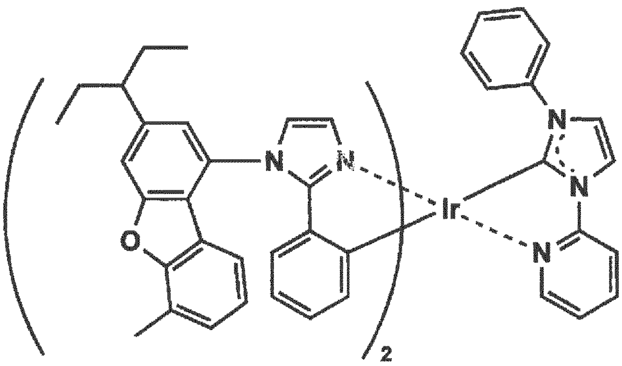

37

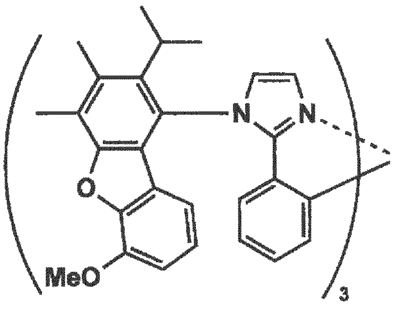

38

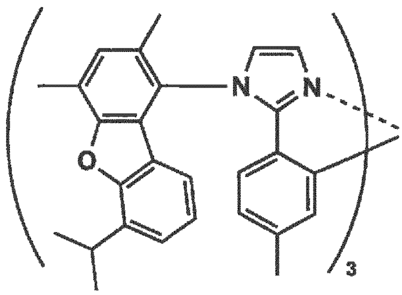

39

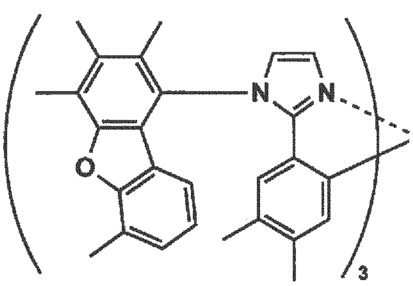

40

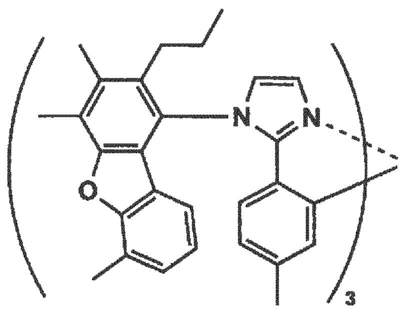

41

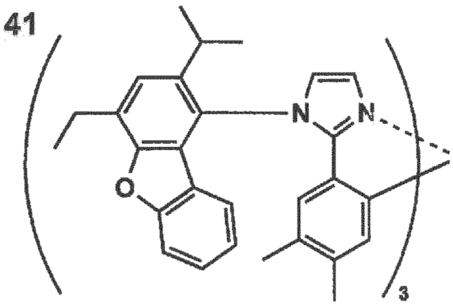

42

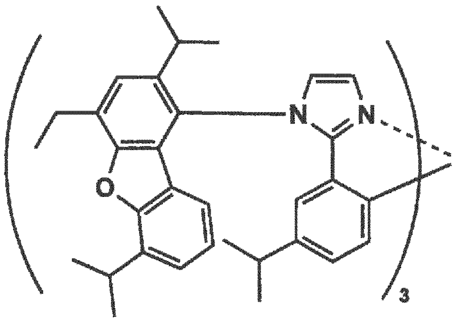

43

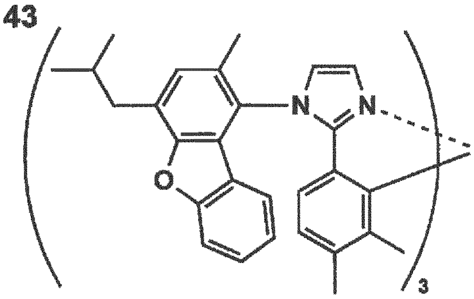

44

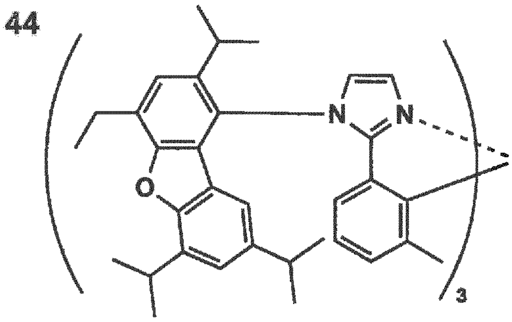

45

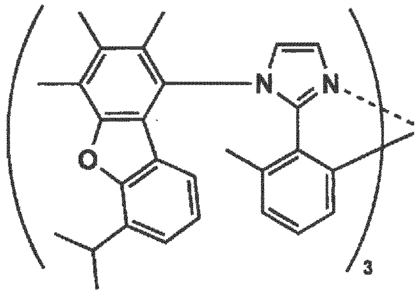

46

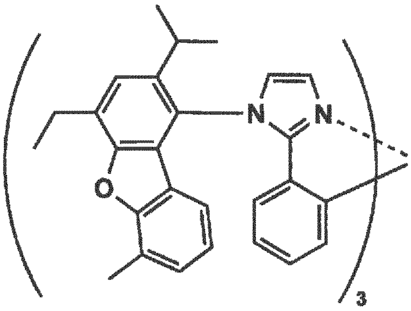

47

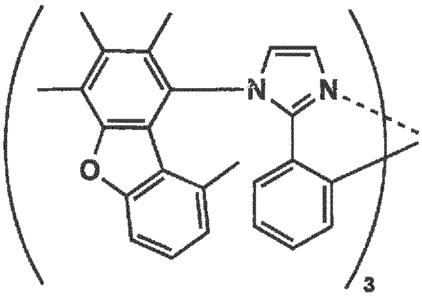

48

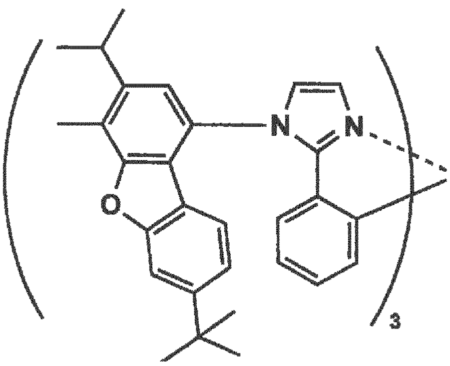

49

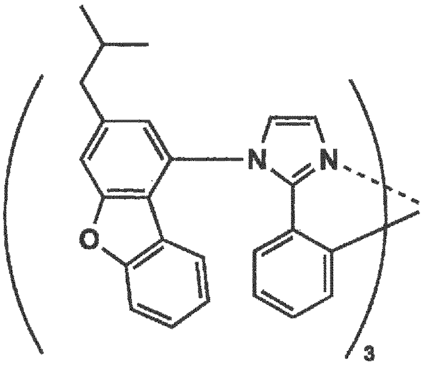

50

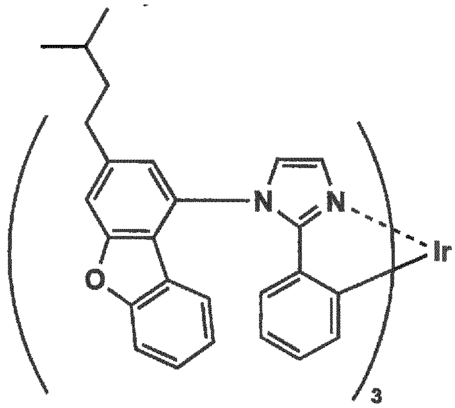

51

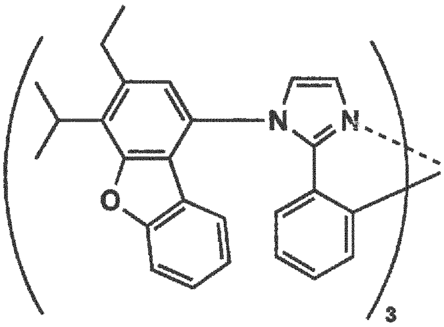

52

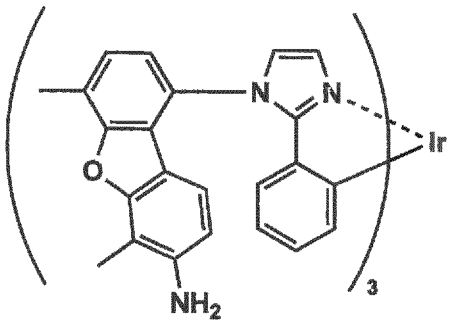

53

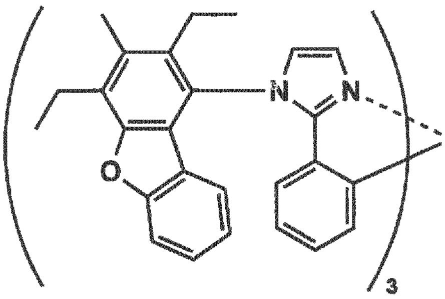

54

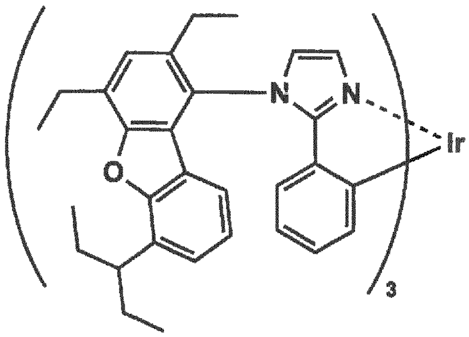

55

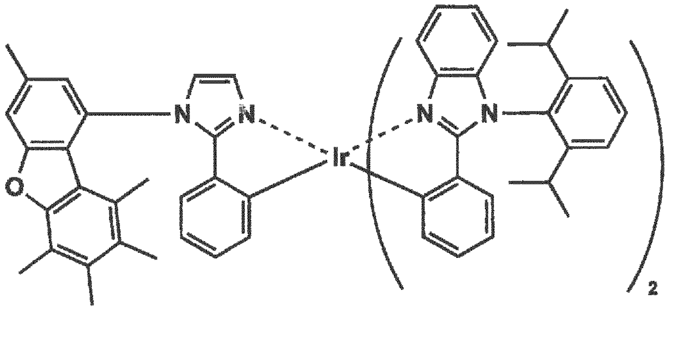

56

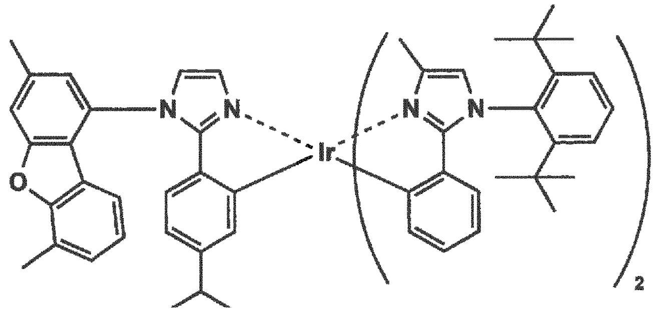

57

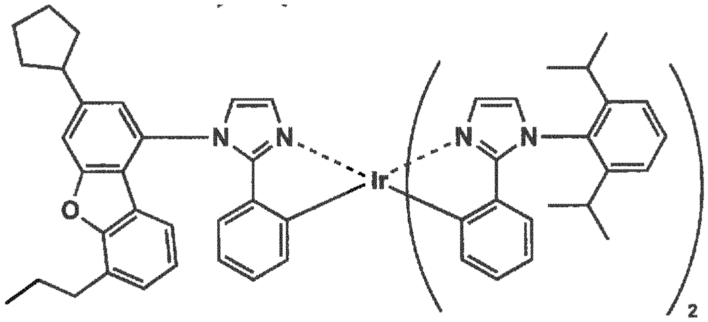

58

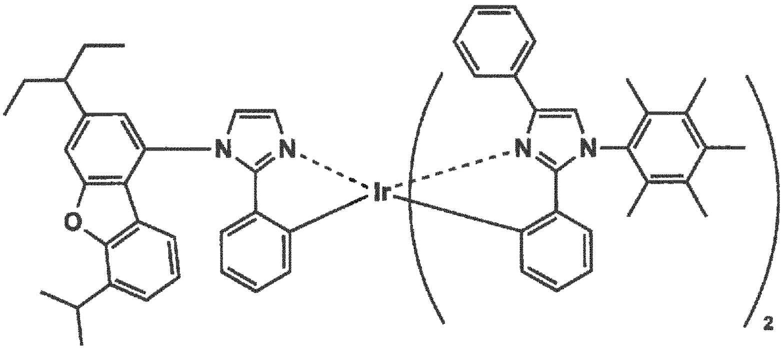

59

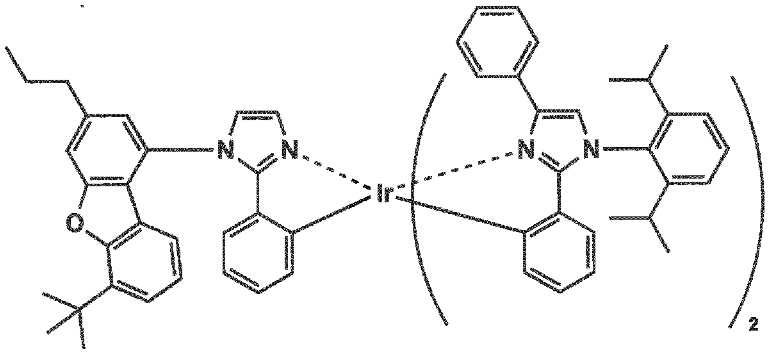

60

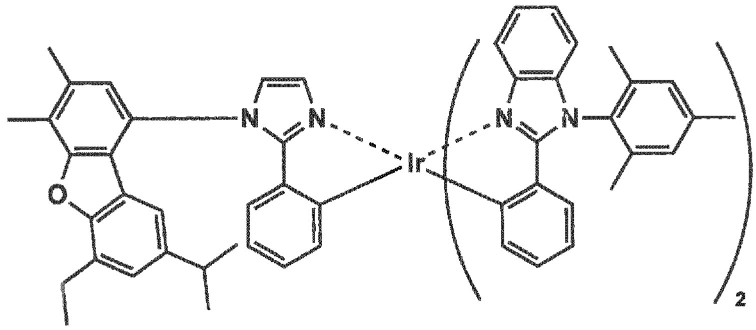

61

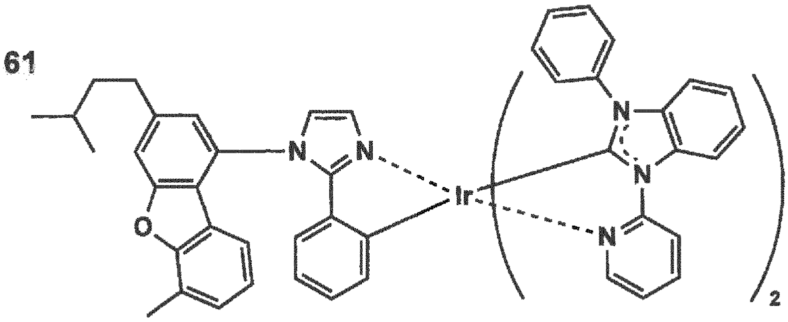

62

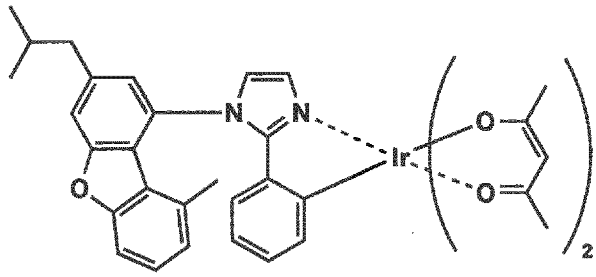

63

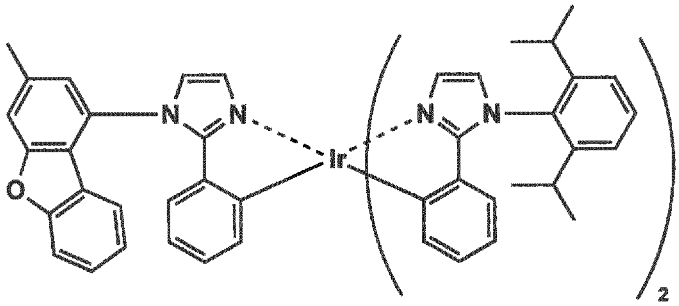

64

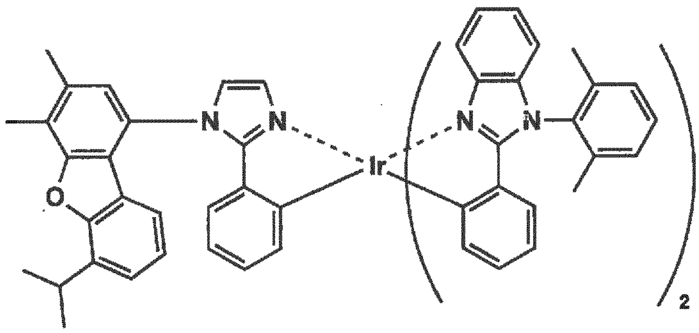

65

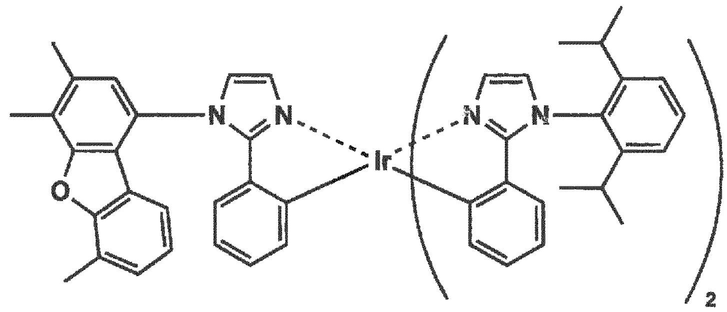

66

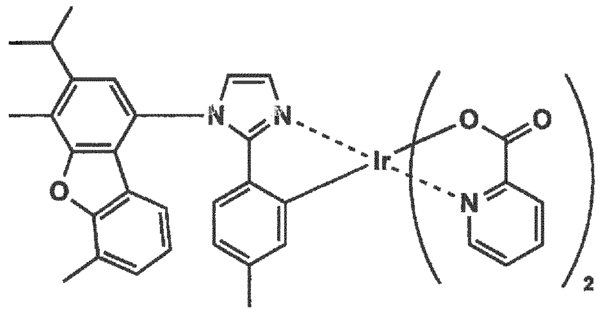

67

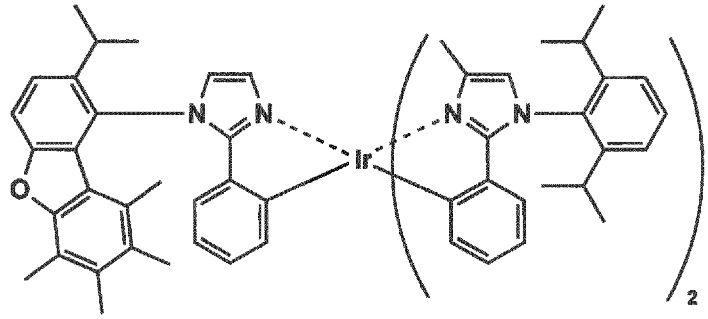

68

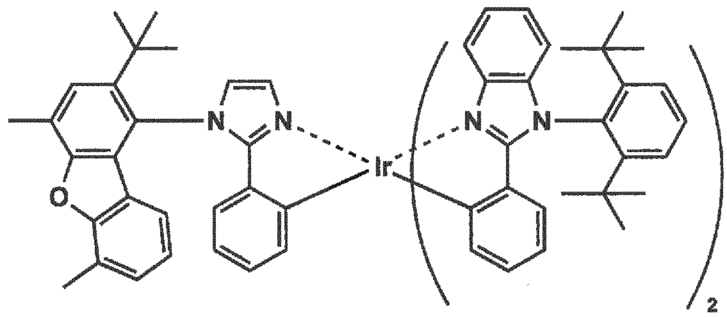

69

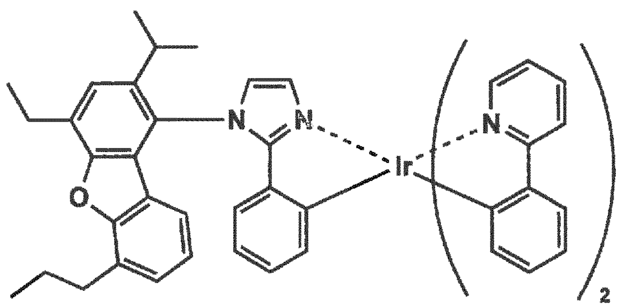

70

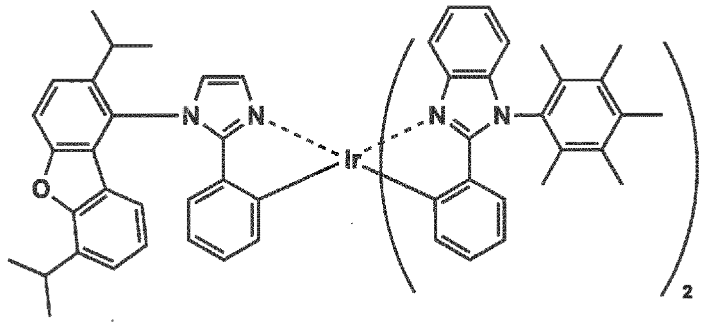

71

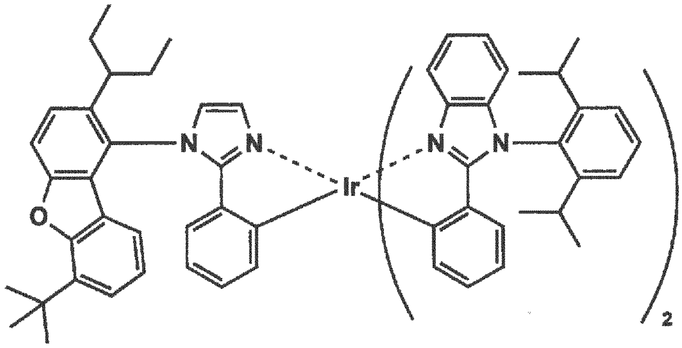

72

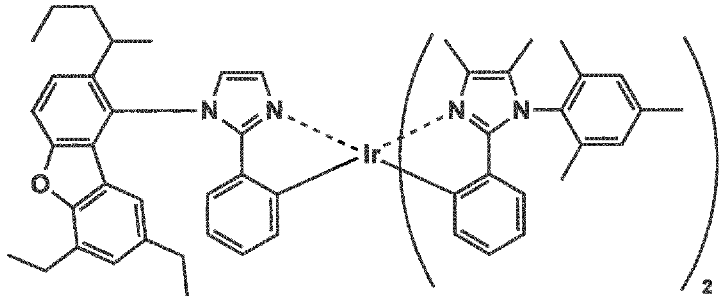

73

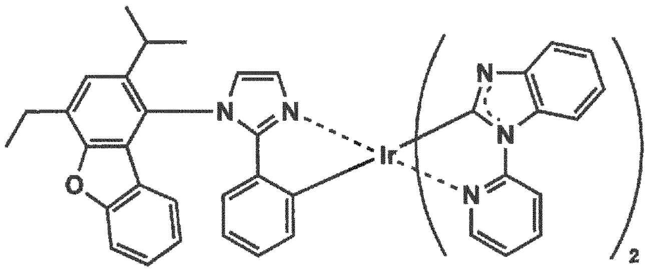

74

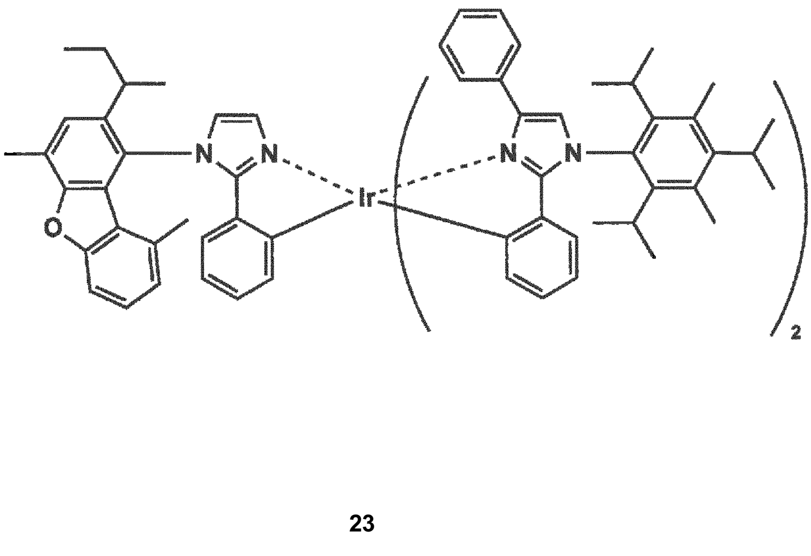

75

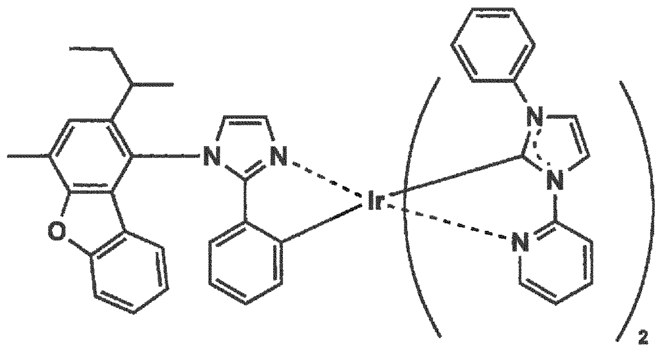

76

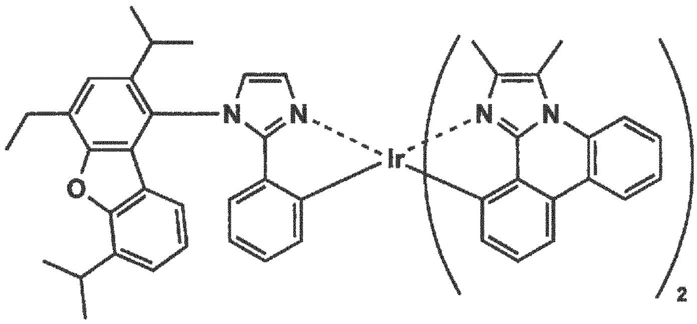

77

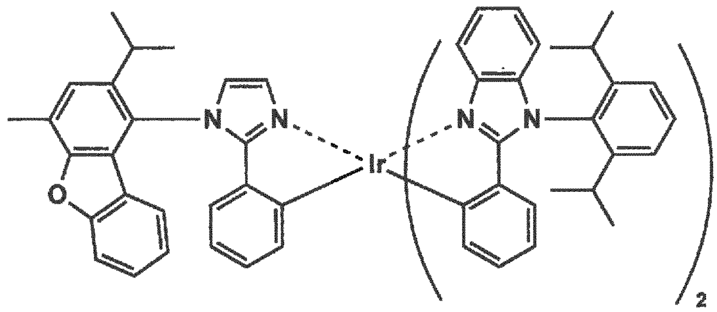

78

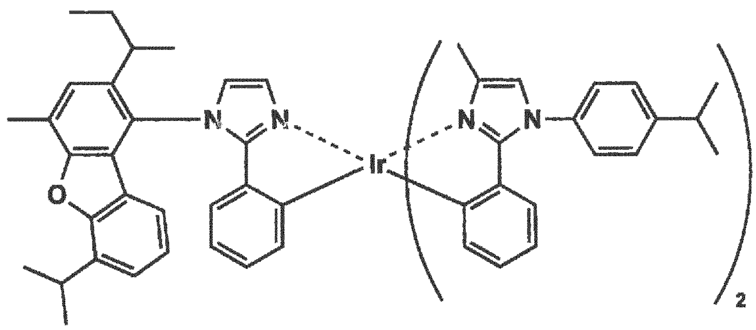

79

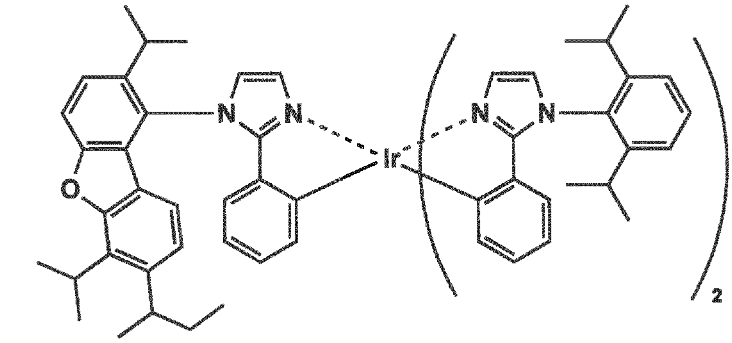

80

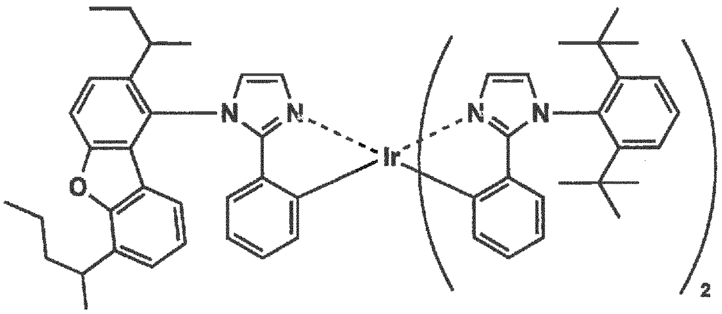

81

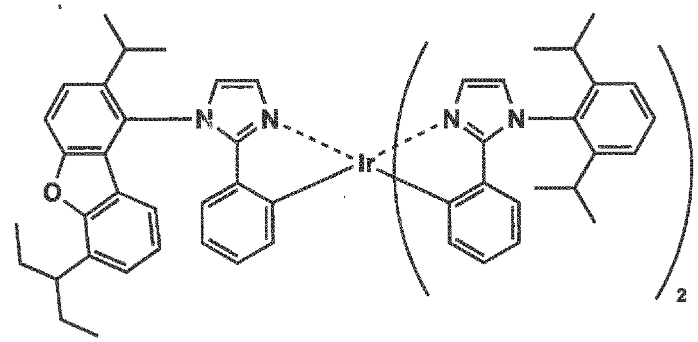

82

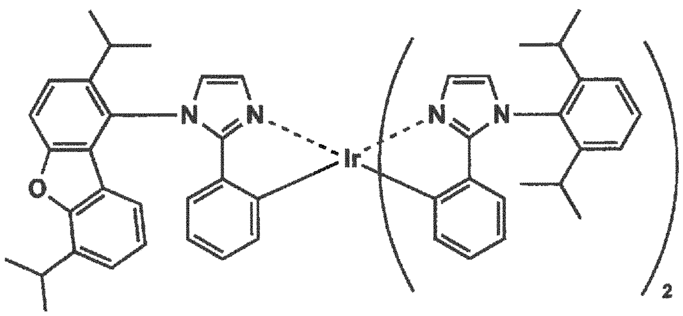

83

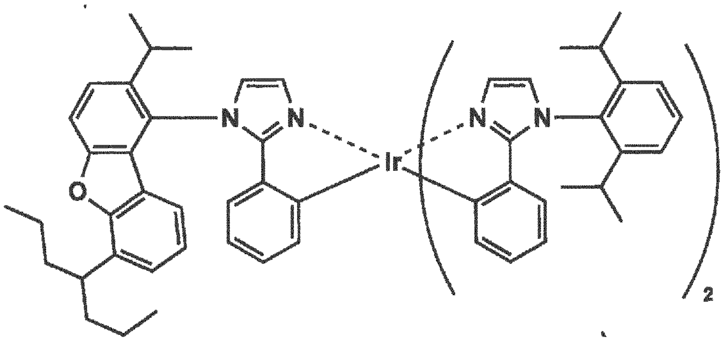

84

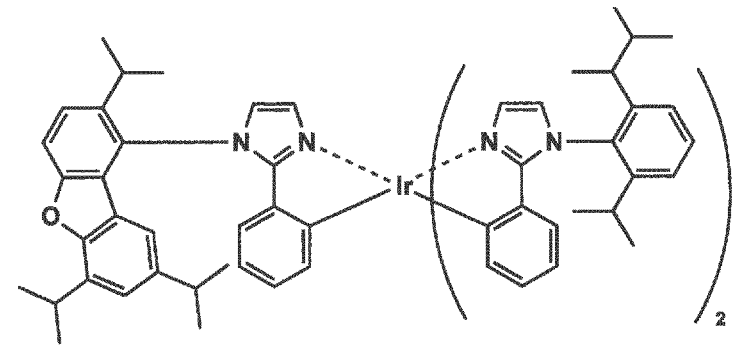

85

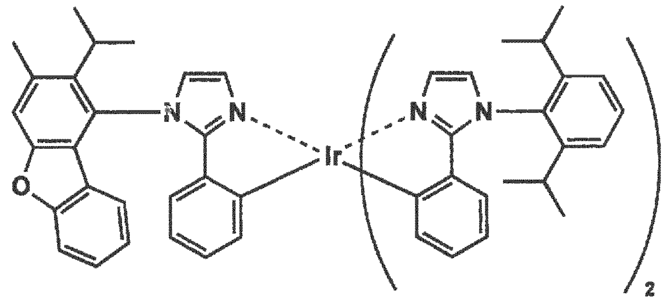

86

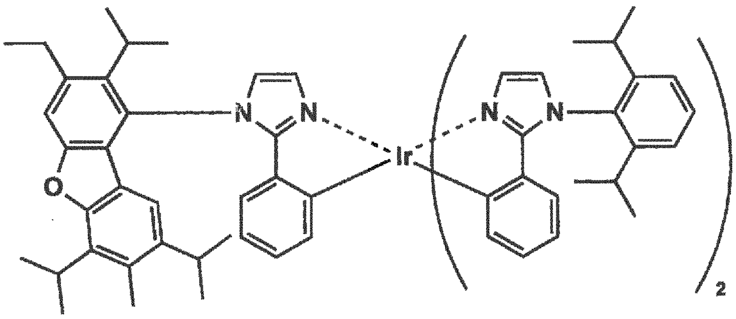

87

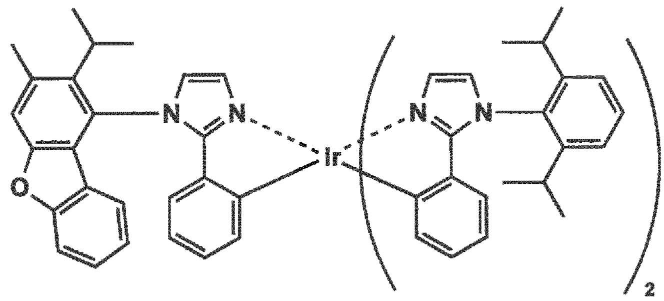

88

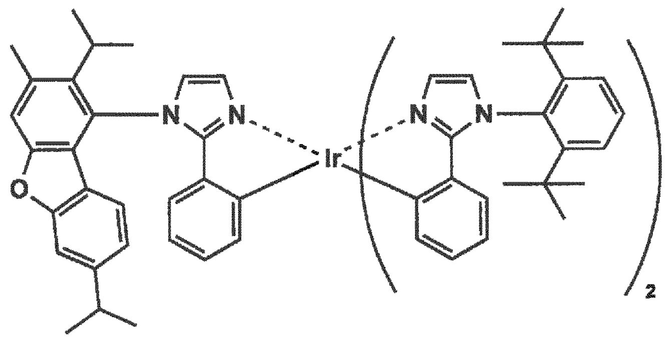

89

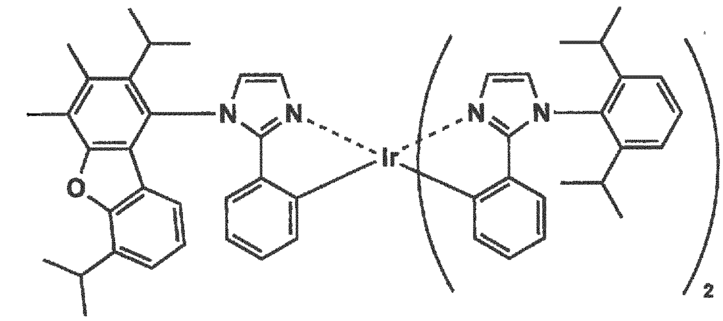

90

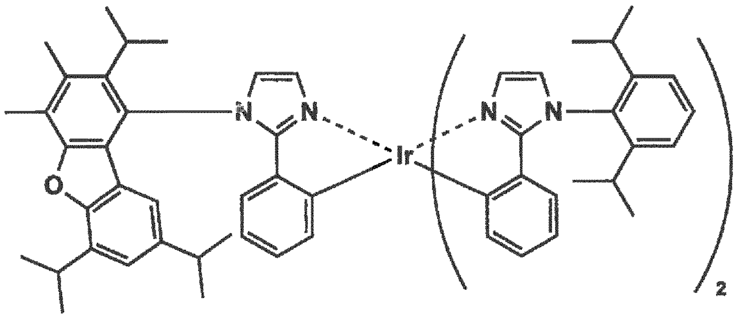

91

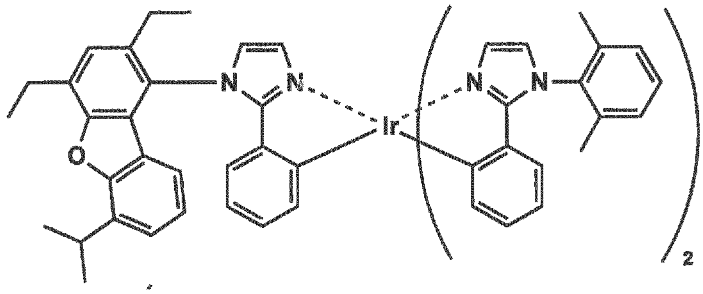

92

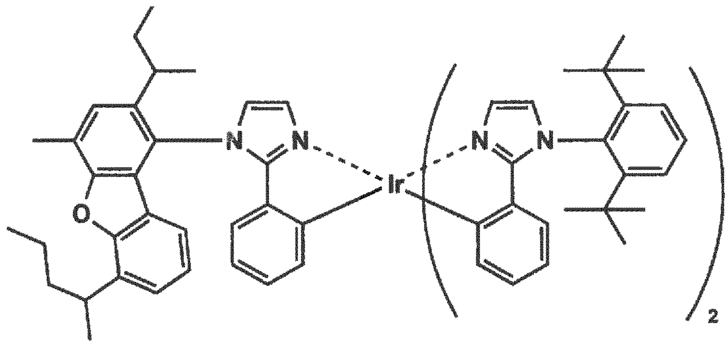

93

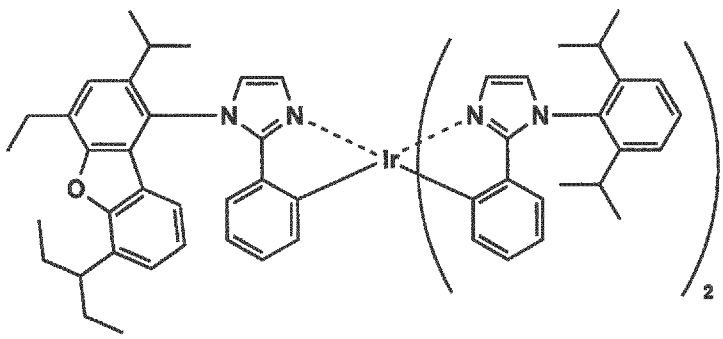

**94**

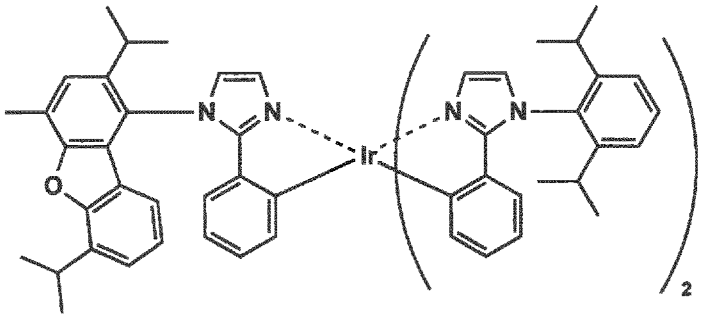

**95**

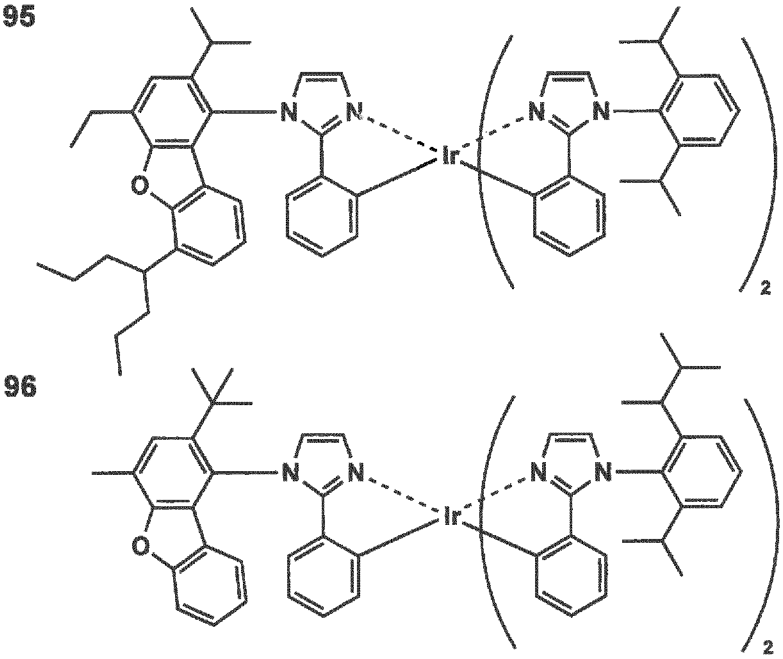

**96**

**97**

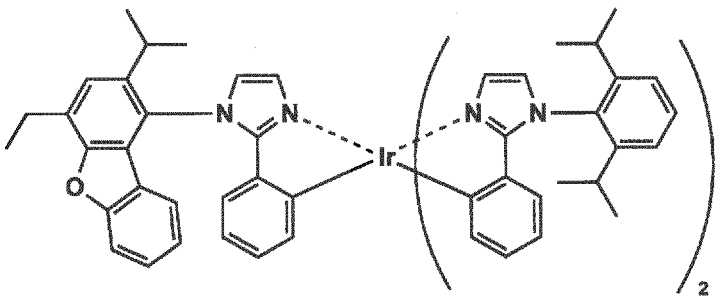

**98**

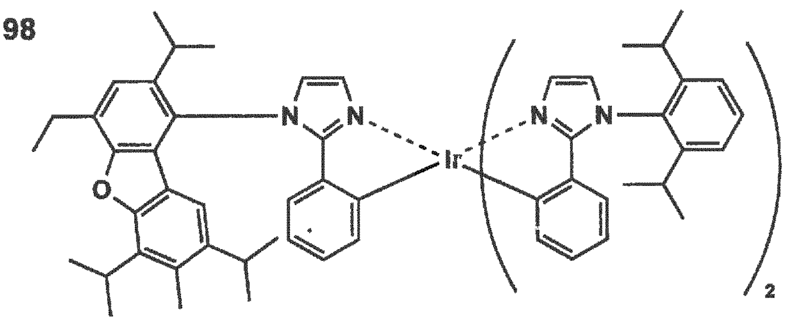

99

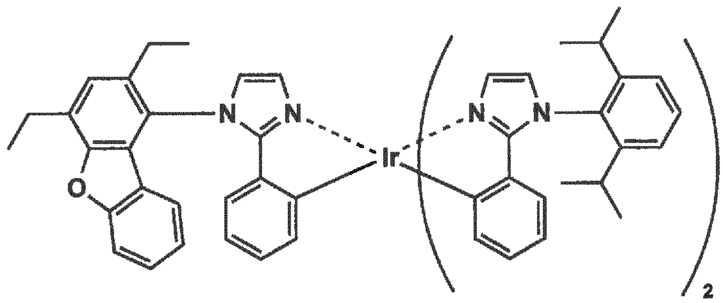

100

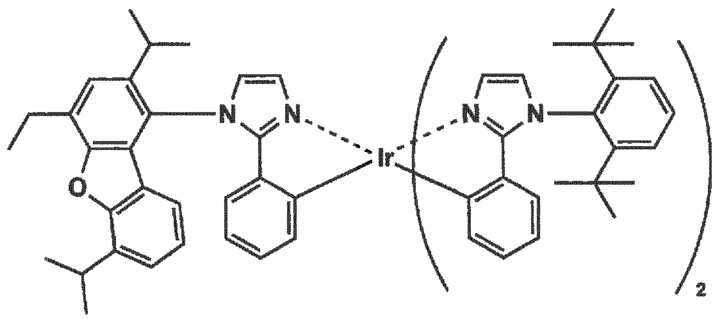

101

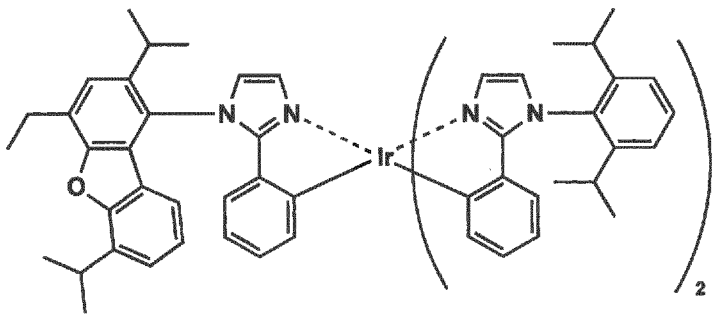

102

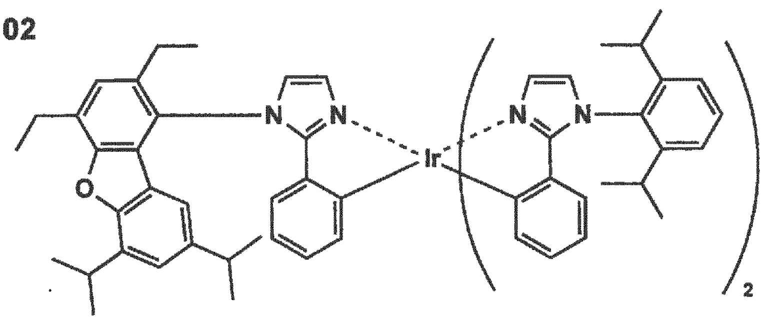

The organic EL element of the present invention will be described.

<<Constituent layers constituting the organic EL element>>

Preferable examples of the constituent layers constituting the organic EL element of the present invention are described below, but the present invention is not limited thereto.

(i) anode/light-emitting layer unit including light-emitting layer(s)/electron transporting layer/cathode
(ii) anode/electron hole transporting layer/ light-emitting layer unit including light-emitting layer(s)/electron transporting layer/cathode
(iii) anode/electron hole transporting layer/ light-emitting layer unit including light-emitting layer(s)/electron hole

blocking layer/electron transporting layer/cathode;
(iv) anode/electron hole transporting layer/ light-emitting layer unit including light-emitting layer(s)/electron hole blocking layer/electron transporting layer/cathode buffer layer/cathode
(v) anode/anode buffer layer/electron hole transporting layer/ light-emitting layer unit including light-emitting layer(s)/electron hole blocking layer/electron transporting layer/cathode buffer layer/cathode

In the light-emitting layer unit, a non-light-emitting intermediate layer may be provided between light-emitting layers. The light-emitting layer unit may have a multiphoton structure, i.e., the intermediate layer may be a charge producing layer. In this case, examples of the charge producing layer include conductive inorganic layers composed of indium tin oxide (ITO), indium zinc oxide (IZO), $ZnO_2$, TiN, ZrN, HfN, $TiO_x$, $VO_x$, CuI, InN, GaN, $CuAlO_2$, $CuGaO_2$, $SrCu_2O_2$, $LaB_6$, $RuO_2$ or the like, bi-layered film composed of $Au/Bi_2O_3$ or the like, multi-layered film composed of $SnO_2/Ag/SnO_2$, ZnO/Ag/ZnO, $Bi_2O_3/Au/ Bi_2O_3$, $TiO_2/TiN/TiO_2$, $TiO_2/ZrN/TiO_2$ or the like, fullerenes such as C60, conductive organic layers composed of oligothiophene or the like, conductive organic layers composed of metal phthalocyanines, metal-free phthalocyanines, metal porphyrins, metal-free porphyrins or the like. The light-emitting layer of the organic EL element of the present invention is preferably a white light-emitting layer, and the lighting device and display device of the present invention preferably has the white light-emitting layer.
Next, each of the constituent layers constituting the organic EL element will be described in detail.

<<light-emitting layer»

The light-emitting layer composing the organic EL element of the present invention emits light by recombining the electrons with electron holes injected from the electrodes, electron transporting layer or electron hole transporting layer. Light-emitting part(s) may be in the light-emitting layer or may be the interface between the light-emitting layer and the adjacent layer.
The total thickness of the light-emitting layer is not particularly limited; however, in terms of homogeneity of the layer, prohibition of undesirably high voltage upon light emission and stability of color of light according to driving voltage, the total thickness is adjusted to preferably from 2 nm to 5 μm, more preferably 2 to 200 nm, and particularly 5 to 100 nm.
To prepare the light-emitting layer, a light-emitting dopant (the ortho-metalated iridium complex of the present invention, for example) and a host, both of which are described later, are used to form the layer by vacuum deposition, wet method (also referred to as a "wet process" exemplified by spin coating, casting, die coating, blade coating, roll coating, ink jet coating, printing, spray coating, curtain coating, Langmuir Blodgett method (LB method) and the like). In the case of using the ortho-metalated iridium complex of the present invention, wet process is suitable.
The light-emitting layer of the organic EL element of the present invention preferably contains light-emitting dopants (phosphorescence-emitting dopants (also referred to as "phosphorescent dopants" or "phosphorescence-emitting dopant groups") or fluorescent dopants, for example) and light-emitting hosts.

(light-emitting dopant)

The light-emitting dopant will be described.
Fluorescent dopants and phosphorescent dopants may be used as the light-emitting dopant.

<Phosphorescent dopant>

Phosphorescent dopants applicable to the present invention will be described.
The phosphorescent dopant of the present invention emits light from the excited triplet state. Specifically, the phosphorescent dopant of the present invention is a compound emitting phosphorescence at room temperature (25 °C). A phosphorescence quantum yield of the phosphorescent dopant is defined as 0.01 or more at 25 °C, and preferably 0.1 or more.
A phosphorescence quantum yield may be measured according to the method described in page 398 of the fourth series of Experimental Chemistry 7, Spectroscopy II, 1992 from MARUZEN Co., Ltd. A phosphorescence quantum yield in a solution may be measured using various solvents as long as a phosphorescence quantum yield of the phosphorescent dopant is 0.01 or more.
There are two principles of light emission by phosphorescent dopants. One is an energy-transporting type characterized in that a carrier recombines with a host on the host to which the carrier is transported to generate an excited state of the light-emitting host, and then the energy is transported to the phosphorescent dopant to emit light from the phosphorescent dopant. The other is a carrier trapping type characterized in that the phosphorescent dopant is a carrier trap which causes recombining of the carrier with the phosphorescent dopant on the phosphorescent dopant to emit light from the phosphorescent dopant. In both cases, it is required that an energy of the phosphorescent dopant

in an excited state is bigger than an energy of the host in an excited state.

In the organic EL element of the present invention, preferably, at least one light-emitting layer contains an organometallic complex emitting phosphorescence (also referred to as a "phosphorescence-emitting dopant", "phosphorescent dopant" or the like). Particularly, the organometallic complex emitting phosphorescence is preferably the ortho-metalated iridium complex of the present invention represented by the general formula (1).

For the light-emitting layer of the present invention, known compounds disclosed in the publications listed below may be additionally used.

The publications are, for example, International Publication WO00/70655, Japanese Patent Application Laid-open Publications Nos. 2002-280178, 2001-181616, 2002-280179, 2001-247859, 2002-299060, 2001-313178, 2002-302671 2001-181617, 2002-280180, 2001-345183, 2002-324679, International Publication WO02/15645, Japanese Patent Application Laid-open Publications Nos. 2002-332291, 2002-50484, 2002-332292, 2002-83684, 2002-540572, 2002-117978, 2002-338588, 2002-170684, 2002-352960, International Publication WO01/93642, Japanese Patent Application Laid-open Publications Nos. 2002-50483, 2002-100476, 2002-173674, 2002-359082, 2002-175884, 2002-363552, 2002-184582, 2003-7469, 2002-525808, 2003-7471, 2002-525833, 2003-31366, 2002-226945, 2002-234894, 2002-235076, 2002-241751, 2001-319779, 2001-319780, 2002-62824, 2002-100474, 2002-203679, 2002-343572, 2002-203678 and the like.

<Fluorescent dopant>

Examples of the fluorescent dopant include coumarin dyes, pyran dyes, cyanine dyes, croconium dyes, squarylium dyes, oxobenzoanthracene dyes, fluorescein dyes, rhodamine dyes, pyrylium dyes, perylene dyes, stilbene dyes, polythiophene dyes, fluorescent rare earth complexes, compounds having a high fluorescence quantum yield such as laser dyes and the like.

Multiple types of light-emitting dopant used in the present invention may be used in combination. For example, phosphorescent dopants having different structures or phosphorescent dopants and fluorescent dopants may be used in combination.

Specific examples of the light-emitting dopants which can be used in combination with the ortho-metalated iridium complex of the present invention represented by the genera formula (1) include the following known compounds, but the present invention is not limited thereto.

D-1

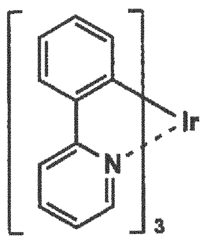

D-2

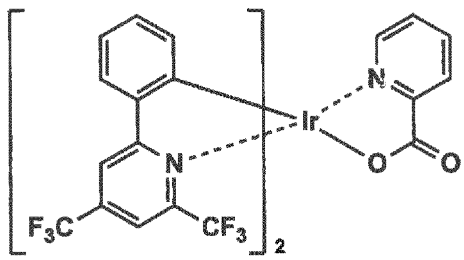

D-3

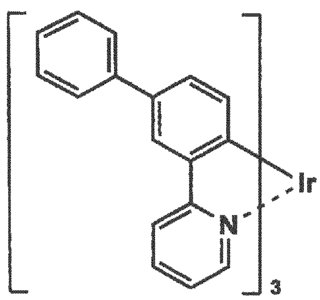

D-4

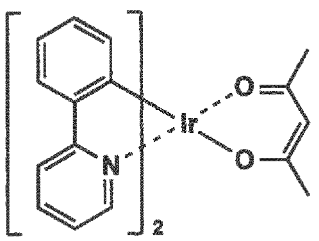

D-5

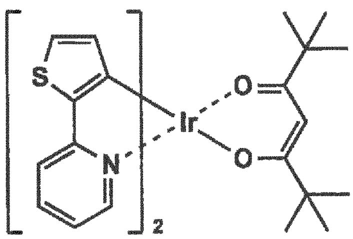

D-6

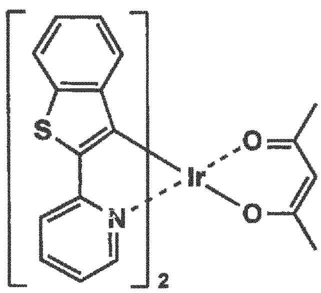

D-7

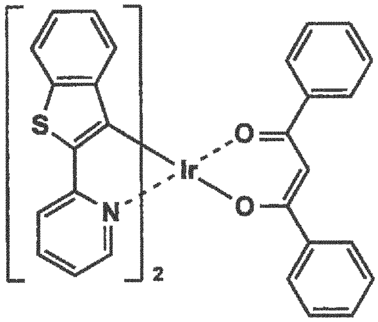

D-8

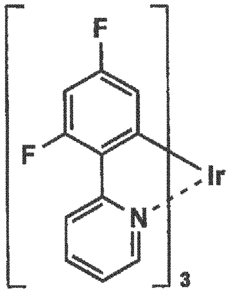

D-9

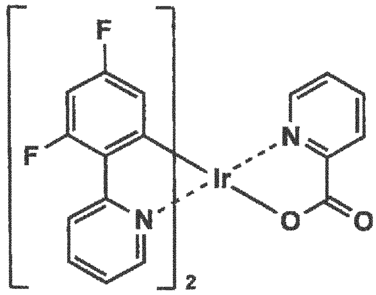

D-10

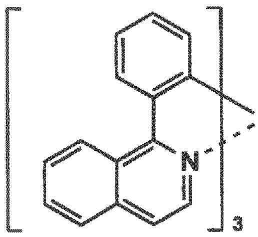

D-11

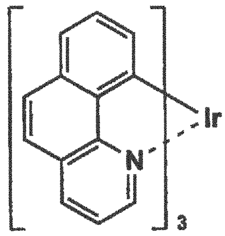

D-12

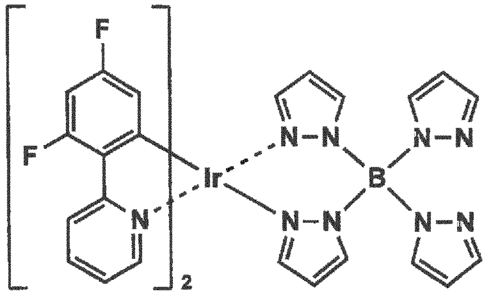

D-13

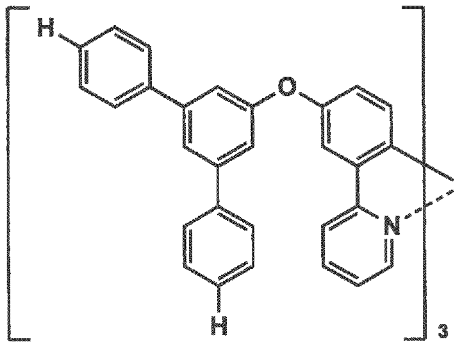

D-14

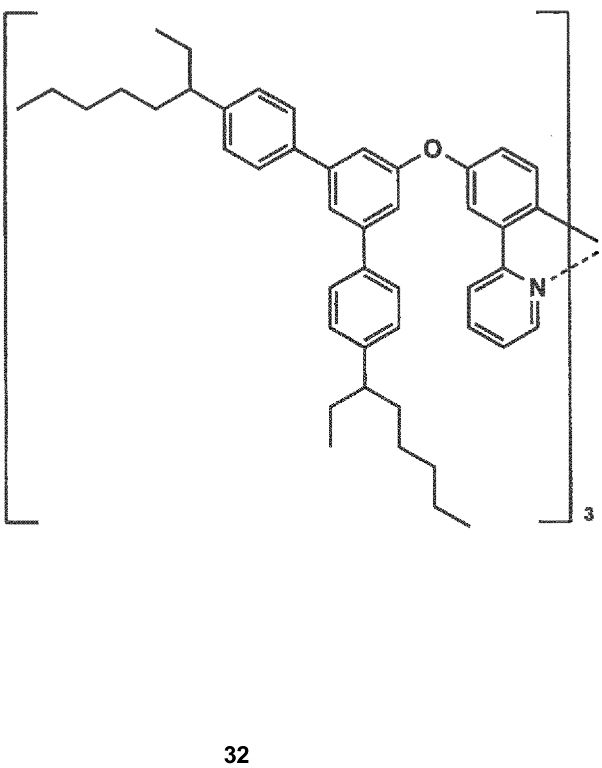

D−15

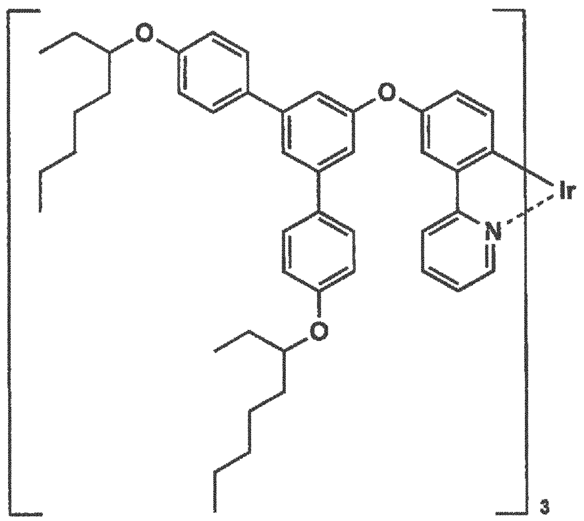

D−16

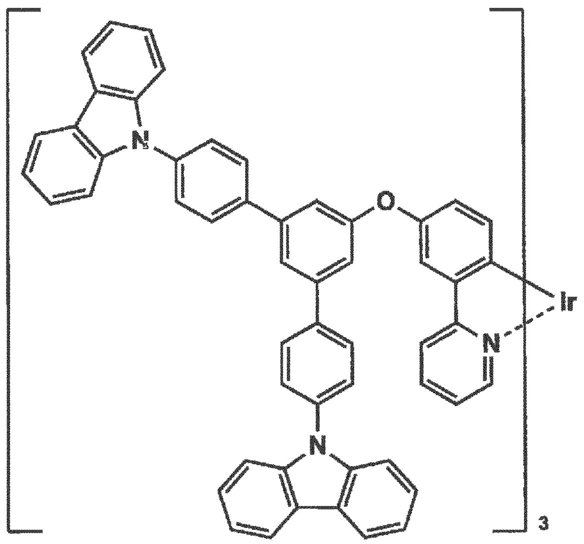

D−17

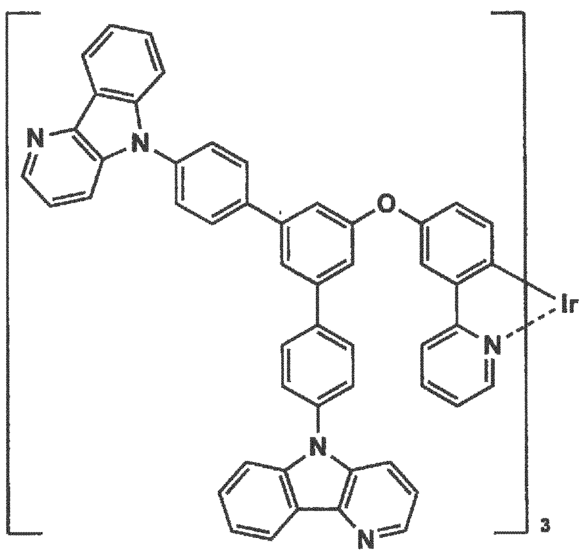

D−18

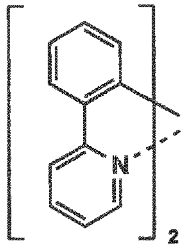

D−19

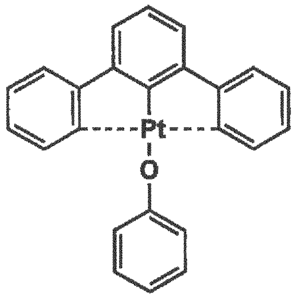

D−20

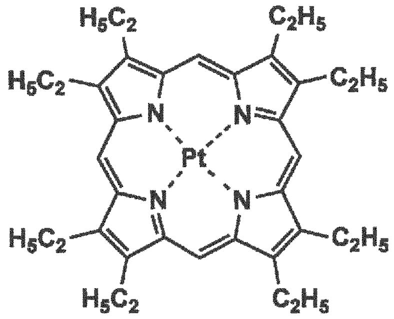

D−21

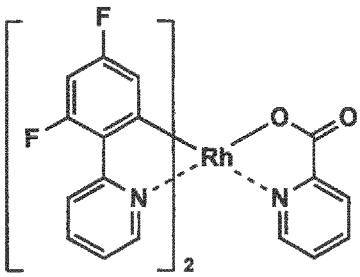

D−22

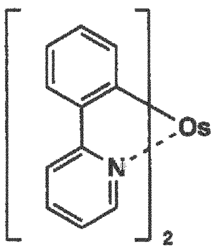

D−23

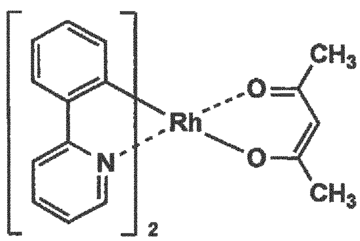

D−24

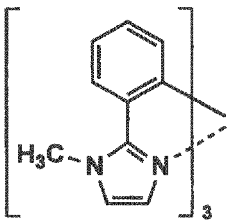

D−25

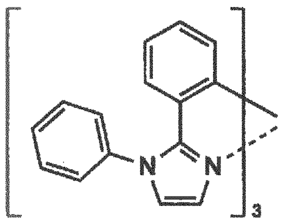

D−26

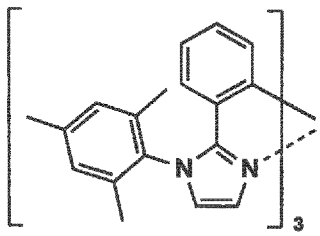

D−27

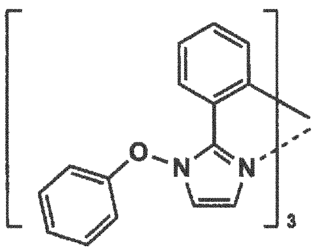

D−28

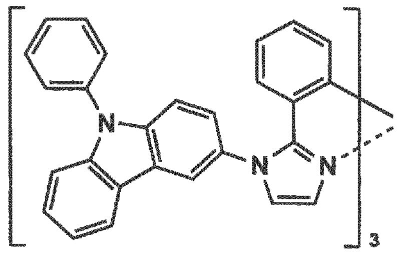

D−29

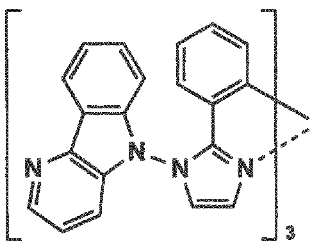

D−30

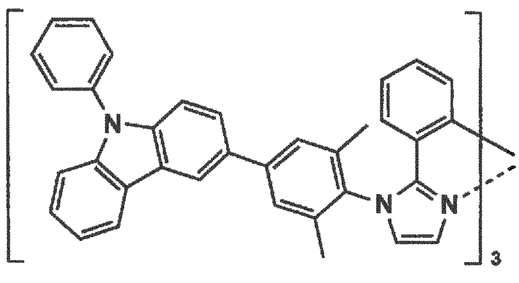

D−31

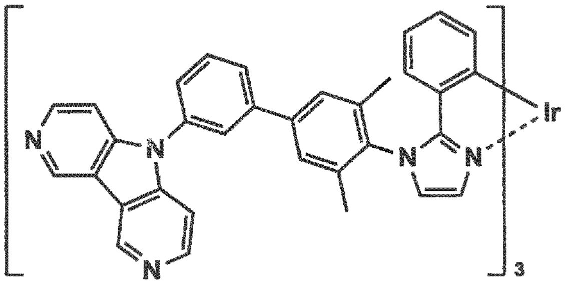

D−32

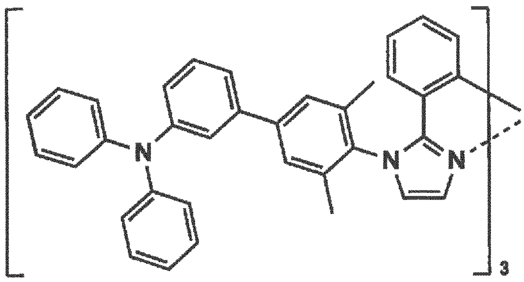

D−33

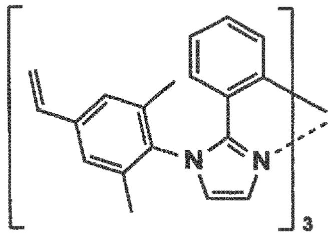

D−34

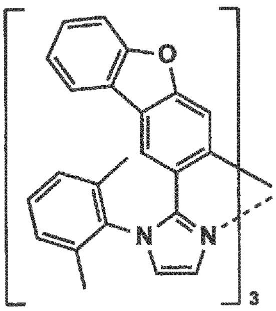

D−35

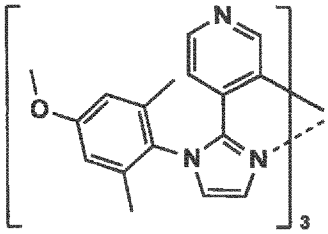

D−36

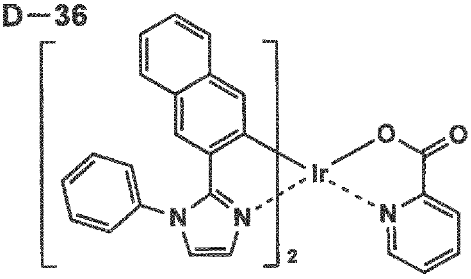

D−37

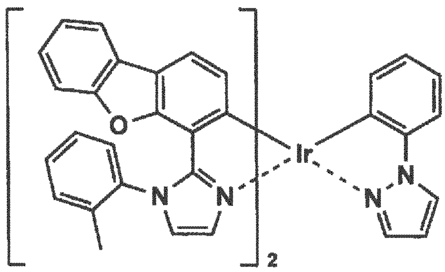

D-38

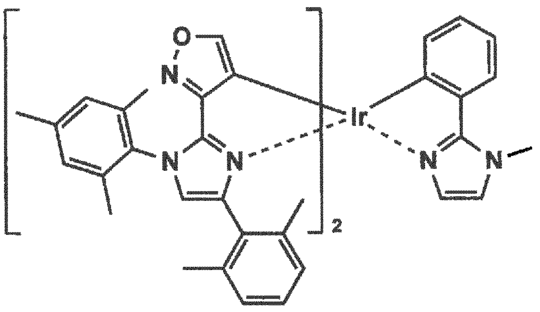

D-39

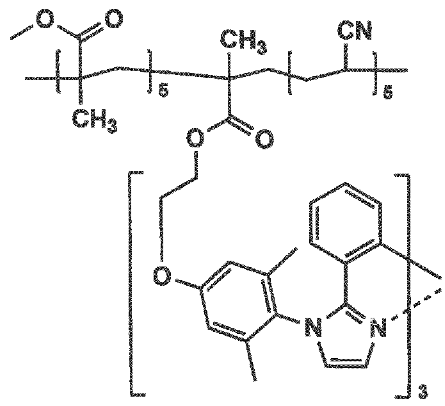

D-40

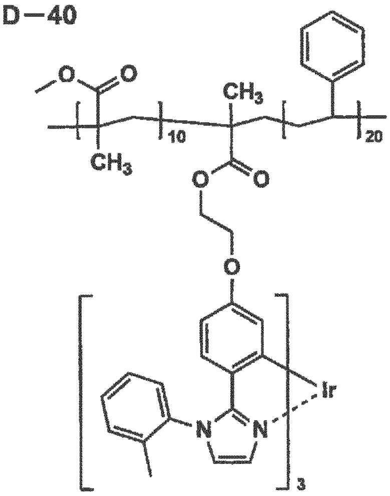

D-41

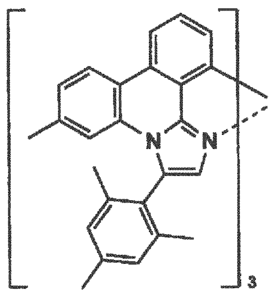

D-42

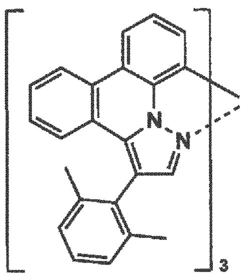

D-43

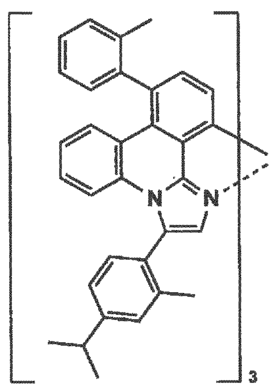

D-44

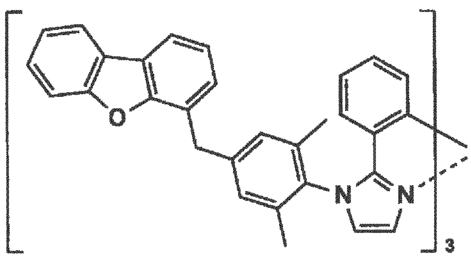

D-45

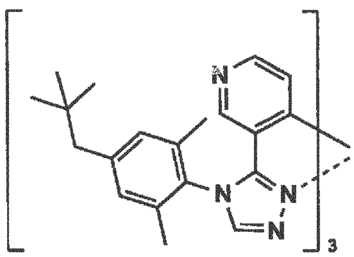

D-46

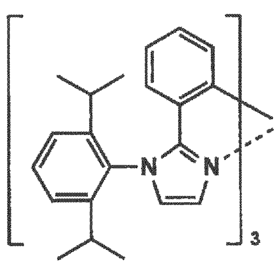

D-47

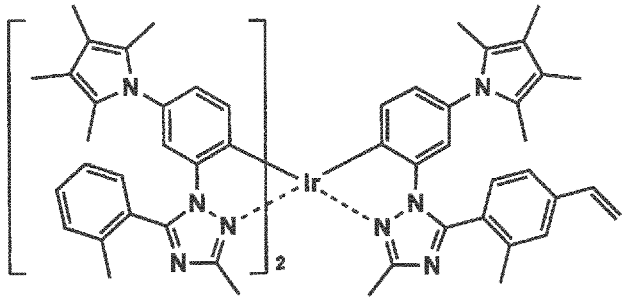

(Light-emitting host)

In the present invention, a mass ratio of the light-emitting host in the light-emitting layer is 20% or more with respect to all of the compounds contained in the light-emitting layer. In addition, the light-emitting host is defined as having a phosphorescence quantum yield in producing phosphorescence of less than 0.1, and preferably less than 0.01 at room temperature (25 °C).

The light-emitting host employable in the present invention is not particularly limited. Any conventional compounds that have been used as the light-emitting hosts in an organic EL element may be used. Representative examples include compounds having structures of carbazole derivatives, triarylamine derivatives, aromatic compound derivatives, nitrogenous heterocyclic compounds, thiophene derivatives, furan derivatives, oligoarylene compounds and the like; carboline derivatives; diazacarbazole derivatives (i.e., carboline derivatives where at least one carbon atom of a hydrocarbon ring of a carboline ring is substituted with a nitrogen atom) and the like.

A known light-emitting host employable in the present invention is preferably capable of transporting electron holes and electrons and avoiding emitting light of longer wavelength; a known light-emitting host employable in the present invention preferably has a high glass transition temperature (Tg).

In the present invention, one type of known light-emitting hosts may be used alone, or two or more types thereof may be used in combination. By using multiple types of known light-emitting hosts, transportation of electronic charge can be controlled, and thus an organic EL element having high efficiency can be provided.

In addition, by using multiple types of ortho-metalated iridium complex of the present invention represented by the genera formula (1) or known compounds as the phosphorescent dopants, different types of light can be emitted and mixed. Accordingly, any desired colors of the light can be obtained.

The light-emitting host employable in the present invention may be a low molecular compound, high molecular compound containing repeating unit(s), or low molecular compound containing polymerizable group(s) such as vinyl and epoxy groups (polymerizable light-emitting host). One type of such compounds may used alone, or two or more types thereof may be used in combination.

Specific examples of the known light-emitting hosts include compounds disclosed in the publications listed below.

The publications are, for example, Japanese Patent Application Laid-open Publications Nos. 2001-257076, 2002-308855, 2001-313179, 2002-319491, 2001-357977, 2002-334786, 2002-8860, 2002-334787, 2002-15871, 2002-334788, 2002-43056, 2002-334789, 2002-75645, 2002-338579, 2002-105445, 2002-343568, 2002-141173, 2002-352957, 2002-203683, 2002-363227, 2002-231453, 2003-3165, 2002-234888, 2003-27048, 2002-255934, 2002-260861, 2002-280183, 2002-299060, 2002-302516, 2002-305083, 2002-305084, 2002-308837 and the like.

Specific examples employable as the light-emitting hosts in the light-emitting layer of the organic EL element include the followings, but not limited thereto.

H-1

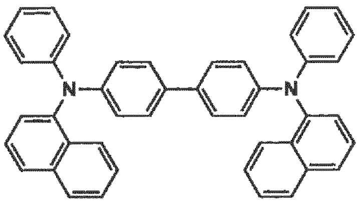

H-2

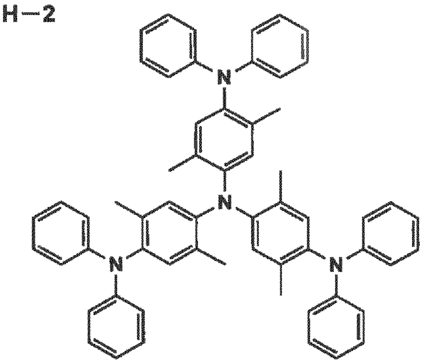

H-3

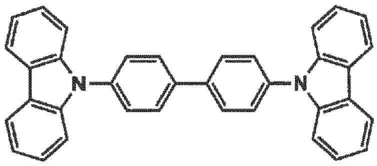

H-4

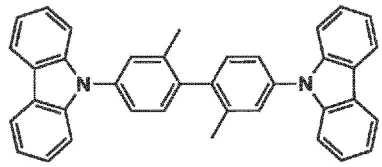

H-5

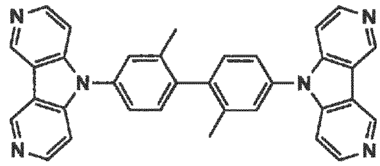

H-6

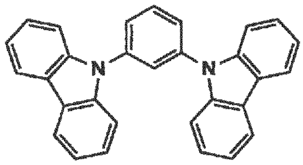

H-7

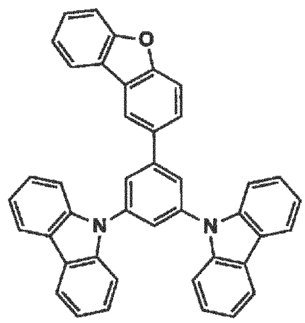

H-8

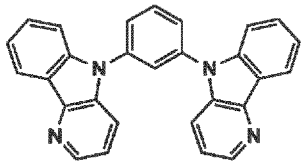

H-9

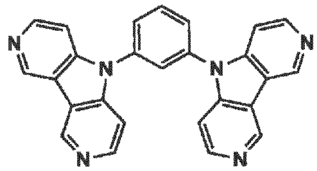

H-10

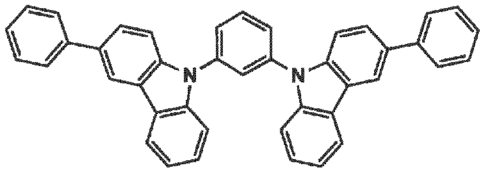

H-11

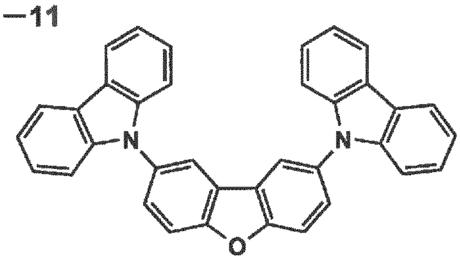

H-12

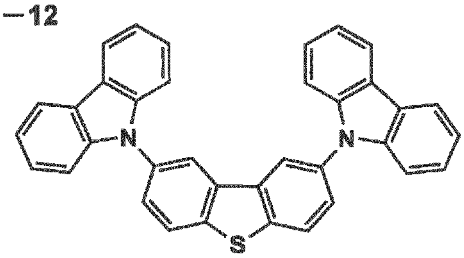

H−13

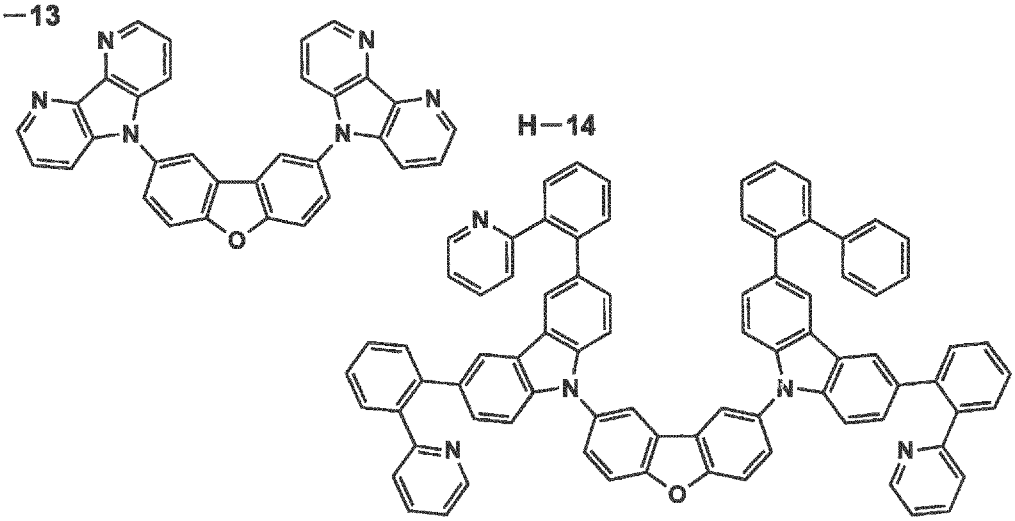

H−14

H−15

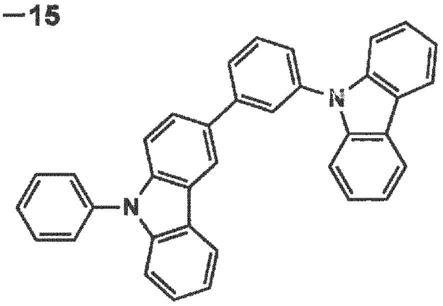

H−16

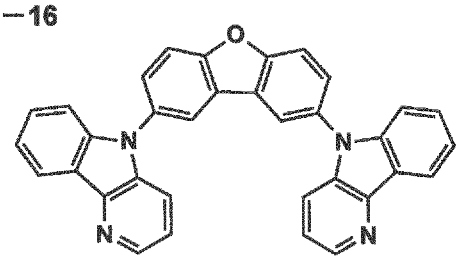

H−17

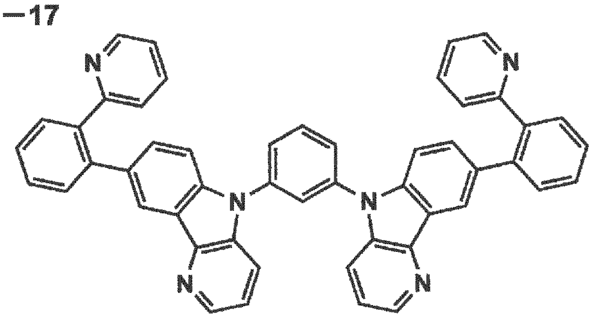

H−18

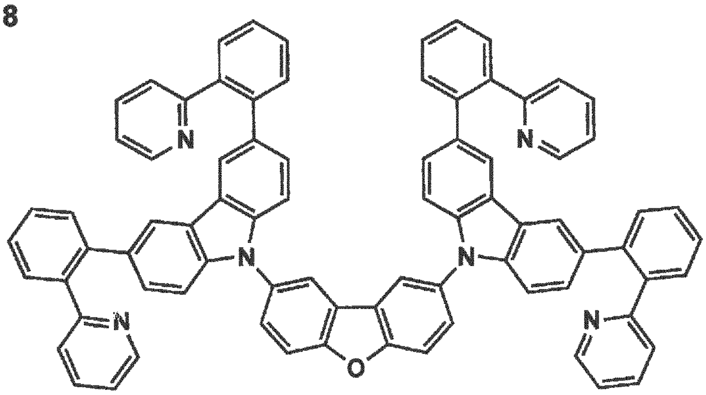

H-19

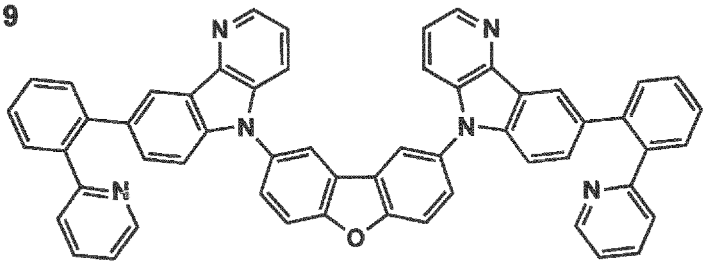

H-20

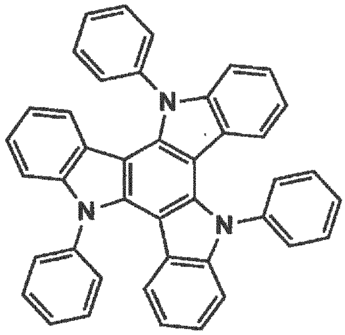

H-21

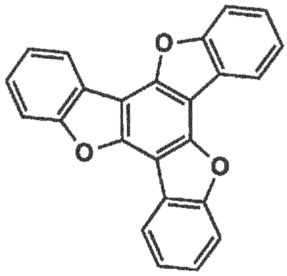

H-22

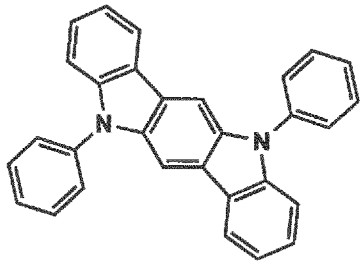

H-23

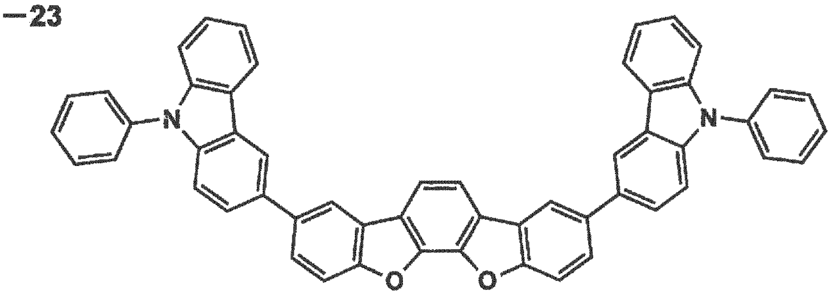

H-24

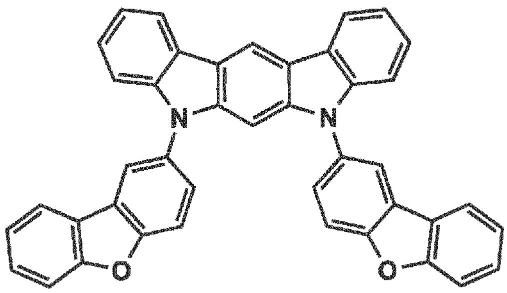

H-25

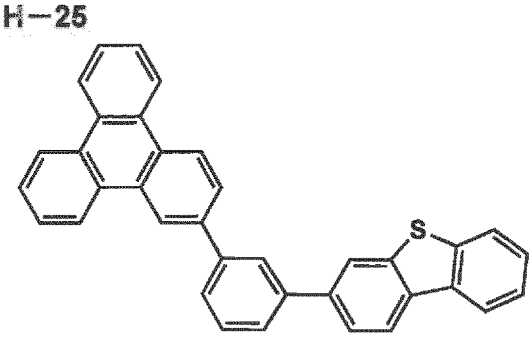

H-26

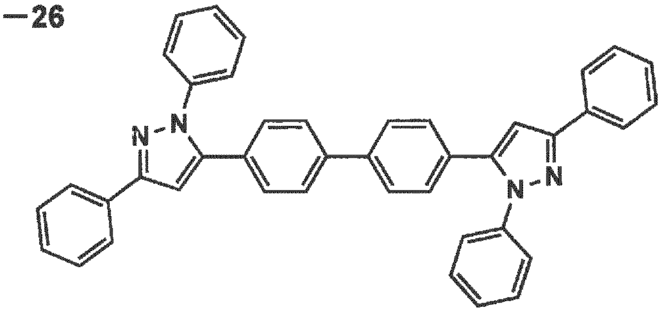

H−27

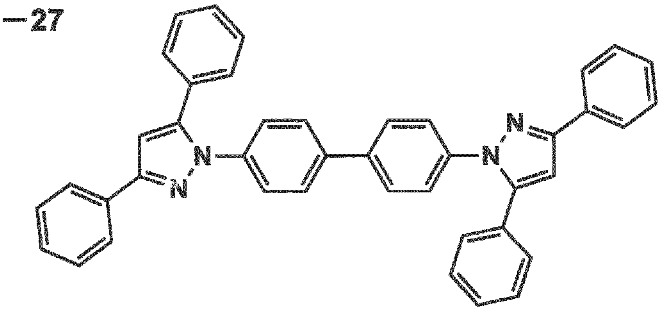

H−28

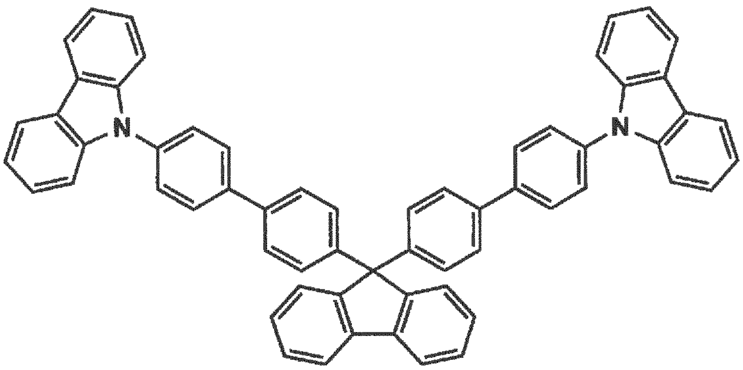

H−29

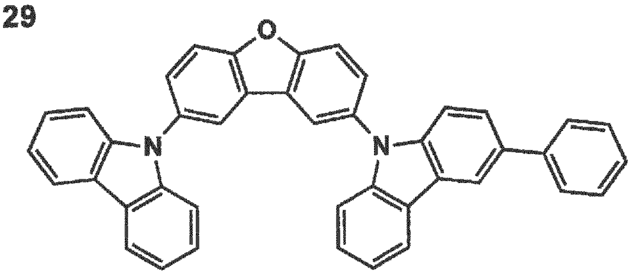

H−30

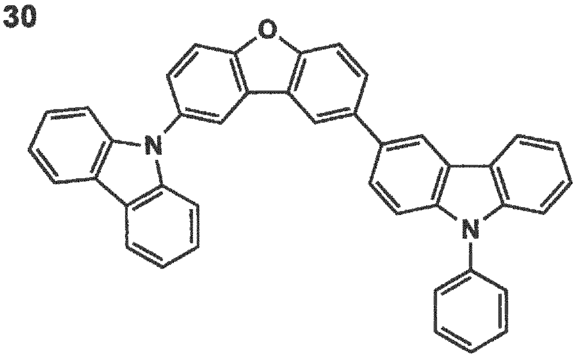

H−31

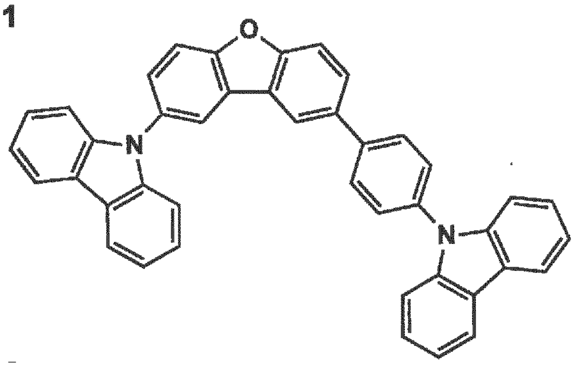

H−32

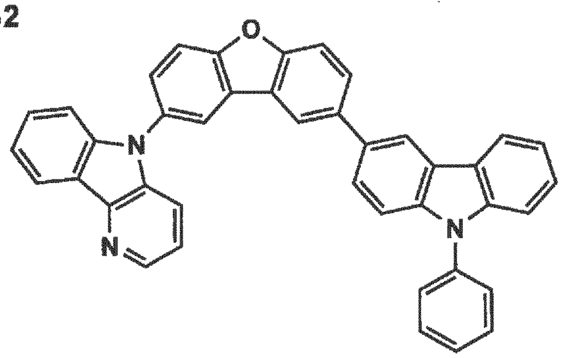

Particularly preferable hosts in the light-emitting layer of the organic EL element of the present invention are compounds represented by the following general formula (A).

General formula (A)

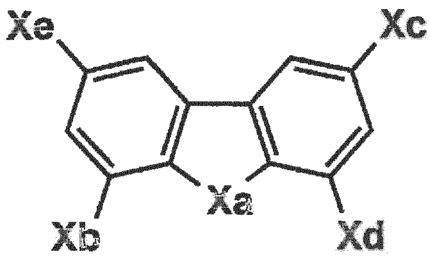

In the general formula (A), Xa represents an oxygen or sulfur atom; Xb, Xc, Xd and Xe each represents a hydrogen atom, substituent group or group represented by the following general formula (B) ; at least one of Xb, Xc, Xd and Xe represents a group represented by the following general formula (B); and the Ar in the following general formula (B) represents a carbazolyl group in at least one of the groups represented by the following general formula (B).

General formula (B) $Ar-(L_4)_n-*$

In the general formula (B), $L_4$ represents a divalent linking group bonded to an aromatic hydrocarbon ring or aromatic hetero ring; n represents 0 or an integer from 1 to 3; when n is 2 or 3, multiple $L_4$s may be different to each other or the same; * represents a linking point with a compound represented by the general formula (A) ; and the Ar in the following general formula (B) represents a carbazolyl group in at least one of the groups represented by the following general formula (B).

General formula (C)

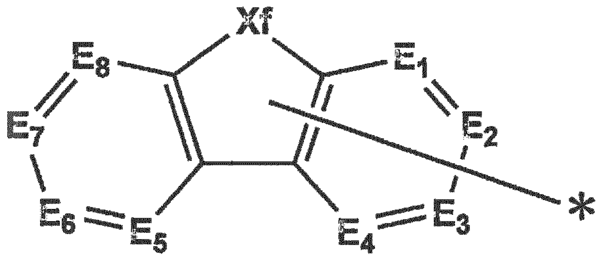

In the general formula (C), Xf represents N(R"), an oxygen or sulfur atom; E1 to E8 each represents C(R"$_1$) or a nitrogen atom; R" and R"$_1$ each represents a hydrogen atom, substituent group or linking point with $L_4$; and * represents a linking point with $L_4$.

Preferably, in the compounds represented by the general formula (A), at least two of Xb, Xc, Xd and Xe are groups represented by the general formula (B). More preferable configuration is that Xc is a group represented by the general formula (B), and Ar in the general formula (B) is a carbazolyl group that may have any substituent group(s).

Specific examples of the hosts (light-emitting hosts) represented by the general formula (A) in the light-emitting layer of the organic EL element of the present invention, but not limited thereto.

H−33

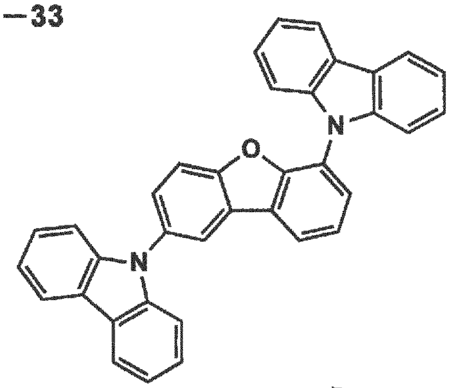

H−34

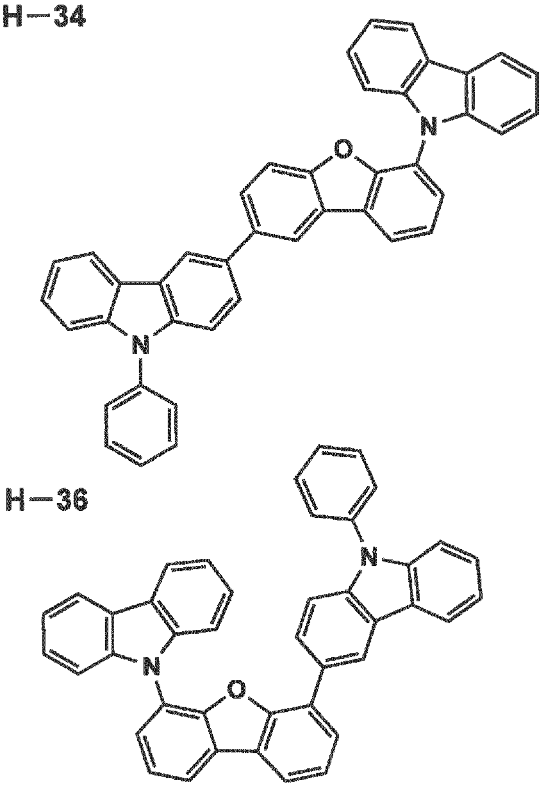

H−35

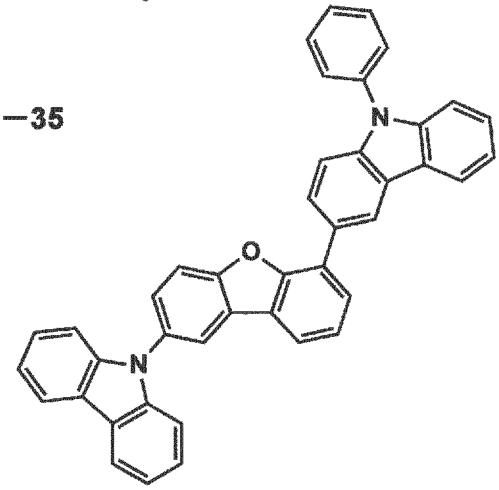

H−36

H−37

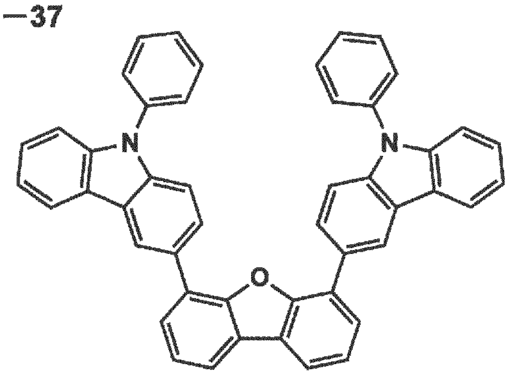

H−38

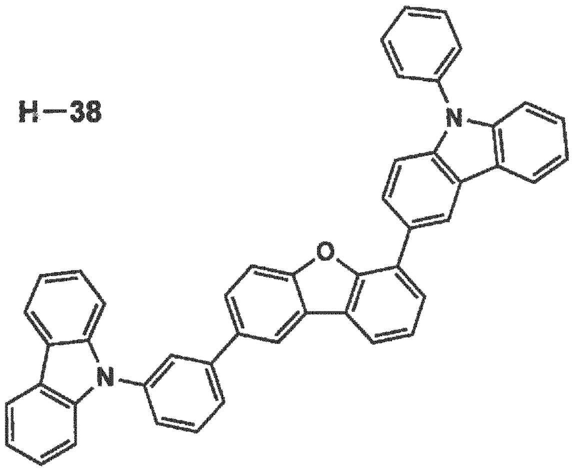

H−39

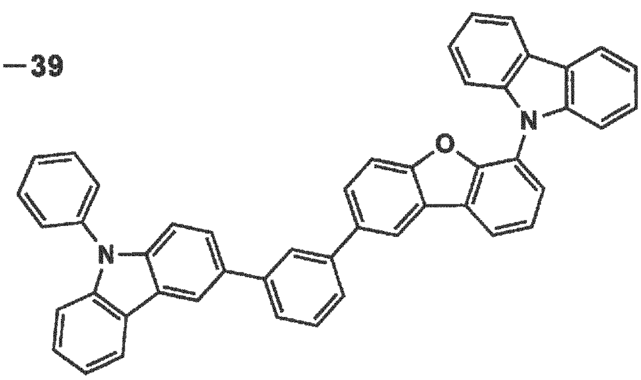

H−40

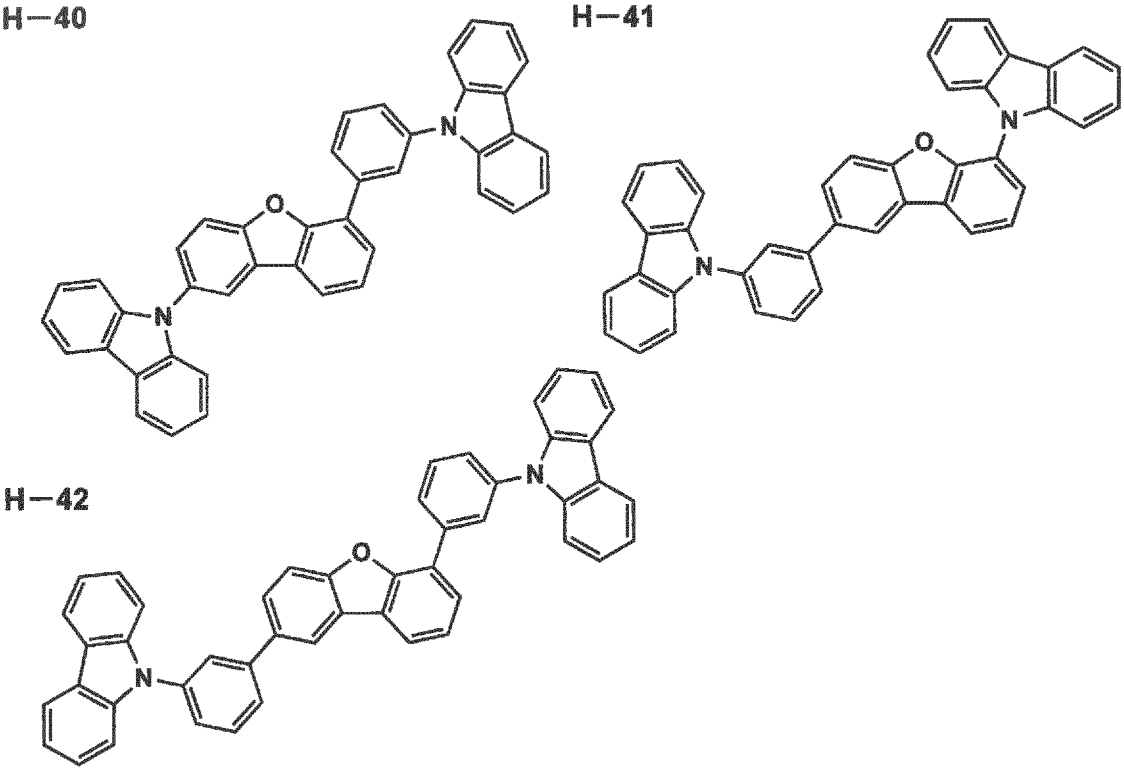

H−41

H−42

H−43

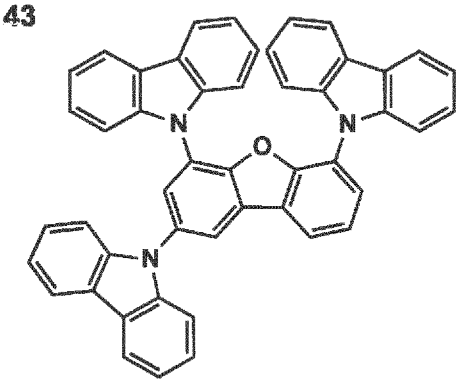

H−44

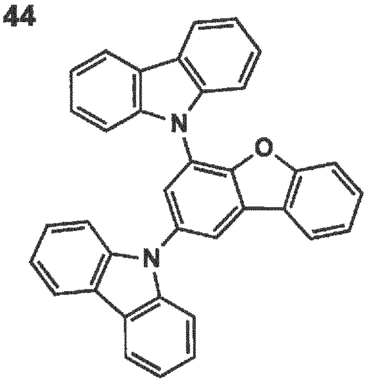

H−45

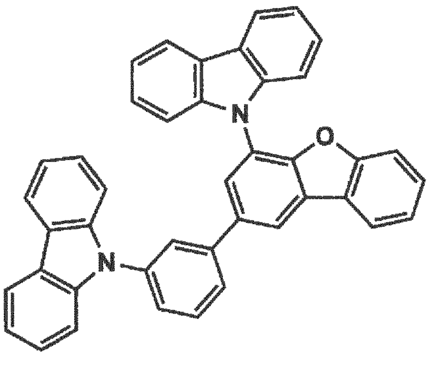

H−46

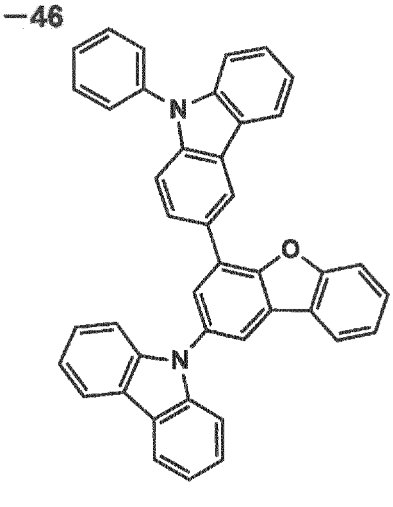

H-47

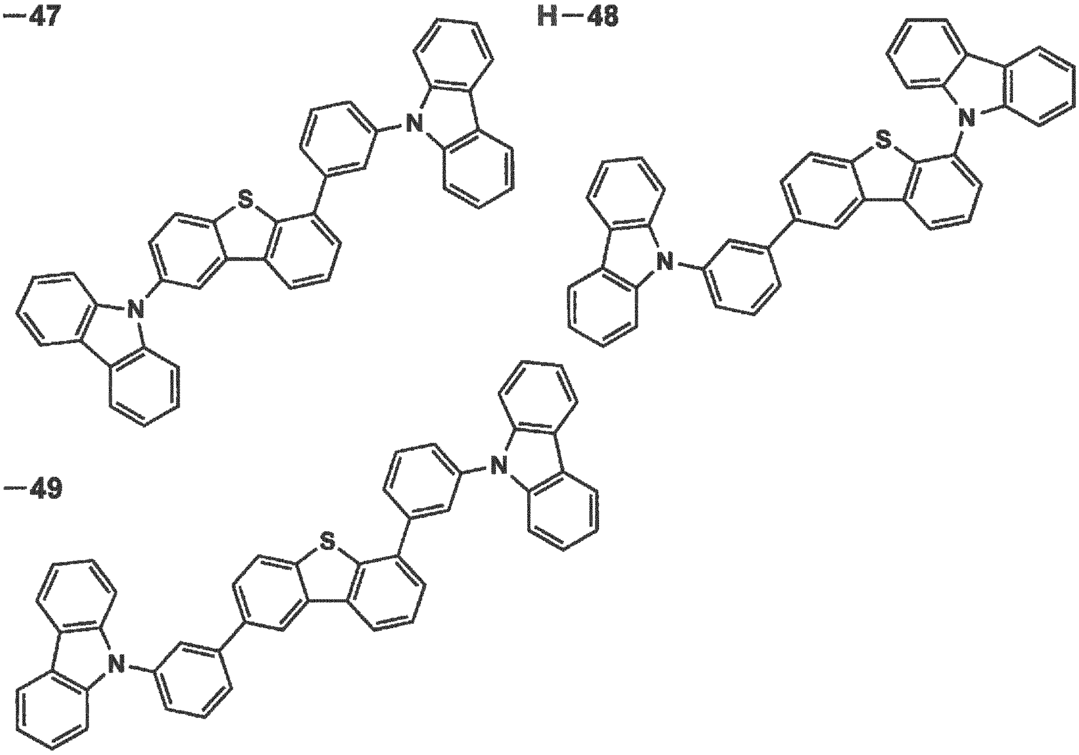

H-48

H-49

H-50

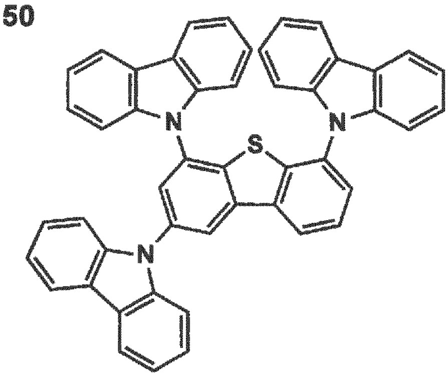

H-51

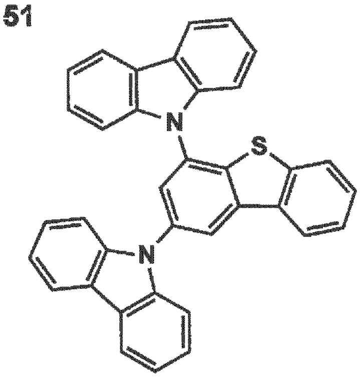

H-52

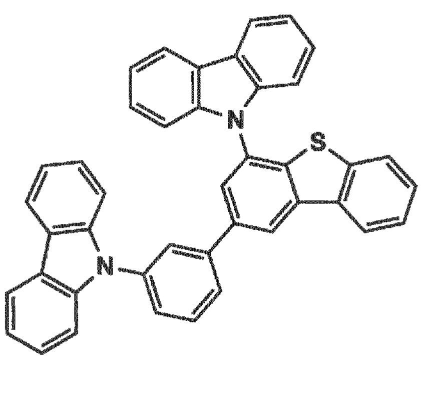

H-53

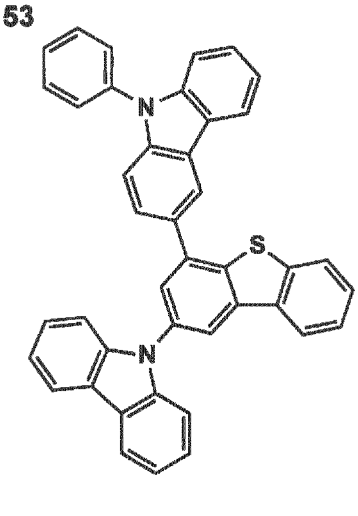

H-54

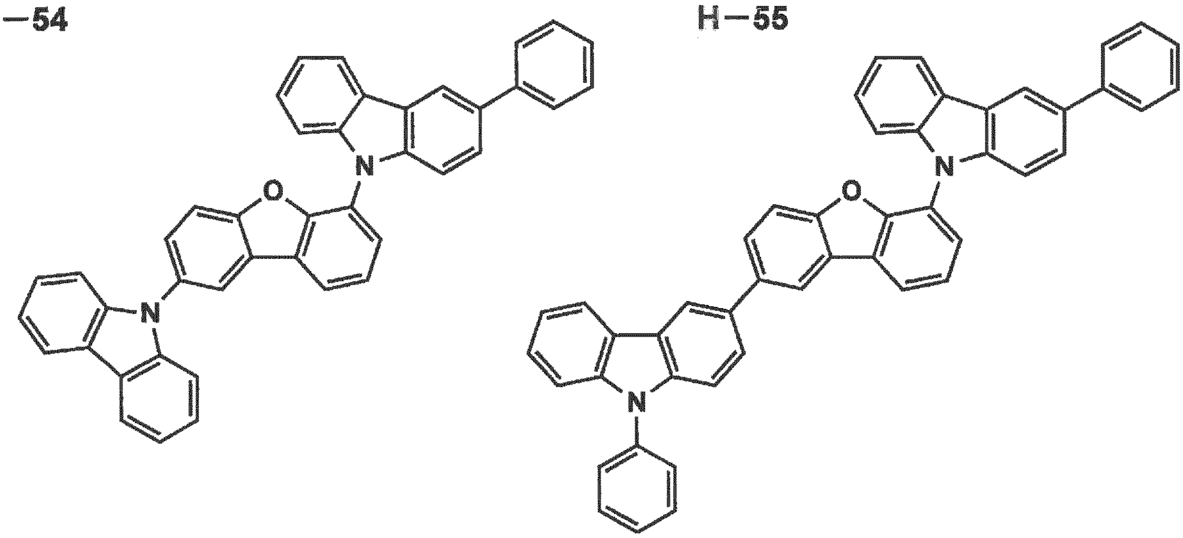

H-55

H-56

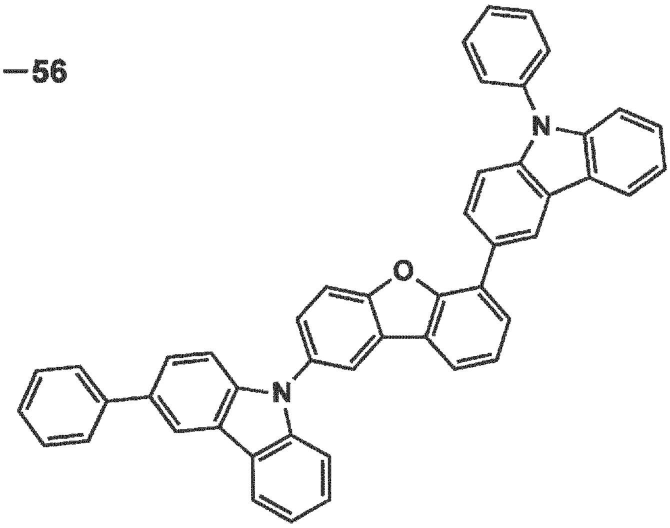

H-57

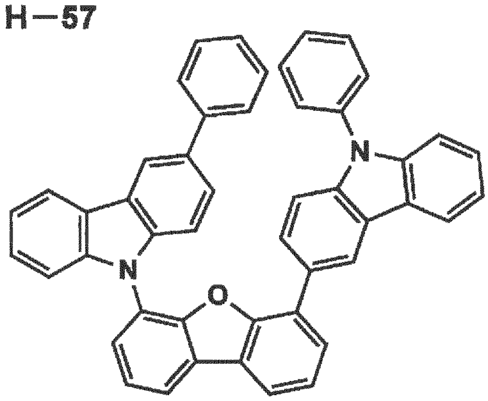

H-58

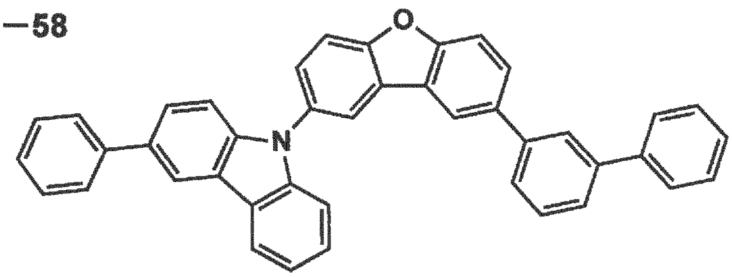

H-59

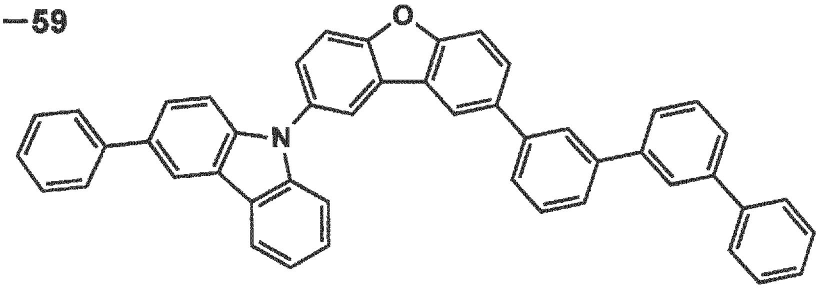

H-60

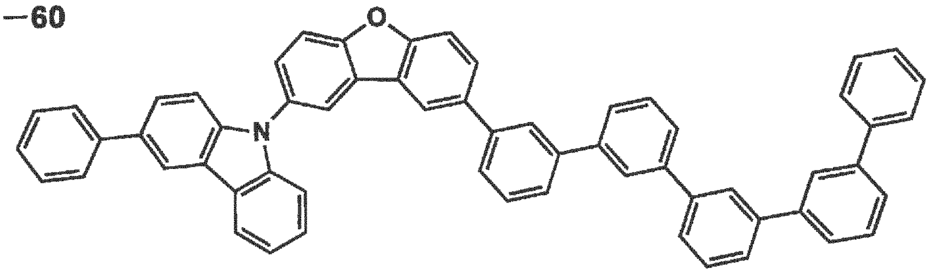

H-61

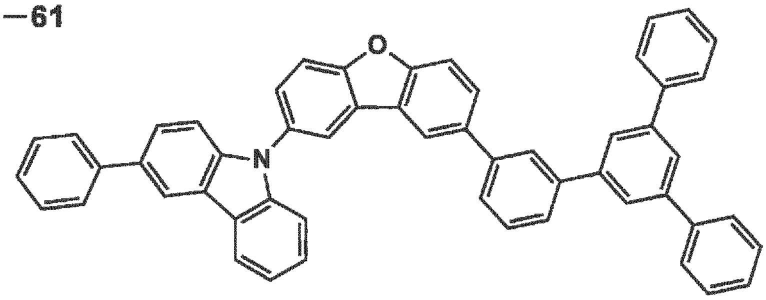

H-62

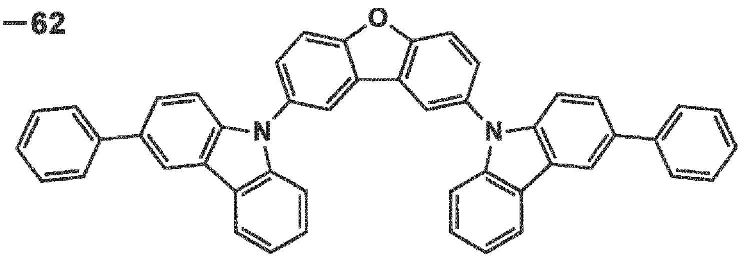

H-63

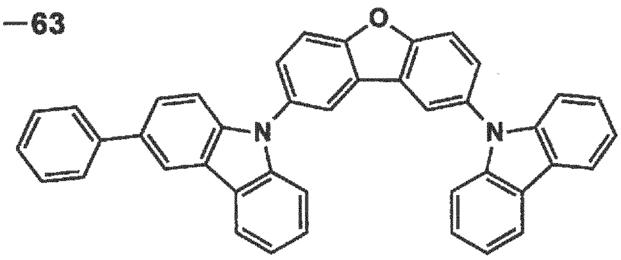

H-64

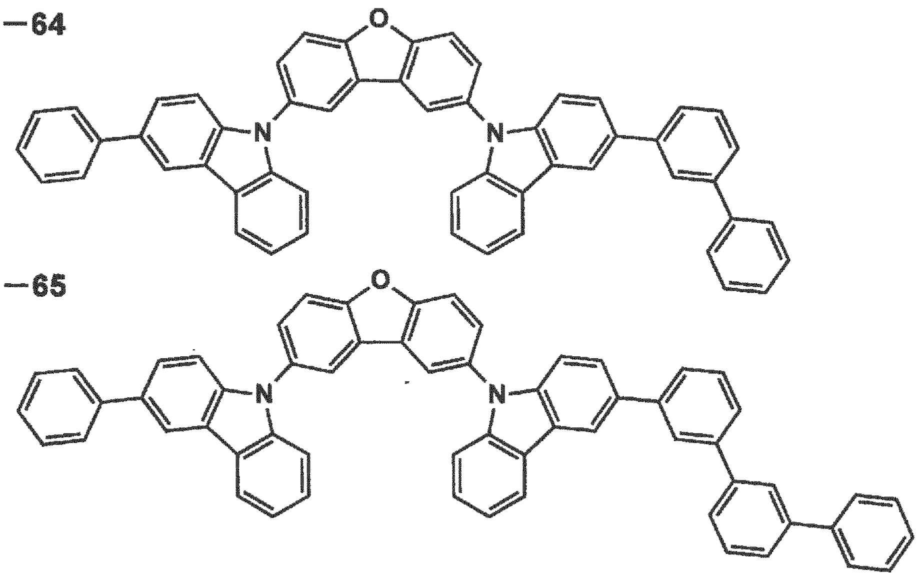

H-65

In addition, as the light-emitting hosts in the light-emitting layer of the organic EL element of the present invention, compounds represented by the following general formula (A') are particularly preferable.

General formula (A')

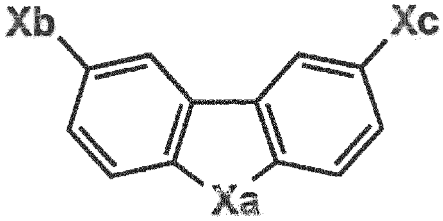

In the general formula (A'), Xa represents an oxygen or sulfur atom; Xb and Xc each represents a substituent group or group represented by the general formula (B); at least one of Xb and Xc represents a group represented by the general formula (B) ; and the Ar in the following general formula (B) represents a carbazolyl group in at least one of the groups represented by the following general formula (B).

In a compound represented by the general formula (A'), preferably, at least one of Xb and Xc is a group represented by the general formula (B), more preferably Ar of the general formula (B) represents a carbazolyl group that may have substituent group(s), and further more preferably Ar of the general formula (B) represents a carbazolyl group that is linked to $L_4$ on N that may be substituted with substituent group(s).

The compounds represented by the general formula (A') as preferable compounds for the hosts (light-emitting hosts) in the light-emitting layer of the organic EL element of the present invention may be, specifically, H-11, H-30, H-33, H-59, H-60, H-61 or H-62 given as specific examples of the light-emitting host above, but the present invention is not limited thereto.

[Electron transporting layer]

The electron transporting layer is composed of materials capable of transporting electrons. In a broad sense, an electron injecting layer and an electron hole transporting layer are types of electron transporting layer. One, or two or more electron transporting layers may be provided.

The electron transporting layer may be any layer as long as the layer is capable of transporting electrons injected from the cathode to the light-emitting layer. The electron transporting layer may be composed of any materials selected from known compounds, and two or more compounds may be used in combination.

Examples of known materials (hereinafter referred to as "electron transporting materials") used in the electron transporting layer include polycyclic aromatic hydrocarbons such as nitro-substituted fuluorene derivatives, diphenylquinone derivatives, thiopyran dioxide derivatives and naphthalene perylene, heterocyclic tetracarbonic acid anhydrides,

carbodiimides, fluorenylidene methane derivatives, derivatives of anthraquino-dimethane or anthrone, oxadiazole derivatives, carboline derivatives, carboline derivatives containing a ring where at least one of carbon atoms of the carboline ring of the carboline derivative is substituted with a nitrogen atom, hexaazatriphenylene derivatives and the like.

In addition, substituted oxadiazole derivatives where the oxygen atom on the oxadiazole ring is substituted with a sulfur atom, namely, thiadiazole derivatives and quinoxaline derivatives containing a quinoxaline ring known as an electron withdrawing group may be used as the electron transporting material.

The above compounds may be introduced in polymer chains or used as a main chain of a polymer. Such polymers may be used as the electron transporting material.

Further examples of the electron transporting material include metal complexes of 8-quinolinole derivatives such as tris(8-quinolinol) aluminum ($Alq_3$), tris(5,7-dichloro-8-quinolinol) aluminum, tris(5,7-dibromo-8-quinolinol) aluminum, tris(2-methyl-8-quinolinol) aluminum, tris(5-methyl-8-quinolinol)aluminum, bis(8-quinolinol) zinc, and complexes where the central metal of any of these complexes is substituted with In, Mg, Cu, Ca, Sn, Ga or Pb.

In addition, metal phthalocyanines, metal-free phthalocyanines, metal phthalocyanines of which ends are substituted with an alkyl group or sulfonic acid group or metal-free phthalocyanines of which ends are substituted with an alkyl group or sulfonic acid group may be used as the electron transporting material.

Inorganic semiconductors such as n-Si and n-SiC may also be used as the electron transporting material.

The electron transporting layer is preferably formed to be a thin layer by vacuum deposition, a wet method (also referred to as a "wet process" exemplified by spin coating, casting, die coating, blade coating, roll coating, ink jet coating, printing, spray coating, curtain coating, Langmuir Blodgett (LB) method) .

Methods for forming the constituent layers constituting the organic EL element will be described later in detail in the description of preparations of the organic EL elements.

The thickness of the electron transporting layer is not particularly limited, and normally from 5 to 5000 nm, and preferably 5 to 200 nm. The electron transporting layer may be a single layer composed of one or two or more of the above materials.

In addition, n-type dopants such as metal complexes or metal compounds such as metal halides may be doped to be used in the electron transporting layer.

Specific examples of the known compounds (electron transporting materials) preferably used in forming the electron transporting layer of the organic EL element of the present invention include the followings, but the present invention is not limited thereto.

ET−1

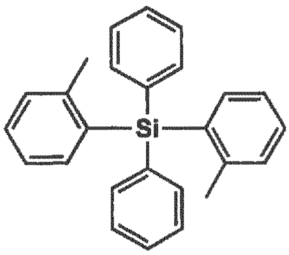

ET−2(BCP)

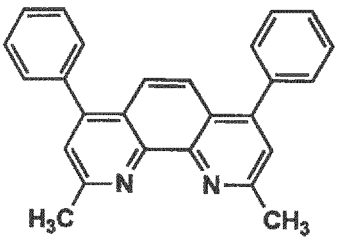

ET−3(PBD)

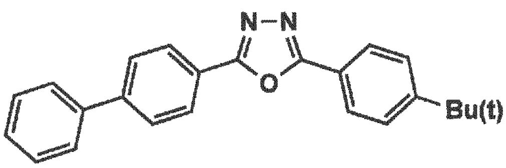

ET−4

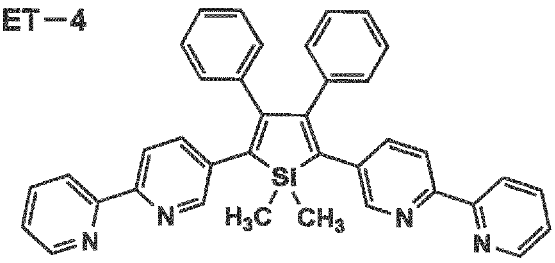

ET−5

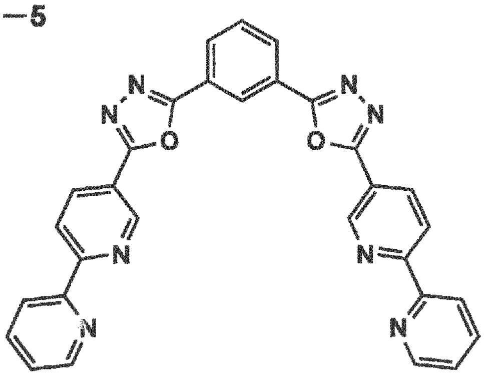

ET−6

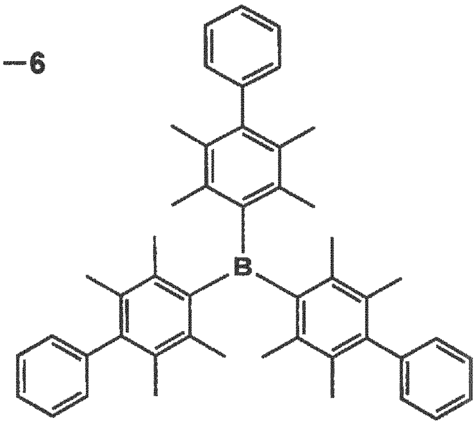

ET−7(Alq$_3$)

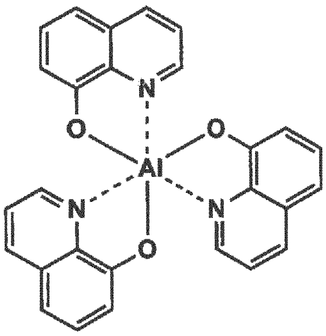

ET−8(BAlq)

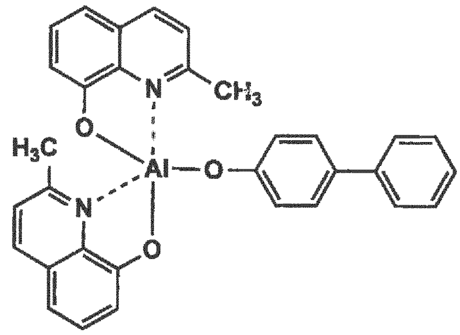

ET−9

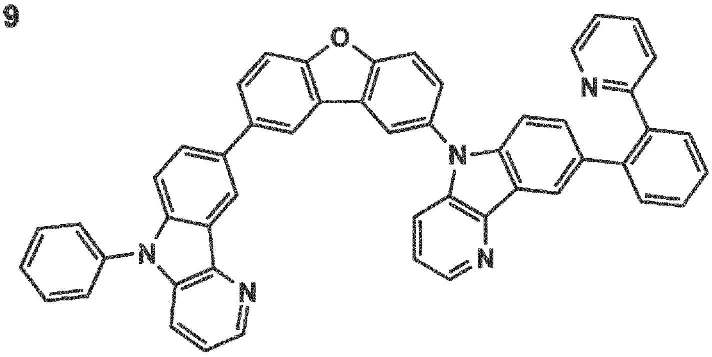

ET−10

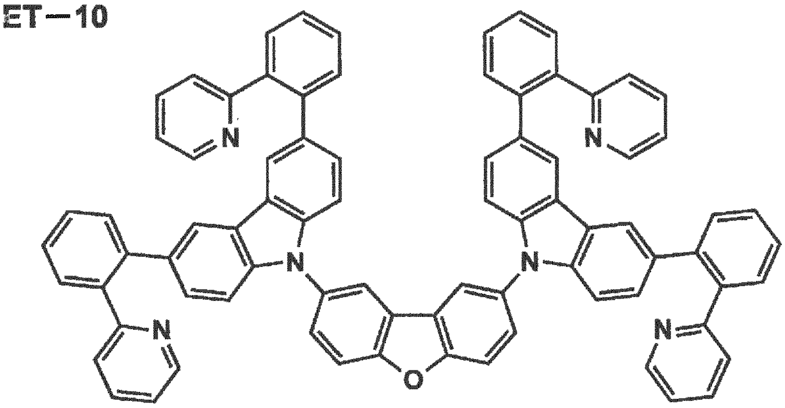

ET−11

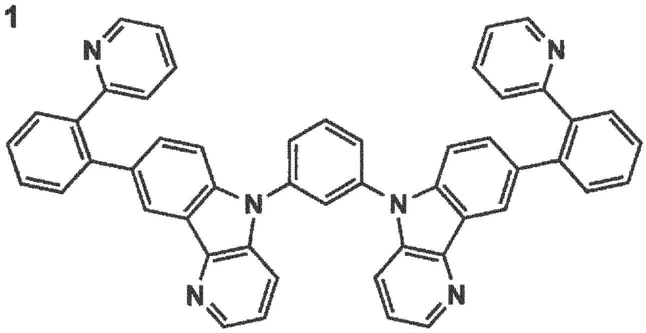

ET−12

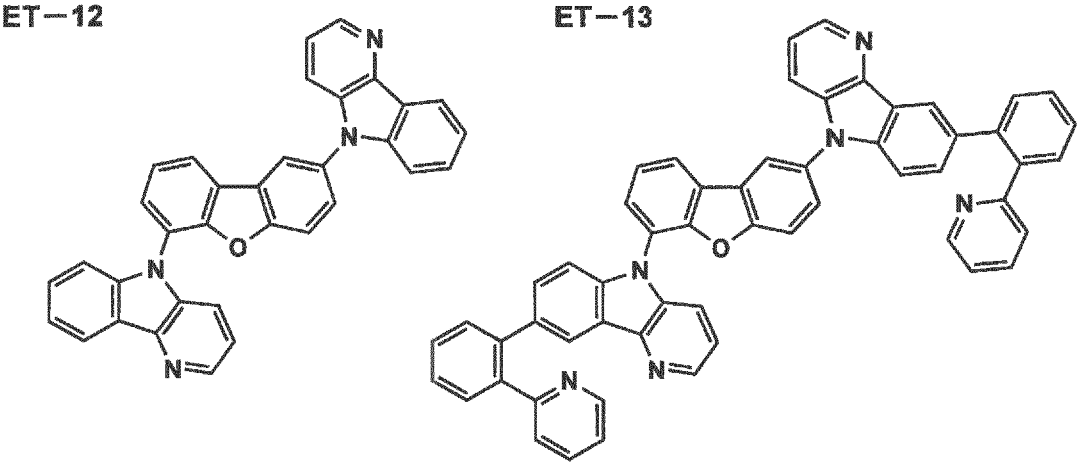

ET−13

ET−14

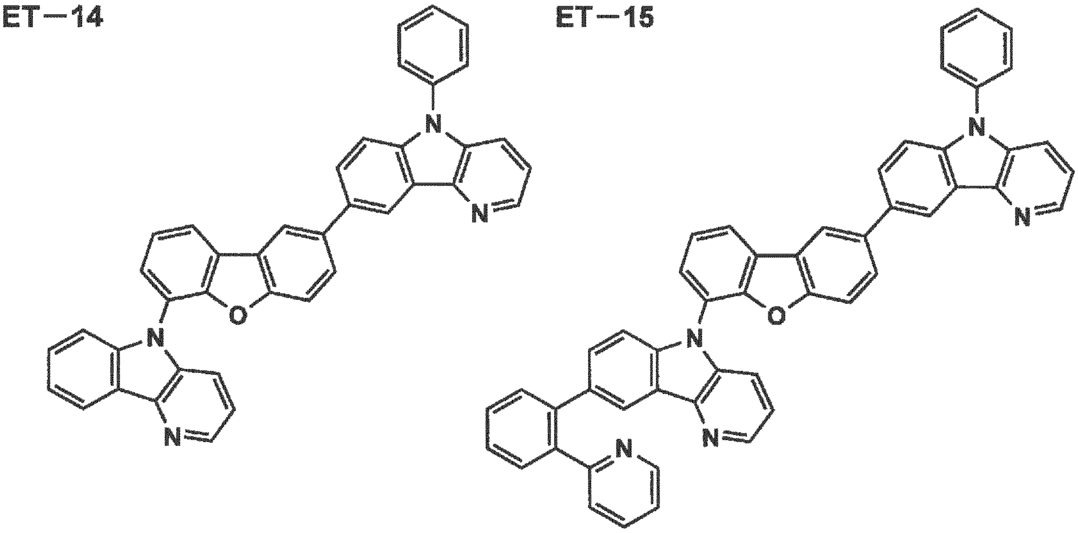

ET−15

ET-16

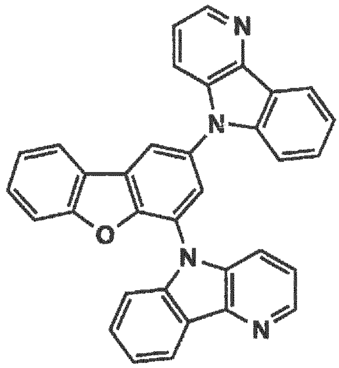

ET-17

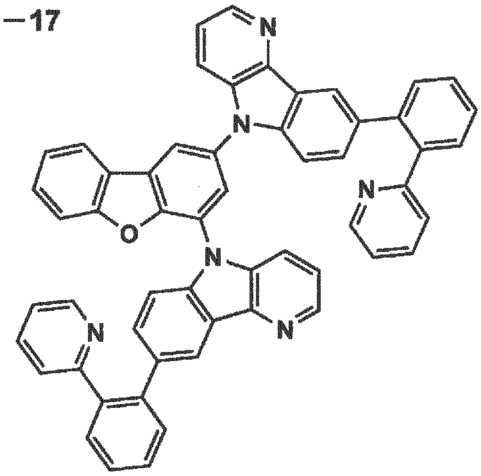

ET-18

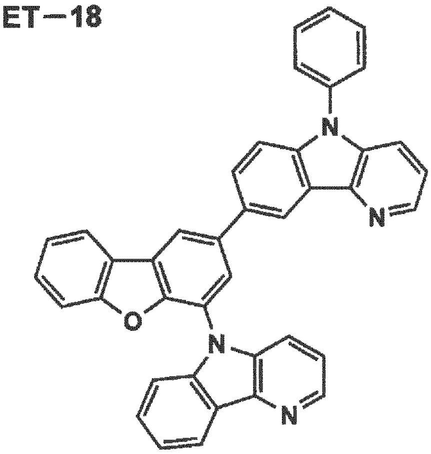

ET-19

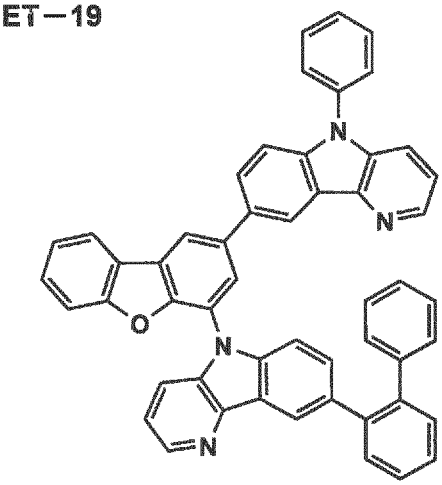

ET-20

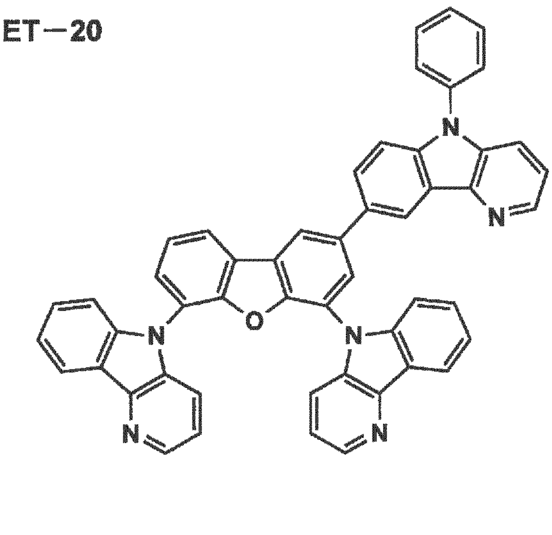

ET-21

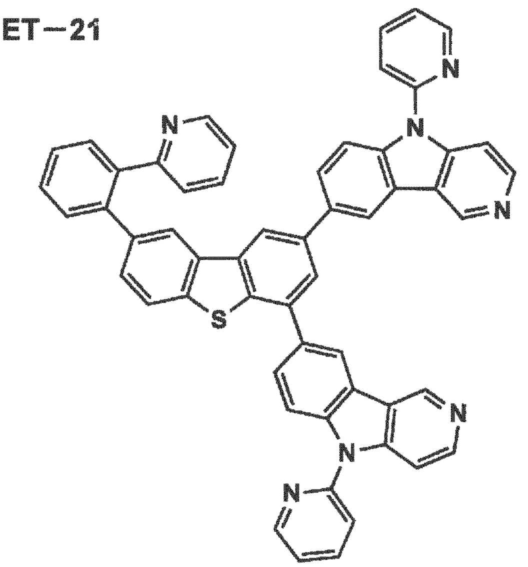

ET−22

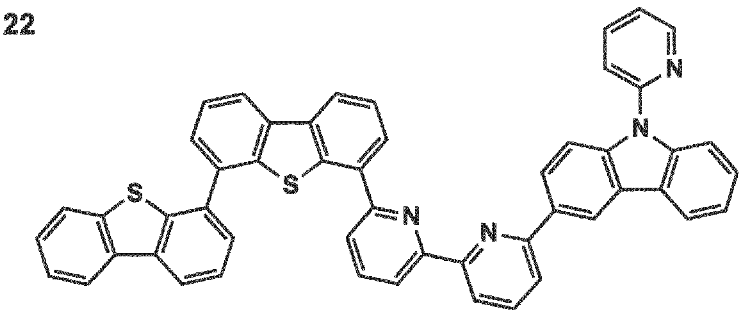

ET−23

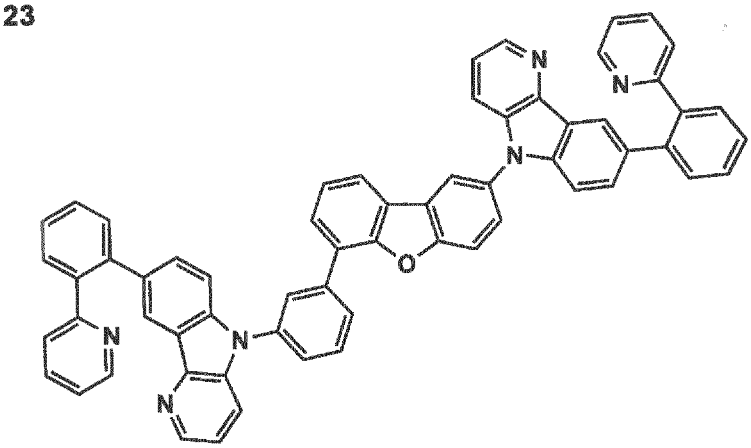

ET−24

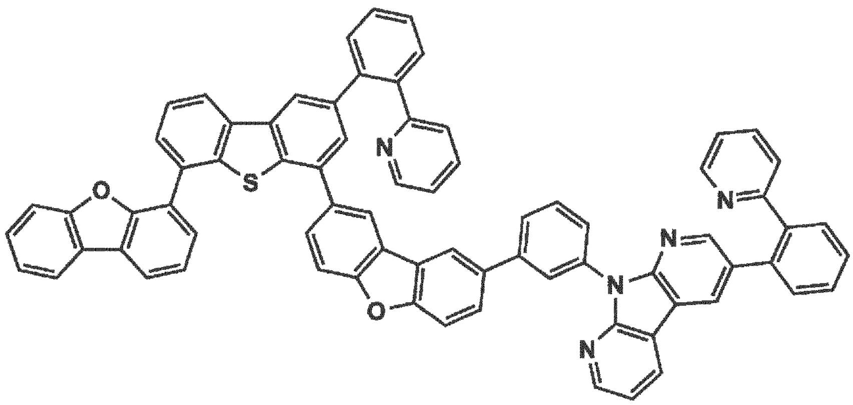

ET-25

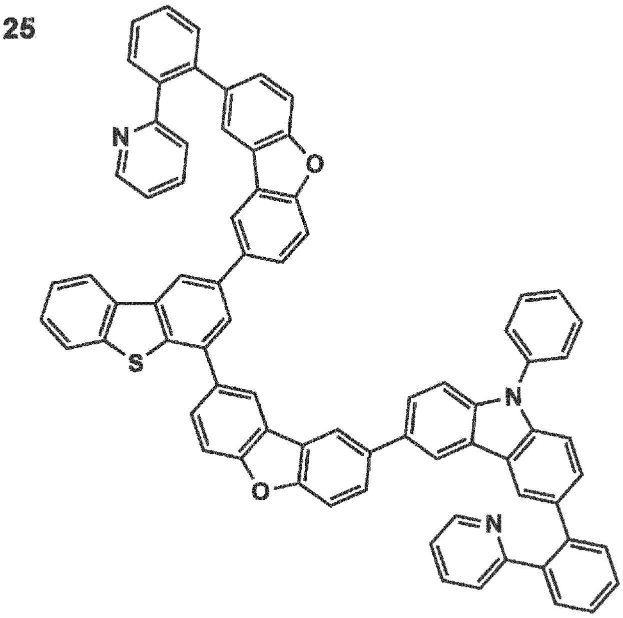

ET-26

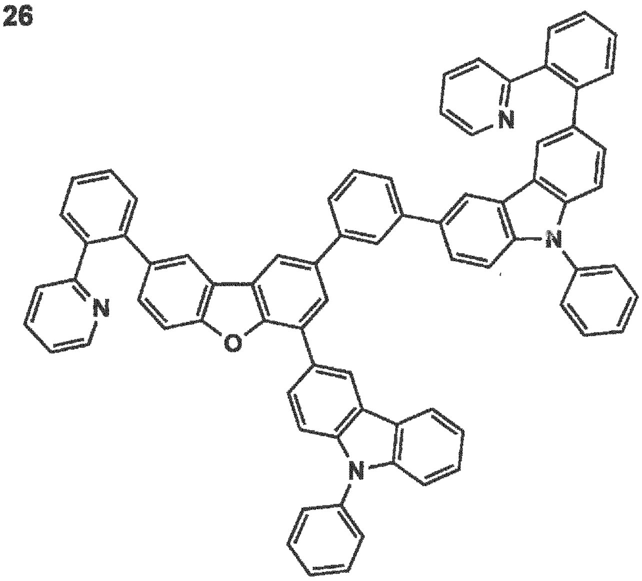

ET-27

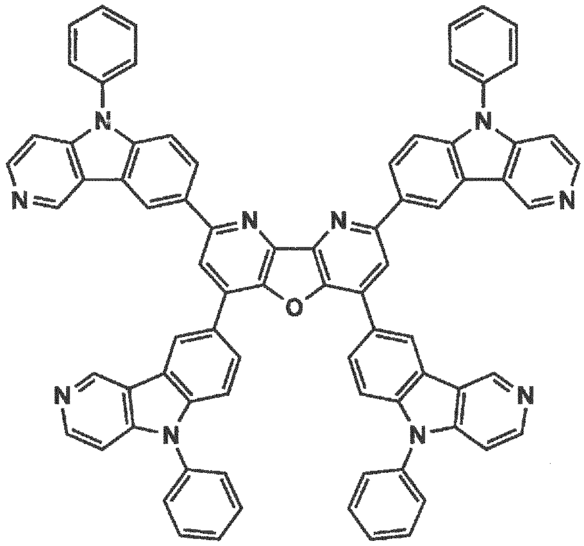

ET-28

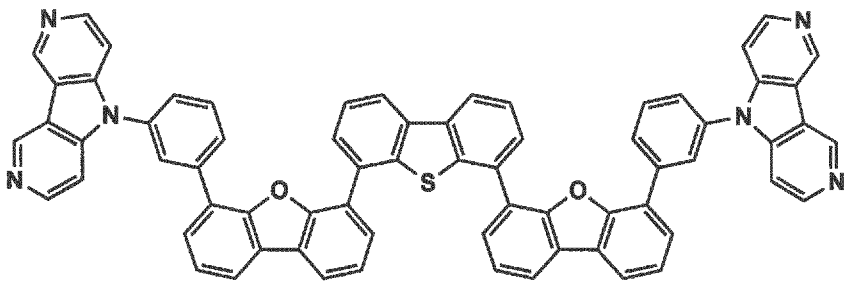

ET-29

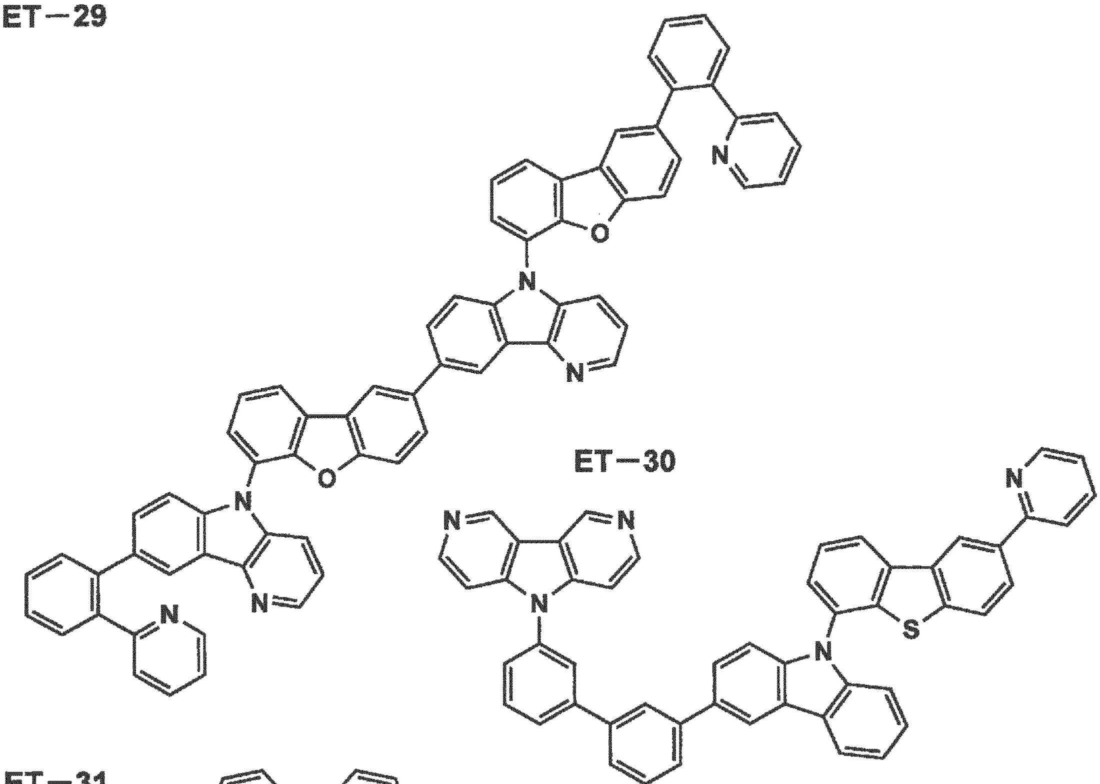

ET-30

ET-31

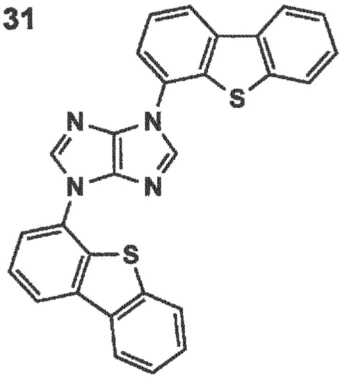

ET-32

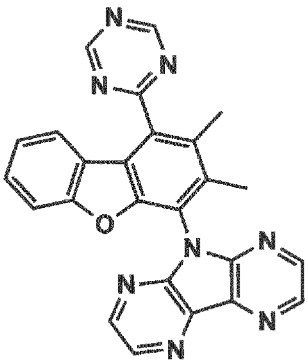

ET-33

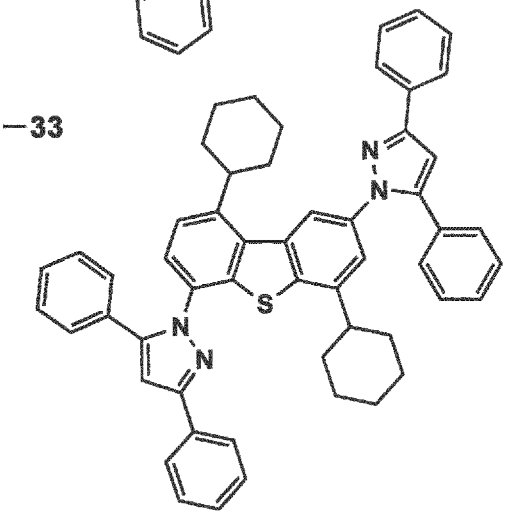

ET-34

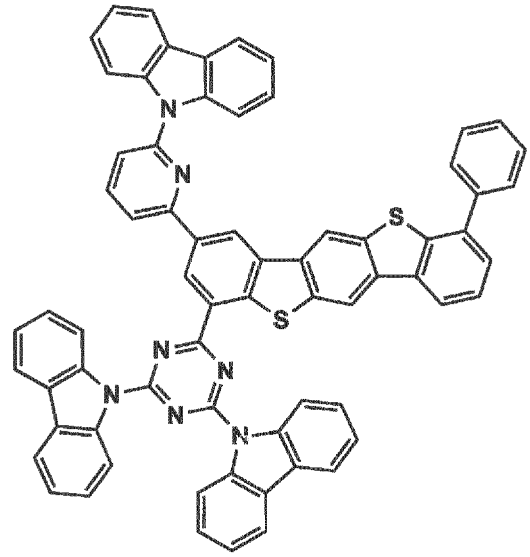

ET-35

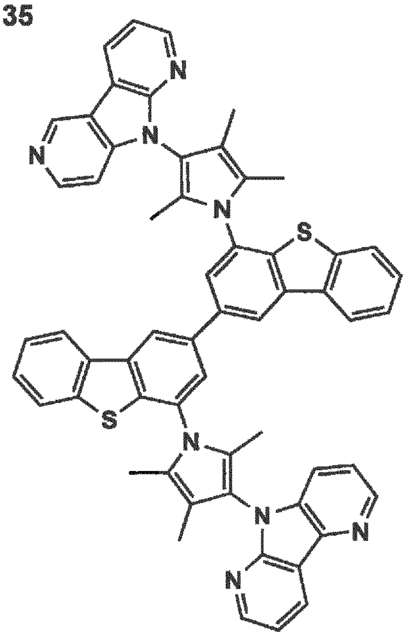

ET-36

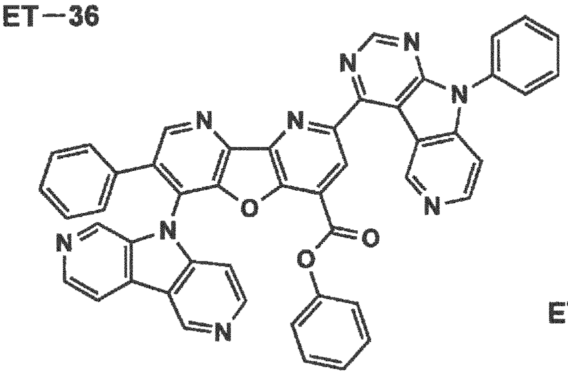

ET-37

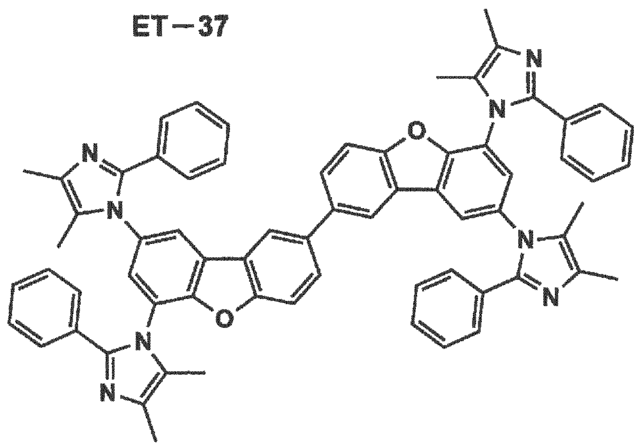

ET-38

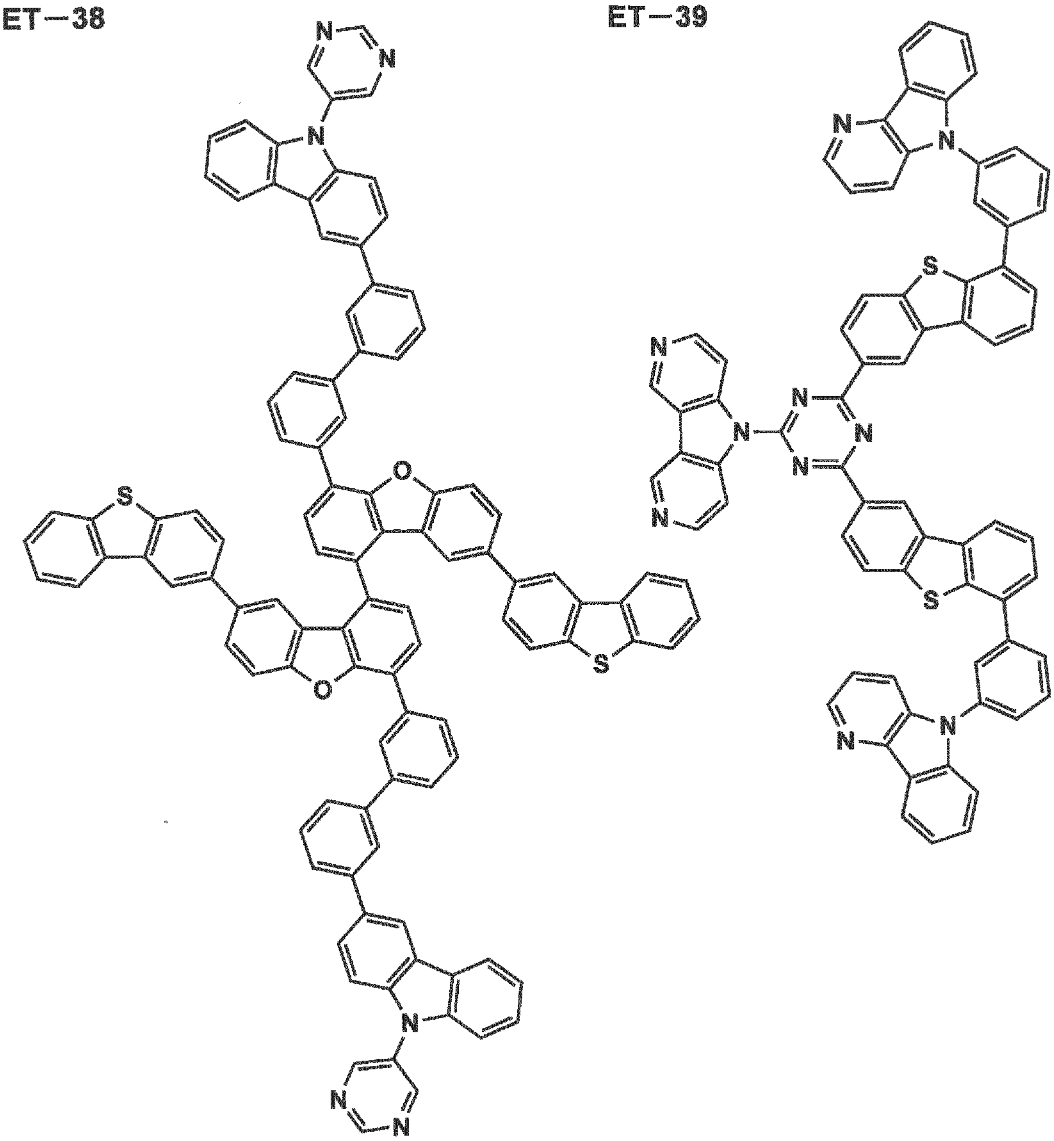

ET-39

ET-40

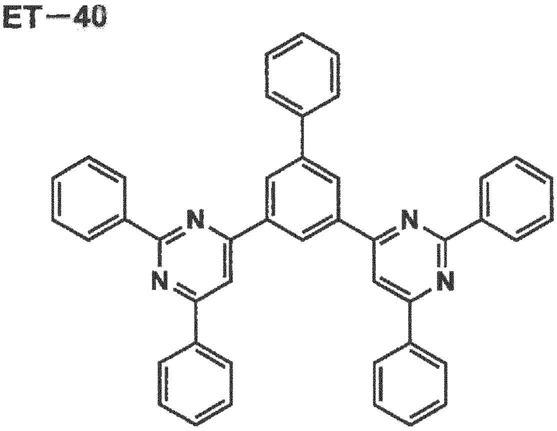

ET−41

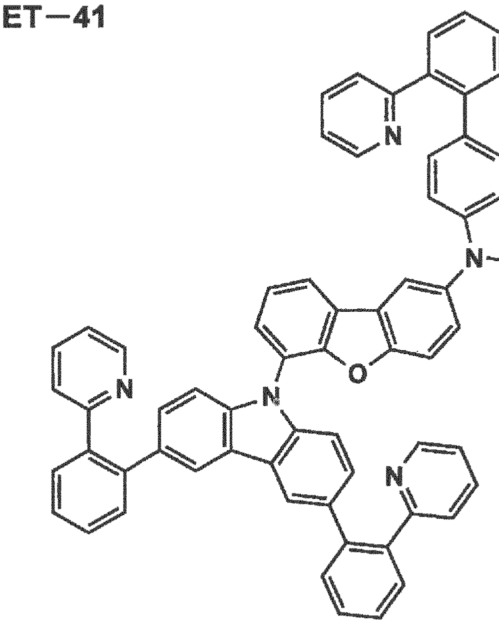

ET−42

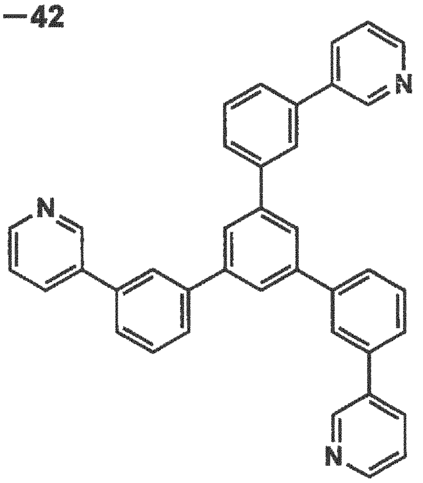

ET−43

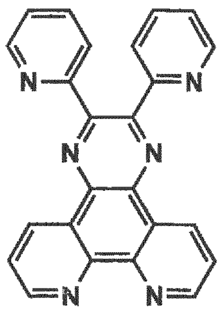

[Cathode]

An electrode material composing the cathode is exemplified by a low-work function metal (referred to as an "electron injecting metal"), low-work function alloy, low-work function electroconductive compound and a mixture of such a metal, alloy and compound. A work function of these materials is 4 eV or lower. Specific examples of the electrode material include sodium, sodium-potassium alloy, magnesium, lithium, a mixture of magnesium and copper, mixture of magnesium and silver, mixture of magnesium and aluminum, mixture of magnesium and indium, mixture of aluminum and aluminum oxide ($Al_2O_3$), indium, a mixture of lithium and aluminum, a rare earth element and the like.

In terms of electron injecting property and anti-oxidation property, a preferred material among the above-listed materials is a mixture of an electron injecting metal and a second metal that has a higher work function than that of the electron injecting metal and that is therefore stable, namely, a mixture of magnesium and silver, mixture of magnesium and aluminum, mixture of magnesium and indium, mixture of aluminum and aluminum oxide ($Al_2O_3$), mixtures of lithium and aluminum, aluminum and the like.

The cathode may be formed as a thin film using such an electrode material by vapor deposition, sputtering or the like. The sheet resistance of the cathode is preferably a few hundred Ω/□ or less, and the thickness of the cathode is preferably from 10 nm to 50 μm, and more preferably from 50 to 200 nm. It is preferable that either the anode or cathode is transparent or semi-transparent to transmit light and thereby improving luminance.

Further, the transparent or semi-transparent cathode may be formed by forming a film composed of the above metal and having a thickness of 1 to 20 nm followed by applying the electroconductive transparent material described later in the explanation of the anode of the present invention on this film. By this procedure, the element where a cathode

and anode are both transparent may be prepared.

[Injecting layer]

The injecting layer is provided if necessary. The injecting layer is categorized into an electron injecting layer (cathode buffer layer) and an electron hole injecting layer (anode buffer layer). The injecting layer may be provided between the anode and the light-emitting layer or between the anode and the electron hole transporting layer, and between the cathode and the light-emitting layer or between the cathode and the electron transporting layer.

The injecting layer is a layer provided between an electrode and an organic layer to lower driving voltage and improve luminance. The injecting layer is described in detail in Chapter II "Electrode material" of Part II of "The frontier of Organic EL element and its industrialization" (pages 123 to 166, published by NTS Inc., November 30, 1998).

The anode buffer layer (electron hole injecting layer) is also described in detail in Japanese Patent Application Laid-Open Publications Nos. Hei9-45479, Hei9-260062 and Hei8-288069, for example. Specific examples include a buffer layer composed of a phthalocyanine as typified by copper phthalocyanine; a buffer layer composed of a hexaazatriphenylene derivative such as disclosed in Japanese Patent Application Laid-Open Publications Nos. 2003-519432 and 2006-135145, for example; a buffer layer composed of an oxide as typified by vanadium oxide; a buffer layer composed of an amorphous carbon; a buffer layer composed of an electroconductive polymer such as polyaniline emeraldine or polythiophene; and a layer composed of an ortho-metalated complex as typified by an iridium complex.

The cathode buffer layer (electron injecting layer) is also described in detail in Japanese Patent Application Laid-Open Publications Nos. Hei6-325871, Hei9-17574 and Hei10-74586, for example. Specific examples include a buffer layer composed of a metal as typified by strontium and aluminum; a buffer layer composed of an alkali metal compound as typified by lithium fluoride and potassium fluoride; a buffer layer composed of an alkali earth metal compound as typified by magnesium fluoride and cesium fluoride; a buffer layer composed of an oxide as typified by aluminum oxide. The above anode and cathode buffer layers (electron hole and electron injecting layers) are preferably very thin, and the thickness of the respective layers is preferably from 0.1 nm to 5. 0 μm while the thickness is determined depending on types of material of the layers.

[Blocking layer: Electron hole blocking layer and Electron blocking layer]

The blocking layer is provided if necessary. Examples include electron hole blocking layers disclosed in Japanese Patent Application Laid-Open Publications Nos. Hei11-204258 and Hei11-204359, and page 237 of "The frontier of Organic EL element and its industrialization" (published by NTS Inc., November 30, 1998).

The electron hole blocking layer functions as an electron transporting layer in a broad sense and is composed of an electron hole blocking material which transports electrons while having significantly small electron hole-transporting property. The electron hole blocking layer transports electrons and blocks electron holes thereby enhancing recombining of electrons with electron holes.

The configuration of the above electron transporting layer may be used for the electron hole blocking layer.

The electron hole blocking layer composing the organic EL element of the present invention is preferably provided adjacent to the light-emitting layer.

The electron hole blocking layer preferably contains a carbazol derivative, carboline derivative or diazacarbazol derivative (the diazacarbazol derivative referred herein has the carboline ring where one carbon atom on the ring is substituted with a nitrogen atom) which are listed above as examples of the host.

In the case where multiple light-emitting layers each of which emits light of a different color from each other are used in the present invention, the light-emitting layer emitting light having the shortest peak wavelength is preferably provided nearest to the anode layer among the all of the light-emitting layers. In this case, it is preferable that the electron hole blocking layer is additionally provided between the above light-emitting layer emitting light having a shortest peak wavelength and a light-emitting layer that is provided the second nearest to the anode among the all light-emitting layers. Further, 50% by mass or more compounds contained in the electron hole blocking layer provided between the light-emitting layers nearest and the second nearest to the anode has an ionization potential of 0.3 eV or more with respect to the hosts in the light-emitting layer emitting light having the shortest peak wavelength.

The ionization potential is defined as an energy necessary for emitting an electron at a Highest Occupied Molecular Orbital (HOMO) energy level to a vacuum level. The ionization potential may be obtained as follows, for example.

(1) The ionization potential is obtained using Gaussian98 (see Gaussian98, Revision A.11.4, M.J.Frisch et al., Gaussian Inc. , Pittsburgh PA, 2002), which is a software for calculating molecular orbitals, with structural optimization with a keyword of B3LYP/6-31G*. The ionization potential is obtained as a value converted to eV unit. The thus-obtained value is useful because this value highly corresponds to an experimental value.

(2) The ionization potential is directly measured using a photoelectric spectroscopy. For example, Model AC-1, a low-energy electron spectroscopy device from RIKEN KEIKI Co. , Ltd. may be preferably used. Any known ultraviolet

photoelectron spectroscopy is also preferably used.

On the other hand, the electron blocking layer functions as an electron hole transporting layer in a broad sense and is composed of a material which transports electron holes while having significantly small electron-transporting property. The electron blocking layer transports electron holes and blocks electrons thereby enhancing recombining of electrons with electron holes.
The configuration of the below-described electron hole transporting layer may be used for the electron blocking layer.
The thicknesses of the electron hole blocking layer and electron transporting layer of the present invention are preferably from 3 to 100 nm, and more preferably from 5 to 30 nm.

[Electron hole transporting layer]

The electron hole transporting layer is composed of an electron hole transporting material. In a broad sense, the electron hole injecting layer and the electron blocking layer are categorized into the electron hole transporting layer. A single or multiple electron hole transporting layers may be used.
The electron hole transporting material may be any organic or inorganic compounds having electron hole-injecting, electron hole-transporting or electron-blocking property. Examples include triazole derivatives, oxadiazole derivatives, imidazole derivatives, polyarylalkane derivatives, pyrazoline derivatives, pyrazolone derivatives, phenylenediamine derivatives, arylamine derivatives, amino-substituted chalcone derivatives, oxazole derivatives, styrylanthracene derivatives, fluorenone derivatives, hydrazone derivatives, stilbene derivatives, silazane derivatives, aniline-based copolymers. Examples further include electroconductive polymers, particularly typified by thiophene polymers.
In addition, azatriphenylene derivatives such as disclosed in Japanese Patent Application Laid-open Publications Nos. 2003-519432 and 2006-135145 may also be used as the electron hole transporting material.
The electron hole transporting material may be the above-exemplified materials and preferably is porphyrins, tertiary aromatic amines and styrylamines. Tertiary aromatic amines are particularly preferable.
Specific examples of the tertiary aromatic amines and styrylamines include
N,N,N',N'-tetraphenyl-4,4'diaminophenyl;
N,N'-diphenyl-N,N'-bis(3-methylphenyl)-[1,1'-biphenyl]-4,4' -diamine (abbreviated as TPD);
2,2-bis(4-di-*p*-tolylaminophenyl)propane;
1,1-bis(4-di-*p*-tolylaminophenyl)cyclohexane;
N,N,N',N'-tetra-*p*-tolyl-4,4'-diaminobiphenyl;
1,1-bis(4-di-*p*-tolylaminophenyl)-4-phenylcyclohexane;
bis(4-dimethylamino-2-methylphenyl)phenylmethane;
bis(4-di-*p*-tolylaminophenyl)phenylmethane;
N,N'-diphenyl-N,N'-di(4-methoxyphenyl)-4,4'-diaminobiphenyl ; N,N,N',N'-tetraphenyl-4,4'-diaminodiphenylether; 4,4'-bis(diphenylamino)qaterphenyl;
N,N,N-tri(*p*-tolyl)amine;
4-(di-*p*-tolylamino)-4'-[4-(di-*p*-tolylamino)styryl]stilbene; 4-N,N-diphenylamino-(2-diphenylvinyl)benzene;
3-methoxy-4'-N,N-diphenlaminostilbene; N-phenylcarbazole.
In addition to the above, compounds containing two confused aromatic rings in the molecules thereof disclosed in US Patent 5,061,569 such as
4,4'-bis[N-(1-naphtyl)-N-phenylamino]biphenyl (abbreviated as NPD), and
4,4',4''-tris[N-(3-methylphenyl)-N-phenylamino]triphenylami ne (abbreviated as MTDATA), which is a starburst aromatic amine containing three triphenylamine units, disclosed in Japanese Patent Application Laid-open Publication No. Hei4-308688 may also be given as examples.
Further, polymers where the above-exemplified materials are introduced in its polymer chain or polymers where the above-exemplified materials exist as main chains may also be used.
Inorganic compounds exemplified by p-type Si and p-type SiC may be used as the electron hole injecting material or an electron hole transporting material.
In addition, so-called p-type electron hole transporting materials such as disclosed in Japanese Patent Application Laid-open Publication No. Hei11-251067 and J. Huang et al., (2002) Applied Physics Letters, 80, p. 139 may be used and are preferable for the present invention because these p-type materials provide a highly efficient light-emitting element.
The above-exemplified materials are used to form the electron hole transporting layer as a thin layer by any known methods such as printing including vacuum deposition, spin coating, casting and ink jet printing or LB method.
The thickness of the electron hole transporting layer is normally from 5 nm to 5 $\mu$m, and preferably from 5 to 200 nm, but not particularly limited thereto. The electron hole transporting layer may be in a single-layered structure

composed of one, or two or more materials exemplified above.

The electron hole transporting layer that is doped with impurity(ies) to have high p character may be used. Examples are disclosed in Japanese Patent Application Laid-open Publications Nos. Hei4-297076, 2000-196140 and 2001-102175, and J. Appl. Phys., 95, 5773 (2004), for example.

In the present invention, the electron hole transporting layer having high p character is preferably used because such a transporting layer achieves an element that consumes lower power.

[Anode]

An electrode material used for the anode composing the organic EL element of the present invention is preferably a high-work function metal, high-work function alloy, high-work function electroconductive compound and a mixed material of such a metal, alloy and compound. Work functions of these material are 4 eV or more. Specific examples of the electrode material include metals such as Au, and transparent electroconductive materials composed of CuI, indium tin oxide (ITO), $SnO_2$, ZnO or the like.

In addition, non-crystalline materials employable in forming a transparent electroconductive layer such as $In_2O_3$-ZnO (IDIXO) may also be used. The anode may be obtained by forming a thin layer with the electrode material by vacuum deposition or sputtering followed by patterning by photolithography according to a desired pattern. In the case where precise patterning is not strictly required (a precision of around 100 m or more), the pattern may be formed using a mask in an appropriate form during vacuum deposition or sputtering.

To apply a material which is applicable like an organic electroconductive compound, wet methods such as printings and coatings may be used. In the case of light extraction from the side of the anode composed of the above-exemplified compound(s), the transmittance is preferably 10% or more. The sheet resistance of the anode is preferably a few hundreds Ω/□ or less. The thickness of the anode is normally from 10 to 1000 nm, and preferably from 10 to 200 nm while depending on types of material of the anode.

[Supporting substrate]

The supporting substrate employable in the organic EL element of the present invention (hereinafter also referred to as the "substrate", "base" or "supporting body") maybe composed of any materials such as glass and plastics without particular limitation, and may be transparent or opaque. In the case of light extraction from the side of the supporting substrate, the supporting substrate is preferably transparent. Examples of a preferable transparent substrate include glass substrates, quartz substrates, transparent resin films and the like. A particularly preferable transparent substrate is a flexible resin film capable of providing flexibility with the organic EL element.

A resin composing the resin film is exemplified by polyesters such as polyethylene terephthalate (PET) and polyethylene naphthalate (PEN); polyethylene; polypropylene; cellophane; cellulose esters or derivatives thereof such as cellulose diacetate, cellulose triacetate (TAC), cellulose acetate butyrate, cellulose acetate propionate (CAP), cellulose acetate phthalate and cellulose nitrate; polyvinylidene chloride; polyvinyl alcohol; polyethylene vinyl alcohol; syndiotactic polystyrene; poly carbonate; norbornene resins; polymethylpentene; polyetherketone; polyimide; polyethersulfone (PES); polyphenylene sulfide; polysulfones, polyetherimides; polyetherketoneimide; polyamide; fluororesins, nylons, polymethylmethacrylate; acrylic compounds or polyarylates, and cycloolefin resins such as ARTON® (from JSR Corporation) and APEL™ (from Mitsui Chemicals, Inc.).

On the surface of the resin film, a coating film composed of an inorganic or organic compound or a hybrid coating film of an inorganic and organic compounds may be formed as a barrier layer. Such a coating film is preferably a barrier layer having a water vapor transmission rate at 25$\pm$0.5 °C and 90$\pm$2%RH of 0.01 g/ ($m^2$ ·24h) determined according to JIS K 7129-1992, and further preferably is a high barrier layer having an oxygen transmission rate of $1\times10^{-3}$ ml/($m^2$ ·24h·atm) or less determined according to JIS K 7126-1987 and a water vapor transmission rate of $1\times10^{-5}$ g/($m^2$·24h) or less.

Materials used in forming the barrier layer may be any materials capable of suppressing intrusion of matters that cause deterioration such as water, oxygen and the like. Examples of the materials include silicon oxide, silicon dioxide, silicon nitride and the like. To improve weakness of the barrier layer, a laminated structure constituted by an inorganic layer composed of the above inorganic material and an organic layer composed of an organic material is preferable. The order of the inorganic layer and the organic layer is not particularly limited. It is preferable that multiple inorganic and organic layers are stacked alternately.

The barrier layer may be formed by vacuum deposition, sputtering, reactive sputtering, molecular beam epitaxy, cluster ion beam, ion plating, plasma polymerization, atmospheric pressure plasma polymerization, plasma chemical vapor deposition (plasma CVD), laser CVD, heat CVD, coating and the like, but not specifically limited thereto. Specifically, atmospheric pressure plasma polymerization such as disclosed in Japanese Patent Application Laid-open Publication No. 2004-68143 is preferable.

An opaque supporting substrate may be, for example, a metal plate composed of aluminum, stainless or the like, opaque film, opaque resin substrate or a ceramic substrate, for example.
The external quantum efficiency in light emission of the organic EL element of the present invention at room temperature is preferably 1.0% or more, and more preferably 5.0% or more.
The external quantum efficiency (%) is determined by the equation:

the external quantum efficiency (%) = (the number of photons emitted from the organic EL element per the number of electrons flowed into the organic EL element) × 100

A hue modifying filter such as a color filter, or a color converting filter which converts a color of light emitted from an organic EL element into multiple colors may be additionally used in combination with the supporting substrate. In the case of using a color converting filter, λmax of light from the organic EL element is preferably 480 nm or less.

<<Method for preparing the organic EL element>>

As an exemplary method for preparing the organic EL element of the present invention, a method for preparing the organic EL element constituted of the anode, anode buffer layer (electron hole injecting layer), electron hole transporting layer, light-emitting layer, electron hole blocking layer, electron transporting layer, cathode buffer layer (electron injecting layer), cathode in this order is described.
First, on the substrate adequately selected, a thin layer having a thickness of 10 to 200 nm with an adequate electrode material such as the material for forming the anode is formed as the anode.
Then, on this anode, the electron hole injecting layer, electron hole transporting layer, light-emitting layer, electron hole blocking layer, electron transporting layer and cathode buffer layer, all of which are organic functional layers (also referred to as "organic layers"), are formed as thin layers so as to be stacked in this order with the organic compounds for forming the above respective organic layers.
Each of the above thin layers may be formed by vacuum deposition, a wet process or the like.
A wet process includes spin coating, casting, die coating, blade coating, roll coating, ink jet coating, printing, spray coating, curtain coating, LB method and the like. Methods suitable for roll-to-roll processing such as die coating, roll coating, ink jet coating and spray coating are preferable because these methods can provide a thin layer with fineness with high productivity. The respective layers may be formed by different methods from each other.
Examples of solvents dissolving or dispersing materials for the above respective organic functional layers therein include ketones such as methylethylketone and cyclohexanone, fatty acid esters such as ethyl acetate, halogenated hydrocarbons such as dichlorobenzene, aromatic hydrocarbons such as toluene, xylene, mesitylene, cyclohexylbenzene, aliphatic hydrocarbons such as cyclohexane, decaline and dodecane, organic solvents such as dimethylformamide (DMF) and dimethylsulfoxide (DMSO).
Methods for dispersing the materials include ultrasonic dispersion, dispersion using high shearing force, dispersion using media and the like.
After the respective layers are stacked, on the top layer among these layers, a thin layer that has a thickness of 1 μm or less, preferably from 50 to 200 nm and that is composed of the material for the cathode is formed as the cathode. The intended organic EL element is thus prepared.
Here, the above order may be reverse, that is, the layers may be stacked in order of the cathode, cathode buffer layer, electron transporting layer, electron hole blocking layer, light-emitting layer, electron hole transporting layer, electron hole injecting layer and anode.
To make the thus-prepared organic EL element emit light, in the case of using direct voltage, the direct voltage to be applied has a voltage of around 2 to 40 V determining the anode as a positive electrode and the cathode as a negative electrode. Alternating voltage may also be used and may have any waveform.
The organic EL element of the present invention is preferably prepared by forming the above layers from the electron hole injecting layer to the cathode in a single vacuuming. However, the vacuuming may be intermitted and replaced by different methods for forming layers in midstream of the vacuuming; in this case, processing by any different method is preferably conducted under dry inert gas atmosphere.

«Sealing»

Sealing applicable to the present invention may be conducted by a method for bonding a sealing portion to the

electrodes and supporting substrate with an adhesive, for example.

The sealing portion may be a concave plate or flat plate so long as the sealing portion covers a display area of the organic EL element. Transparency and insulating performance are not particularly limited.

Specific examples include a composite of a glass plate, polymer plate and a film, and a composite of a metal plate and film. The glass plate may be composed of soda-lime glass, barium-strontium glass, lead glass, aluminosilicate glass, borosilicate glass, barium borosilicate glass or quartz, for example.

The polymer plate may be composed of polycarbonate, acrylic compounds, polyethylene terephthalate, polyether sulfide or polysulfones, for example.

The metal plate may be composed of any one or more metals selected from the group including stainless, iron, copper, aluminum, magnesium, nickel, zinc, chrome, titanium, molybdenum, silicon, germanium and tantalum, or an alloy thereof.

In the present invention, a polymer film and a metal film are preferably used because these films provide a thin organic EL element.

Preferably, the polymer film has an oxygen transmission rate of $1\times10^{-3}$ ml/ ($m^2$·24h·atm) or less determined according to JIS K 7126-1987 and a water vapor transmission rate at 25±0.5 °C and 90±2%RH of $1\times10^{-3}$ g/($m^2$-24h) or less determined according to JIS K 7129-1992.

The sealing portion may be made concave by sandblasting and chemical etching, for example.

The adhesive may be exemplified by a light curing or heat curing adhesives containing a reactive vinyl group of an acrylic acid-based oligomer and methacrylic acid-based oligomer, moisture curing adhesives such as 2-cyanoacrylate, and heat and chemical curing adhesives (mixture of two types of adhesive). In addition, hot-melt polyamides, hot-melt polyesters, hot-melt polyolefins, cationic UV curing epoxy resin adhesives may also be given as examples.

To prevent the organic EL element from being deteriorated by heat, preferable adhesives are curable at a temperature ranging from room temperature to 80 °C. In the adhesive, a desiccant maybe dispersed. Applying of the adhesive to sealing area may be conducted using a commercially available dispenser or conducted by printing such as screen printing.

It is also preferable to form a layer as a sealing membrane containing an inorganic or organic compound. The sealing membrane is formed so as to cover the electrode which sandwiches the organic layers with the supporting substrate and the organic layers and so as to contact to the supporting substrate. Materials used for the sealing membrane may be any materials capable of suppressing intrusion of matters that cause deterioration such as water, oxygen and the like. Examples of the materials include silicon oxide, silicon dioxide, silicon nitride and the like.

To improve weakness of the sealing membrane, the sealing membrane preferably has a laminated structure constituted of the inorganic layer composed of the above inorganic material (s) and an organic layer composed of organic material(s). The sealing membrane may be formed by vacuum deposition, sputtering, reactive sputtering, molecular beam epitaxy, cluster ion beam, ion plating, plasma polymerization, atmospheric pressure plasma polymerization, plasma CVD, laser CVD, heat CVD or coating, but not specifically limited thereto.

Between the sealing portion and a display area of the organic EL element, gas or liquid layer may be provided. Inert gas such as nitrogen and argon or inert liquid such as fluorohydrocarbon and silicon oil are preferably provided between the sealing portion and the display area by injection. Vacuum may also be employable. Also a hygroscopic compound may be placed in the gas or liquid layer.

The hygroscopic compound may be exemplified by metal oxides such as sodium oxide, potassium oxide, calcium oxide, barium oxide, magnesium oxide, aluminum oxide; sulfates such as sodium sulfate, calcium sulfate, magnesium sulfate, cobalt sulfate; metallic halides such as calcium chloride, magnesium chloride, cesium fluoride, tantalum fluoride, cerium bromide, magnesium bromide, barium iodide and magnesium iodide; perchloric acids such as barium perchlorate and magnesium perchlorate. As for sulfates, metallic halides and perchloric acids, anhydrous salts thereof are preferably used.

«Protective film and protective plate»

A protective film or protective plate may be provided on the sealing membrane or sealing film both of which are provided to sandwich the organic layers with the supporting substrate in order to improve mechanical strength of the organic EL element. It is preferable to provide the protective film of protective plate especially in the case of providing the sealing membrane because the sealing membrane is not so mechanically strong. Materials for the protective film or protective plate may be exemplified by a composite of glass plate, polymer plate and film and a composite of metal plate and film, like the materials for sealing. To achieve light weight and thinness, polymer film is preferable.

<<Light Extraction>>

In an organic EL element, it is generally understood that light emission occurs within a layer having a refractive

index of around 1.7 to 2.1 which is higher than that of air, and only around 15 to 20% of the light emitted from the light-emitting layer is extracted. The reasons are that light incident on the interface between a transparent substrate and air at θ° larger than an optimum angle is totally reflected and thus cannot be extracted to outside of the element and that light is totally reflected between a transparent electrode or light-emitting layer and a transparent substrate, and the light is guided through the transparent electrode or light-emitting layer resulted in light emission to the lateral sides of the element.

Methods for achieving higher efficiency of light extraction have been proposed. Such methods include a method for preventing total reflection at the interface of the transparent substrate and air by forming irregularities on the surface of the transparent substrate (US Patent 4,774,435), a method for improving the efficiency by using a light-harvesting substrate (Japanese Patent Laid-Open Publication No. Sho63-314795), a method for forming a reflective face on lateral sides of an element (Japanese Patent Laid-Open Publication No. Hei1-220394), a method for providing, between a substrate and a light-emitting portion, a reflection-preventing layer as a smoothing layer having a refractive index intermediate in value between the substrate and the light-emitting portion (Japanese Patent Laid-Open Publication No. Sho62-172691), a method for providing a smoothing layer having a refractive index smaller than that of a substrate between the substrate and a light-emitting portion (Japanese Patent Laid-Open Publication No. 2001-202827) and a method for providing a diffracting grating at an interface between any two of a substrate, between a transparent electrode layer and light-emitting layer, or between a substrate and the outside (Japanese Patent Laid-Open Publication No. Hei11-283751).

In the present invention, the above methods may be additionally used in forming the organic EL element of the present invention. Preferable methods are the method for providing a smoothing layer having a refractive index lower than that of a substrate between the substrate and a light-emitting portion, and the method for providing a diffracting grating at an interface between any two of a substrate, between a transparent electrode layer and light-emitting layer, or between a substrate and the outside.

In the present invention, combinations of the above methods achieve the element having higher luminance and higher strength.

The lower refractive index layer having a thickness longer than a light wavelength provides higher efficiency of light extraction from a transparent substrate.

The low refractive index layer may be composed of aero gel, porous silica, magnesium fluoride, fluorine-containing polymer and the like. The low refractive index of the low refractive index layer is preferably around 1.5 or less considering that a refractive index of a transparent substrate is generally from 1.5 to 1.7. More preferably, the low refractive index of the low refractive index layer 1.35 or less.

The thickness of the low refractive index layer has a thickness of preferably two-fold of wavelength of light in the layer or more, because if the thickness is around the wavelength of light in the layer, evanescent wave enters in the substrate resulted in decreasing effects of the low refractive index layer.

The method for providing a diffracting grating at any interface where total reflection occurs or in any layer can highly improve efficiency of light extraction. A diffraction grating functions to turn light to a specific direction other than refraction by Bragg diffraction such as a primary diffraction or secondary diffraction. This method therefore achieves extraction of the emitted light that is caught in the element due to the total reflection and the like extract light by diffraction with the diffracting grating which is provided at any interface or in any layer, for example, in a transparent substrate or transparent electrode.

The diffracting grating to be provided is preferably has two-dimensional periodic refractive index distribution. This is because light is emitted in any directions randomly in the light-emitting layer, and thus a general one-dimensional diffracting grating having a periodic refractive index in a specific direction only diffracts light in a specific direction, resulted in little improvement of efficiency of light extraction. The diffracting grating having two-dimensional diffractive index distribution can diffract light in any directions and thus highly improve the efficiency of light extraction.

The diffracting grating may be provided at any interface or any layer, and preferably provided near a light-emitting layer where light is emitted.

A pitch of the diffracting grating is preferably one-third to one-second of wavelength of light in the layer. The diffracting grating preferably has in a two-dimensionally repeated pattern such as square lattice, triangle lattice and honeycomb lattice.

<<Light condensing sheet>>

In the organic EL element of the present invention, on a side for light extraction of the substrate, micro lens array structure may be formed or a light condensing sheet may be provided to condense light in a specific direction, for example, in a front direction with respect to a light emitting face of the element to increase luminance in a specific direction.

An exemplary structure of micro lens array is as follows: on the light extraction side of the substrate, quadrangular pyramids with a vertex angle of 90°, 30 μm on a side are two-dimensionally arranged. Each side of the quadrangular

pyramids has a length of preferably from 10 to 100 μm. If each side is shorter than this range, coloring occurs; if each side is too long, the element is undesirably thick.

The light condensing sheet may be an available sheet used in an LED backlight of a liquid crystal display device, for example. Examples of such a sheet include Brightness Enhancement Film (BEF) from Sumitomo 3M Ltd, which is a prism sheet.

The prism sheet may have a structure where the substrate thereof is paved with triangular prisms having a vertex angle of 90° at a pitch of 50μm between the vertexes. The vertexes of the triangular prisms may be roundish, or the pitch may be randomly varied. Other structures may also be used.

To control emission angle of light from the light-emitting element, a light diffusion plate or light diffusion film may be used in combination with the light condensing sheet. Examples include LIGHT-UP™ from KIMOTO Co., Ltd., for example.

<<Use application>>

The organic EL element of the present invention may be used for display devices, displays and various types of light source. Examples of the light source include a lighting device such as a light for home use or in-car use; a backlight of a clock or liquid crystal device; billboard; traffic light; light source of an optical storage medium, electrophotographic copier, optical communication processing device and light sensor, but not limited thereto. Specifically, using the organic EL element for a backlight of a liquid crystal display device or light source of a lighting device is particularly effective.

In the organic EL element of the present invention, each layer may be formed by patterning according to a pattern using a metal mask or by patterning using ink jet printing, for example. The patterning may be conducted only to the electrodes, the electrodes and light-emitting layer or all of the layer of the element. The element may be manufactured by a commonly known method.

A color of light emitted from the organic EL element of the present invention or the compound of the present invention corresponds to a color determined by applying values measured with CS-1000 (a spectroradiometer light measurement instrument from Konica Minolta, Inc.) to the CIE chromaticity coordinate in Fig. 4.16 on page 108 of Handbook of Color Science, NewEdition (edited by the Color science association of Japan, published from University of Tokyo Press, 1985).

The organic EL element of the present invention is preferably a white light-emitting element. "White" light in the present invention has a chromaticity of $X=0.33\pm0.07$ and $Y=0.33\pm0.1$ in the CIE1931 chromaticity coordinate system at 1000 cd/$m^2$ when a front luminance of the white light is measured in a viewing angle of 2° by the above method.

<<Display device>>

The display device of the present invention will be described. The display device of the present invention has the organic EL element of the present invention.

The display device of the present invention may be either a monochrome display device or multicolored display device. The case of multicolored display device is described here. For the multicolored display device, only the light-emitting layer is formed using a shadow mask, and the other layers may be formed by deposition, casting, spin coating, ink jet printing or printing on the entire upper surface of the previously-formed layer or so that the light emitting layer is embedded therein.

When patterning is conducted only to the light-emitting layer, the patterning is conducted preferably by deposition, ink jet printing, spin coating or printing, but not limited thereto.

A configuration of the organic EL element used in the display device of the present invention is selectable from the above-described configurations of the organic EL element as desired.

A method for preparing the organic EL element used for the display device of the present invention is such as described in the above exemplary method for preparing the organic EL element.

When a direct voltage of around 2 to 40 V is applied to the thus-manufactured multicolored display device determining the anode as a positive electrode and the cathode as a negative electrode, light emission occurs. In the case where the anode and cathode have polarity the reverse of the above, voltage application occurs no current flow, and thus no light is emitted. In the case where alternating voltage is used, light is emitted only when the anode is a positive electrode and the cathode is a negative electrode. Alternating voltage may have any waveform.

The multicolored display device of the present invention may be used as a display device, display and various light sources. In a display device and display, using three types of organic EL element which emits blue, red or green light achieves a full-color display.

The display device and display may be exemplified by a television, personal computer, mobile device, audio-video device, display for teletext broadcasting, information display in a car and the like. Especially, the display device

and display may be used as an image projecting device or a display device for reproducing still images or videos (i.e. , display) . The display for reproducing videos may be driven either by a passive matrix or active matrix method.

The light source may be exemplified by a backlight of a clock or liquid crystal; billboard; traffic light; light source of an optical storage medium, electrophotographic copier, optical communication processing device and light sensor, but not limited thereto.

An example of the display device having the organic EL element of the present invention will be described with reference to the drawings.

Fig. 1 is a schematic diagram of an example of the display device including the organic EL element. This is a schematic diagram of a display for displaying an image on the basis of image information by light emission of organic EL elements such as a display of a mobile phone and the like.

A display 1 is composed of a display unit A composed of multiple pixels and a control unit B executing image scanning on the display unit A on the basis of image information.

The control unit B is electrically connected to the display unit A. The control unit B transmits scanning signals and image data signals on the basis of input image information to the respective pixels of the display unit A to make the display unit A display an image based on the image information.

Fig. 2 is a schematic diagram of the display unit A.

The display unit A has a line part including multiple scanning lines and data lines, the multiple pixels 3 and so forth. Main elements of the display unit A will be described below.

Fig. 2 illustrates the case where the light L emitted from the pixel 3 is extracted to the direction indicated by the white arrow (downward).

The multiple scanning lines 5 and multiple data lines 6 in the line part are both composed of electroconductive materials and intersect at the right angle with each other to make a grid. The multiple scanning lines 5 and multiple data lines 6 contact the pixels 3 at their intersections (details are not illustrated).

When the scanning signal is applied to each of the pixels 3, the pixel 3 then receive the image data signal from the data line 6. Thereafter, the pixel 3 emits light according to the received image data signal.

A full-color display is achieved by appropriately apposing pixels emitting light in a red wavelength range, pixels emitting light in a green wavelength range and pixels emitting light in a blue wavelength range on a single substrate.

Next, processes of light emission in the pixels 3 is described.

Fig. 3 is a schematic diagram of an example of a line layout in the pixel 3.

The pixel 3 has the organic EL element 10, a switching transistor 11, a driving transistor 12, a capacitor 13 and so forth. A full-color display is achieved by appropriately apposing the pixels 3 each of which has the organic EL element emitting red, green or blue light on a single substrate.

The image data signal is applied to the drain of the switching transistor 11 via the data line 6 from the control unit B. Then, upon an application of the scanning signal to the date of the switching transistor 11 via the scanning line 5 from the control unit 5, the switching transistor 11 is driven and the image data signal applied to the drain is transmitted to the capacitor 13 and the gate of the driving transistor 12.

Upon the transmission of the capacitor 13, the capacitor 13 is electrically charged according to an electrical potential of the transmitted image data signal, and the driving transistor 12 is then driven. The drain of the driving transistor 12 is connected to a power-supply line 7, and the source of the driving transistor 11 is connected to the electrode of the organic EL element 10. Current is applied to the organic EL element 10 via the power-supply line 7 according to an electrical potential of the image data signal transmitted to the gate.

When the scanning signal pass on to the next scanning line 5 in sequential scanning of the control unit 5, the driving of the switching transistor 11 is stopped. Even though the driving of the switching transistor 11 is stopped, the capacitor 13 keeps the electrical potential charged according to the image data signal. Thus, the driving transistor 12 is continuously driven, and the organic EL element 10 emits light until the next scanning signal is applied to the gate. When the next scanning signal is applied in the sequential scanning, the driving transistor 12 is driven according to an electrical potential of the image data signal transmitted along with the next scanning signal, and then the organic EL element 10 emits light.

As described above, the organic EL element 10 emits light by the configuration such that each of the organic EL element 10 of the pixel 3 is equipped with the switching transistor 11 and the driving transistor 12 both of which are active elements. This light emission method is called an active matrix method.

The light emission of the organic EL element 10 may be such as emission of light of multiple gradations on the basis of multiple-valued image data signals of multiple gradation electric potentials. Also light emission in a predetermined amount of luminance may be started or stopped according to a binary image data signal. The electrical potential of the capacitor 13 may be kept until the next scanning signal is applied or may be discharged just before the application of the next scanning signal.

The present invention may use not only the above active matrix method but also a passive matrix method which makes an organic EL element emit light according to a data signal only when the scanning signal is applied.

Fig. 4 is a schematic diagram of a display device using a passive matrix method.
As illustrated in Fig. 4, the multiple scanning lines 5 and multiple image data lines 6 sandwich the pixels 3 and make a grid.
When the scanning signal is applied to the scanning line 5, the pixel 3 that is connected to the scanning line 5 to which the scanning signal is applied emits light according to the image signal.
A passive matrix method does not employ active elements in pixels 3 and thus reduce manufacturing cost.

<<Lighting device>>

The lighting device of the present invention is described.
The lighting device of the present invention is characterized by including the organic EL element of the present invention.
The organic EL element used in the lighting device of the present invention may be the organic EL element of the present invention additionally having a resonator structure. The organic EL element having a resonator structure may applicable to a light source of an optical storage medium, light source of an electrophotographic copier, light source of an optical communication processing device and light source of a light sensor, but not limited thereto. Laser oscillation may also be used in the organic EL element used for the above-listed applications.
The organic EL element of the present invention may also be used in a lamp for illumination or light exposure, or a light for home use or in-car use.
The organic EL element of the present invention may be used as an organic EL element emitting white or substantially white light in a lighting device. To obtain white light, multiple colors of light from multiple light-emitting materials are mixed. A combination of the colors of light may be either a combination of peak wavelengths of the three primary colors, namely, red, green and blue, or a combination of peak wavelengths of two complimentary colors, namely, blue and yellow, blue green and orange, for example.
A combination of the light-emitting materials to obtain white light may be either a combination of multiple materials emitting multiple types of fluorescence or phosphorescence or a combination of a light-emitting material emitting fluorescence or phosphorescence and a dye material emitting light when excited by the fluorescence or phosphorescence emitted from the light-emitting material. In a white light-emitting organic EL element of the present invention, white light is obtained merely by mixing the light-emitting dopants.
The masks are used only in forming the light-emitting layer, electron hole transporting layer and electron transporting layer, for example. These layers are formed by simply placing the masks which allow patterning. As for the other layers, the patterning with the masks is not needed because the other layers are similarly formed on the entire upper surface of the previously-formed layer or so that the patterned layer is embedded therein. That is, for example, the electrode layer may be formed on the entire upper surface of the previously-formed layer by deposition, casting, spin coating, ink jet coating, printing or the like. Accordingly, productivity is improved.
Thus different from an organic EL device emitting white light by arraying multiple light-emitting elements in parallel, the element itself according to the above method emits white light.
The light-emitting material used in the light-emitting layer may be selected without particular limitation. For example, in the case of obtaining white light from a backlight of a liquid crystal display element, the light-emitting material may be selected from the metal complexes of the present invention, any known light-emitting compounds or combinations thereof so long as the material is suitable in terms of a wavelength region conform to color filter properties.

<<Example of Lighting device of the present invention>>

An example of the lighting device including the organic EL element of the present invention is described.
Fig. 5 is a schematic diagram of a lighting device 112. The organic EL element 101 of the present invention is covered by a glass cover 102 placed from above the organic EL element 101. Sealing with the glass cover 102 is preferably conducted in a glove box under nitrogen atmosphere (high-purity nitrogen atmosphere with a purity of 99.999% or more) in order that the organic EL element 101 does not contact air.
Fig. 6 is a cross-sectional view of the lighting device 112. In Fig. 6, 105 denotes the anode, 106 denotes the organic EL layer, 107 denotes a glass substrate with a transparent electrode. The inner space formed by the glass cover 102 and a transparent supporting substrate 110 is filled with nitrogen gas 108. A water refilling material 109 is placed on the upper surface of the glass cover 102 inside the glass cover 102.
The glass cover 102 is used to cover non-light emitting sides of the organic EL element 101 of the present invention, and the transparent supporting substrate 110 made of glass having a thickness of 300 μm is used for encasing the organic EL element 101 with the glass cover 102. An epoxy-based photo curing adhesive (LUXTRAK LC0629B from TOA GOSEI Co., Ltd.) as a sealant is applied around the organic EL element 101, and then the glass cover 102 is placed so as to make the bottom peripheral surface thereof match the sealant area 111 from above the cathode 105 to adhere

to the transparent supporting substrate 110. The sealant is then irradiated with UV from the side of the transparent supporting substrate 110 to cure the sealant so as to make a sealed lighting device. The lighting device 112 as illustrated in Figs. 5 and 6 is thus manufactured.

## EXAMPLES

The present invention will be specifically described with reference to Examples, but not limited thereto. In Examples, "%" means "% by mass" unless described otherwise.

### Example 1

<<Synthesis of hexa-coordinated ortho-metalated iridium complex>>

As exemplary methods for synthesis of the hexa-coordinated ortho-metalated iridium complexes represented by the general formula (1) of the present invention, methods for synthesis of the above-described exemplary compounds 99, 102, 91, 54 and 26 are specifically described.

[Synthesis 1: Synthesis of Exemplary compound 99]

The exemplary compound 99 was synthesized according to the following scheme.

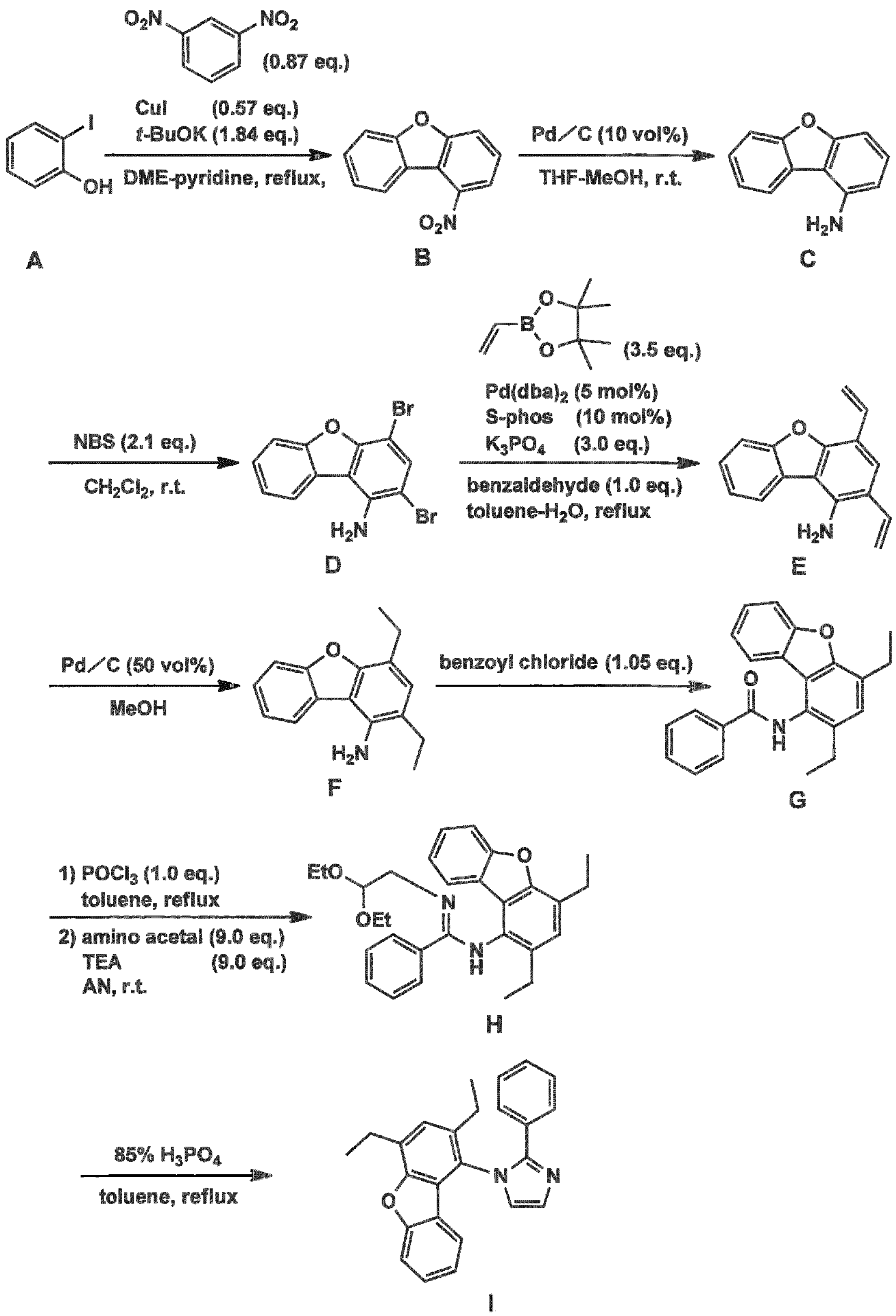
(0.87 eq.)
CuI (0.57 eq.)
t-BuOK (1.84 eq.)
DME-pyridine, reflux,
Pd/C (10 vol%)
THF-MeOH, r.t.
A
B
C
(3.5 eq.)
Pd(dba)$_2$ (5 mol%)
S-phos (10 mol%)
$K_3PO_4$ (3.0 eq.)
NBS (2.1 eq.)
$CH_2Cl_2$, r.t.
benzaldehyde (1.0 eq.)
toluene-$H_2O$, reflux
D
E
Pd/C (50 vol%)
MeOH
benzoyl chloride (1.05 eq.)
F
G
1) $POCl_3$ (1.0 eq.)
toluene, reflux
2) amino acetal (9.0 eq.)
TEA (9.0 eq.)
AN, r.t.
H
85% $H_3PO_4$
toluene, reflux
I

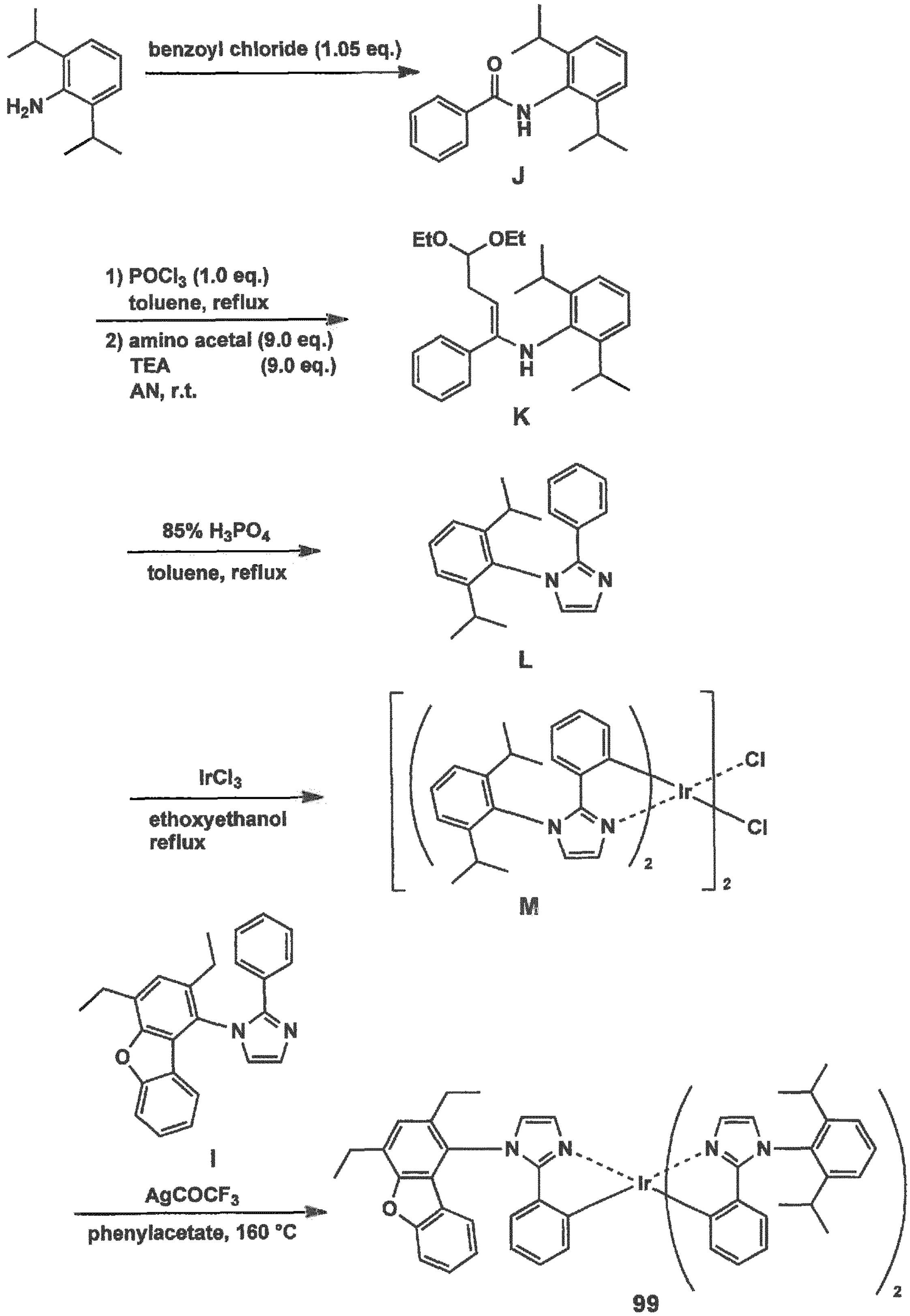


The compound B was obtained in a yield of 65% by heating o-iodophoenol and m-nitrobenzene in the presence of copper iodide and potassium t-butoxide in a mixture of dimethylether (hereinafter abbreviated as DME) and pyridine under reflux, and then the compound B was subjected to hydrogenation to give the compound C in a yield of 78%. Thereafter, the compound C was reacted with N-bromosuccinimide (hereinafter abbreviated as NBS) in methylene chloride at room temperature to give the compound D in a yield of 88%. Subsequently, the compound D was coupled

with vinylboronic acid pinacol ester by the Suzuki coupling to give the compound E in a yield of 65%.

Then, the compound E was hydrogenated by stirring in the presence of 10% palladium on carbon (Pd/C) in a mixture of tetrahydrofuran (hereinafter abbreviated as THF) and methanol under hydrogen atmosphere at room temperature to give the compound F in a yield of 77%.

The compound F was then reacted with benzoyl chloride in a mixture of benzoyl chloride and toluene at room temperature to give the compound G in a yield of 81%.

Thereafter, the compound G was heated with phosphoryl chloride in toluene under reflux followed by reaction with aminoacetal in acetonitrile-triethylamine mixture at room temperature to give the compound H in a yield of 45%. The compound H was then heated with 85% phosphate in toluene under reflux to give the compound I in a yield of 44%.

On the other hand, 2,6-diisopropylaniline and benzoyl chloride were stirred in toluene at room temperature to give the compound J in a yield of 83%. The compound J was then heated with phosphoryl chloride in toluene under reflux followed by reaction with aminoacetal in acetonitrile-triethylamine mixture at room temperature to give the compound K in a yield of 49%. Thereafter, the compound K was heated with 85% phosphate in toluene under reflux to give the compound L in a yield of 44%. Subsequently, the compound L was heated with indium chloride in ethoxyethanol under reflux to give the compound M in a yield of 68%.

Then, the above compound I and compound M were reacted with each other in the presence of silver trifluoroacetate in phenyl acetate at 160 °C to give the exemplary compound 99 in a yield of 21 %. The structure of the exemplary compound 99 was confirmed by Mass Spectrometry and $^{1}$H-NMR.

[Synthesis 2: Synthesis of Exemplary compound 102]

The exemplary compound 102 was synthesized according to the following scheme.

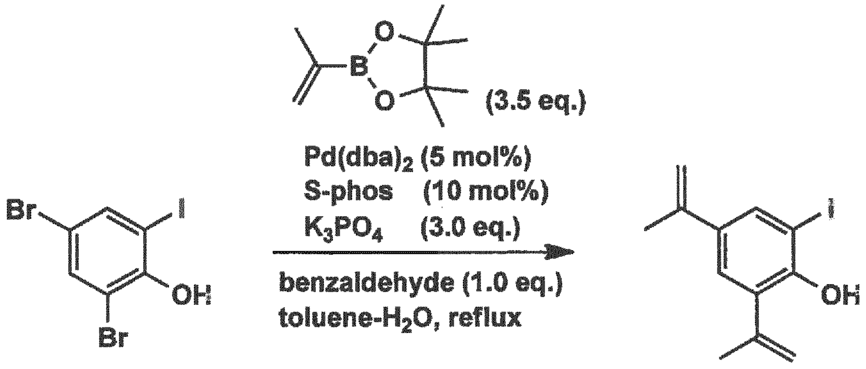


N

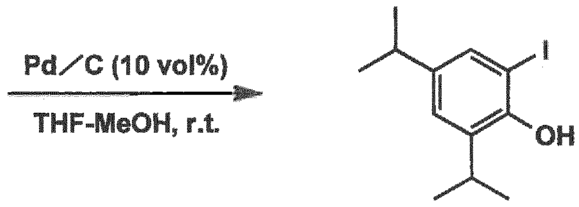


O

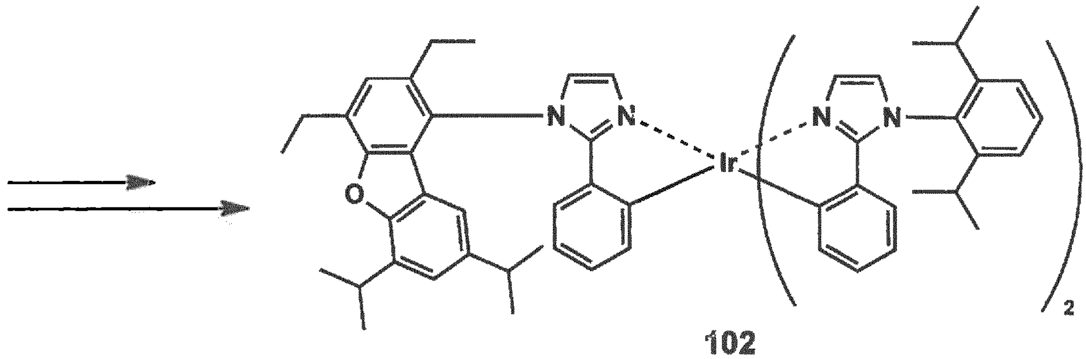

102

2,4-dibromo 6-iodophenol and isopropenylboronic acid pinacol ester were coupled by the Suzuki coupling to give the compound N in a yield of 48%. The compound N was then hydrogenated to give the compound O in a yield of 79%.

Thereafter, synthesis of the exemplary compound 102 from the compound O was the same as the synthesis of the exemplary compound 99 except that the compound A was replaced with the compound O. The structure of the exemplary compound 102 was confirmed by Mass Spectrometry and $^1$H-NMR.

[Synthesis 3: Synthesis of Exemplary compound 91]

The exemplary compound 91 was synthesized according to the following scheme.

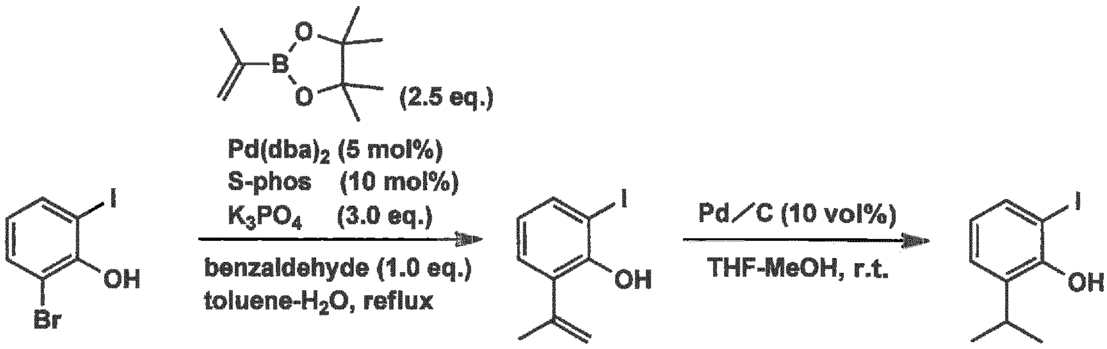


P Q

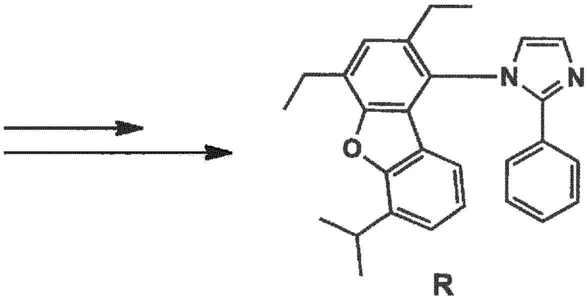

R

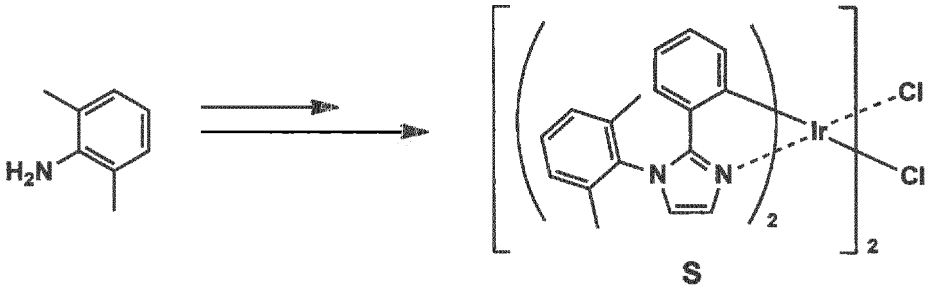

S

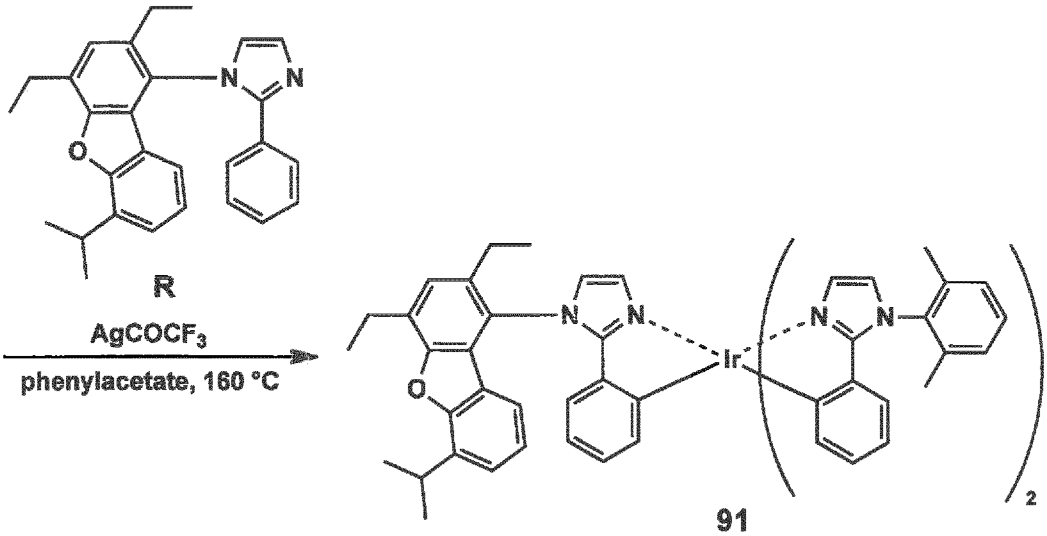


R

91

2-bromo 6-iodophenol and isopropenylboronic acid pinacol ester were coupled by the Suzuki coupling to give the compound P in a yield of 41%. The compound P was then hydrogenated to give the compound Q in a yield of 62%.

The compound Q was obtained from the compound Q by the same way as the compound M described in the synthesis 1 was obtained.

On the other hand, the compound S was obtained from 2,6-dimethylaniline by the same way as the compound M described in the synthesis 1 was obtained.

Then the compound S and compound R were reacted with each other in the presence of silver trifluoroacetate in phenyl acetate at 160 °C to give the exemplary compound 91 in a yield of 20%. The structure of the exemplary compound 91 was confirmed by Mass Spectrometry and $^{1}$H-NMR.

[Synthesis 4: Synthesis of Exemplary compound 54]

The exemplary compound 54 was synthesized according to the following scheme.

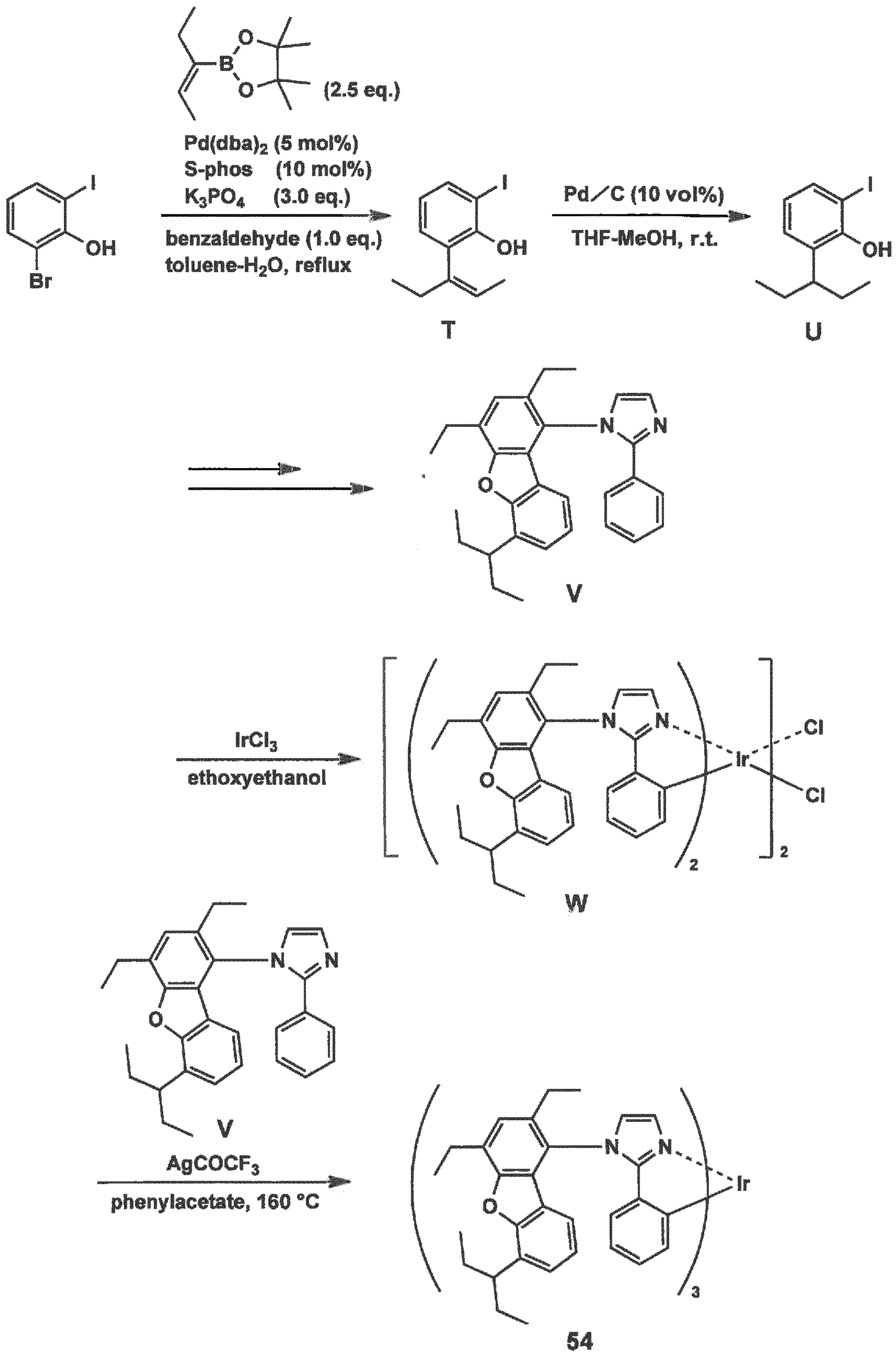


T U V W V 54

2-bromo 6-iodophenol and isopropenylboronic acid pinacol ester were coupled by the Suzuki coupling to give the compound T in a yield of 31%. The compound T was then hydrogenated to give the compound U in a yield of 54%. The compound V was obtained from the compound U by the same way as the compound M described in the synthesis 1 was obtained.

The compound V was reacted with iridium chloride in ethoxyethanol to give the compound W in a yield of 45%.

The compound W and compound V were reacted with each other in the presence of silver trifluoroacetate in phenyl acetate at 160 °C to give the exemplary compound 54 in a yield of 44%. The structure of the exemplary compound 54 was confirmed by Mass Spectrometry and $^{1}$H-NMR.

[Synthesis 5: Synthesis of Exemplary compound 26]

The exemplary compound 26 was synthesized according to the following scheme.

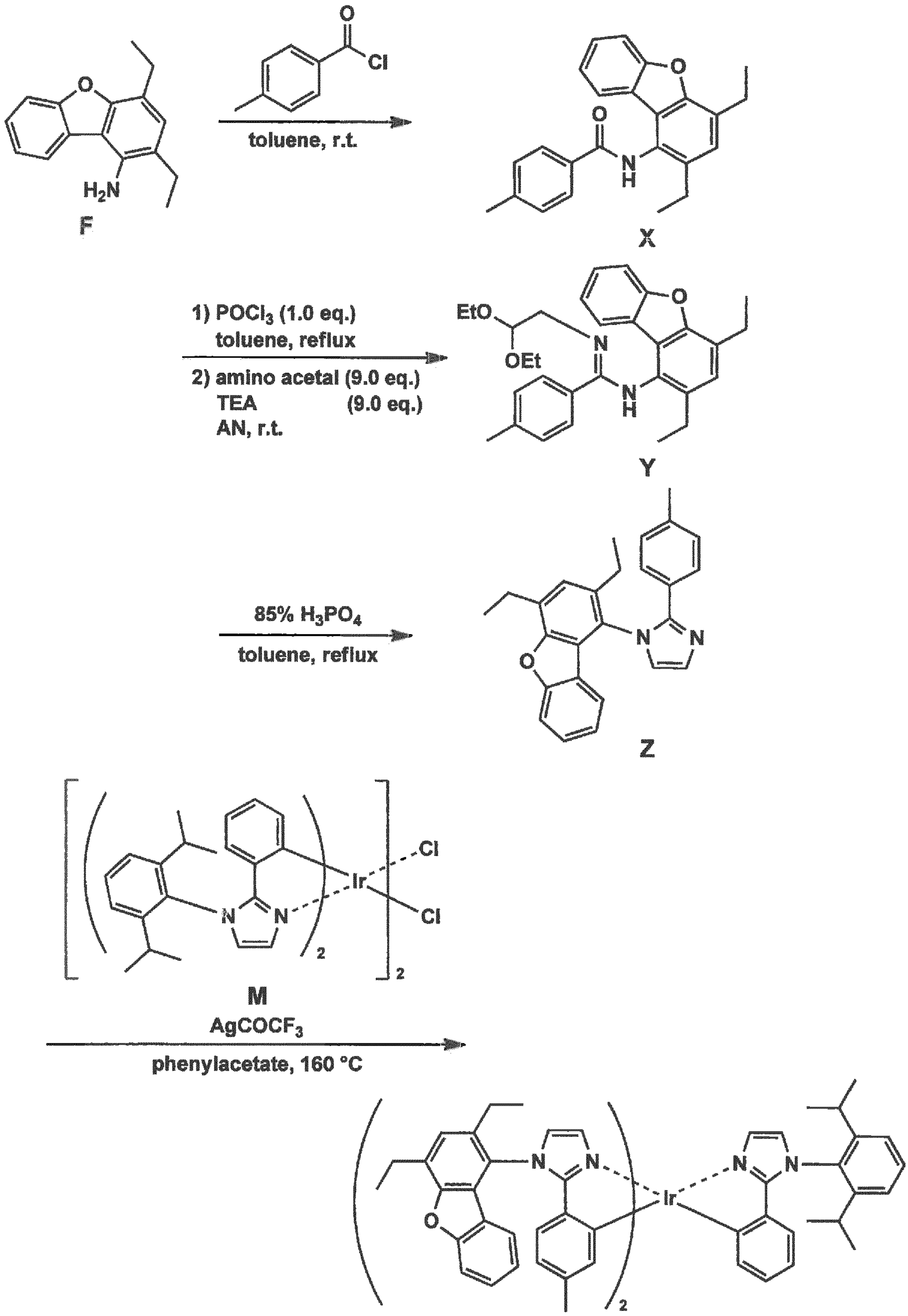


F X Y Z M

26

The compound F and p-methylbenzoyl chloride were reacted with each other in toluene at room temperature to give the compound X in a yield of 79%. The compound X was then heated with phosphoryl chloride in toluene under

reflux followed by reaction with aminoacetal in acetonitrile-triethylamine mixture at room temperature to give the compound Y in a yield of 49%.

Thereafter, the compound Y was heated with phosphate in toluene under reflux to give the compound Z in a yield of 58%.

The compound Z and the compound M synthesized in the synthesis 1 were reacted with each other in the presence of silver trifluoroacetate in phenyl acetate at 160 °C to give the exemplary compound 26 in a yield of 19%. The structure of the exemplary compound 26 was confirmed by Mass Spectrometry and $^1$H-NMR.

Example 2

<<Preparation of organic EL elements>>

Blue light-emitting organic EL elements 1-1 to 1-20 were prepared using deposition as follows.

[Preparation of organic EL element 1-1]

On a transparent supporting substrate made of glass having an area of 100 mm wide and 100 mm long and a thickness of 1.1 mm (NA45 from NH Techno Glass Corporation), a layer of indium tin oxide (ITO) having a thickness of 100 nm was formed, and patterning was then conducted to this layer to form an anode. The transparent supporting substrate on which the anode (ITO transparent electrode) was formed was subjected to an ultrasonic cleaning with isopropyl alcohol, drying in dry nitrogen gas, and five-minute UV-ozone cleaning.

The transparent supporting substrate was then fixed on a substrate holder of a commercially-available vacuum deposition device.

On the other hand, 200mg of copper phthalocyanine as the electron hole injecting material was placed in a molybdenum resistance heating boat; 200 mg of $\alpha$-NPD shown later was placed in another molybdenum resistance heating boat; 200 mg of the exemplary compound H-33 as the host was placed in another molybdenum resistance heating boat; D-1 shown later as the light-emitting dopant was placed in another molybdenum resistance heating boat; and $Alq_3$ shown later as the electron transporting material was placed in another molybdenum resistance heating boat, and then all of these heating boats were attached to the above commercially-available vacuum deposition device.

Thereafter, the vacuum chamber was depressurized to $4\times10^{-4}$ Pa, and then the heating boat in which copper phthalocyanine was placed was electrically heated so as to deposit copper phthalocyanine at a deposition rate of 0.1 nm/sec on the anode and the transparent supporting substrate to form an electron hole injecting layer having a thickness of 20 nm.

Subsequently, the heating boat in which $\alpha$-NPD was placed was electrically heated so as to deposit $\alpha$-NPD at a deposition rate of 0.1 nm/sec on the above electron hole injecting layer to form an electron hole transporting layer having a thickness of 20 nm.

Then, the heating boat in which the exemplary compound H-33 as the host was placed and the heating boat in which D-1 as the dopant was placed were both electrically heated so as to co-deposit H-33 and D-1 at deposition rates of 0.1 nm/sec and 0.06 nm/sec respectively on the above electron hole transporting layer to form a light-emitting layer having a thickness of 20 nm.

The heating boat in which $Alq_3$ was placed was electrically heated so as to deposit $Alq_3$ at a deposition rate of 0.1 nm/sec on the light-emitting layer to form an electron transporting layer having a thickness of 20 nm.

Lithium fluoride was then deposited on the electron transporting layer so as to form a cathode buffer layer having a thickness of 0.5 nm. Thereafter, aluminum was deposited on the cathode buffer layer so as to form a cathode. An organic EL element 1-1 as a comparative example was thus prepared.

[Preparation of organic EL element 1-2 to 1-20]

Organic EL elements 1-2 to 1-20 were prepared by the same way as the organic EL element 1-1 was prepared except that D-1 as the dopant and/or H-33 as the host, both of which were used for forming the light-emitting layer, were replaced with the compounds as listed in Table 1.

The structures of $Alq_3$ as the electron transporting material, $\alpha$-NPD as the electron hole transporting material and comparative dopants D-1 and D-2, all of which are other than the exemplary compounds used for the respective organic EL elements, are as follows.

Alq3

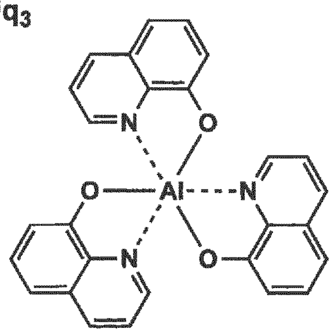

α−NPD

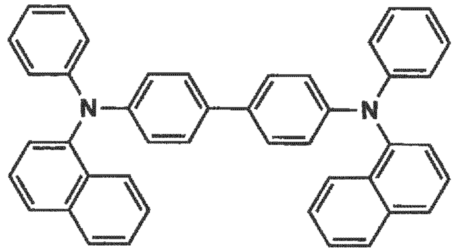

D−1

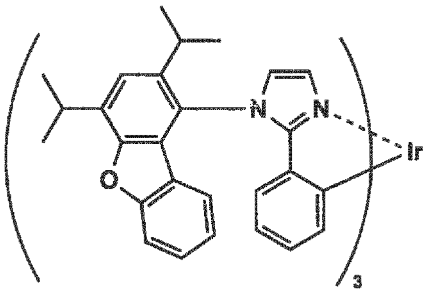

D−2

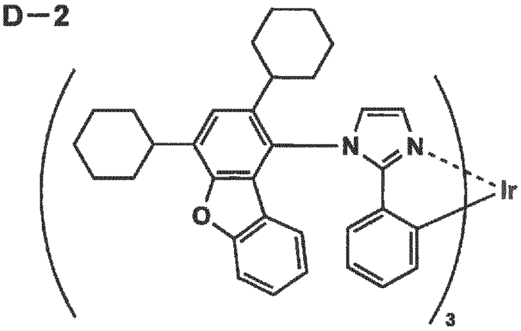

«Evaluation of organic EL elements»

[Preparation of lighting devices]

To prepare respective lighting devices 1-1 to 1-20, a glass cover was used to cover non-light emitting sides of the organic EL element of the present invention, and a transparent supporting substrate made of glass having a thickness of 300 μm was used for encasing the organic EL element with the glass cover. An epoxy-based photo curing adhesive (LUXTRAK LC0629B from TOA GOSEI Co., Ltd.) as a sealant was applied around the organic EL element, and then the glass cover was placed so as to make the bottom peripheral surface match the sealant area from above the cathode to adhere to the transparent supporting substrate. The sealant was then irradiated with UV from the side of the transparent supporting substrate to cure the sealant so as to make a sealed lighting device. The respective lighting devices 1-1 to 1-20 such as illustrated in Figs. 5 and 6 were thus prepared. The respective lighting devices 1-1 to 1-20 were evaluated regarding the following points.

[External quantum efficiency]

For each of the organic EL elements of the lighting devices 1-1 to 1-20, an external quantum efficiency (%) at a constant current of 2.5 mA/cm$^2$ at 23 °C under dry nitrogen atmosphere was measured. CS-1000 (a spectroradiometer light measurement instrument from Konica Minolta, Inc.) was used for the measurement. Relative values to a measured efficiency of the organic EL element 1-1 defined as 100 were calculated for the other organic EL elements. The bigger value represents the bigger external quantum efficiency.

[Evaluation of lifetime of light emission]

For each of the organic EL elements of the lighting devices, a time period until luminance at the start of light emission (initial luminance) decreased by half in driving at a constant current of 2.5 mA/cm$^2$ was measured as a half-life time. The half-life time was an indicator of lifetime of light emission. CS-1000 (a spectroradiometer light measurement instrument from Konica Minolta, Inc.) was used for the measurement. Relative values to a measured time period of the organic EL element 1-1 defined as 100 were calculated for the other organic EL elements. The bigger value represents the superiority in lifetime of light emission.

[Evaluation of color of light]

For each of the organic EL elements of the lighting devices, color of the light was visually evaluated when the

organic EL element was constantly made emit light at a constant current of 2.5 mA/$cm^2$.

Results obtained from the above evaluations are shown in Table 1.

[Table 1]

| Organic EL element No. | Light - emitting layer | | Evaluation | | | Note |
|---|---|---|---|---|---|---|
| | Dopant | Host | Lifetime of light emission | External quantum efficiency | Color of light | |
| 1-1 | D-1 | H-33 | 100 | 100 | blue | Comparative Example |
| 1-2 | D-2 | H-33 | 101 | 103 | blue | Comparative Example |
| 1-3 | D-2 | H-62 | 102 | 100 | blue | Comparative Example |
| 1-4 | 10 | H-62 | 122 | 119 | blue | Present Invention |
| 1-5 | 16 | H-62 | 124 | 118 | blue | Present Invention |
| 1-6 | 22 | H-62 | 126 | 119 | blue | Present Invention |
| 1-7 | 26 | H-62 | 125 | 113 | blue | Present Invention |
| 1-8 | 34 | H-62 | 131 | 117 | blue | Present Invention |
| 1-9 | 40 | H-62 | 133 | 115 | blue | Present Invention |
| 1-10 | 52 | H-62 | 132 | 119 | blue | Present Invention |
| 1-11 | 56 | H-62 | 126 | 120 | blue | Present Invention |
| 1-12 | 60 | H-62 | 128 | 123 | blue | Present Invention |
| 1-13 | 68 | H-62 | 143 | 126 | blue | Present Invention |
| 1-14 | 71 | H-60 | 131 | 130 | blue | Present Invention |
| 1-15 | 74 | H-60 | 132 | 132 | blue | Present Invention |
| 1-16 | 80 | H-60 | 133 | 140 | blue | Present Invention |
| 1-17 | 89 | H-60 | 135 | 142 | blue | Present Invention |
| 1-18 | 97 | H-60 | 127 | 141 | blue | Present Invention |
| 1-19 | 98 | H-60 | 143 | 145 | blue | Present Invention |

(continued)

| Organic EL element No. | Light - emitting layer | | Evaluation | | | Note |
|---|---|---|---|---|---|---|
| | Dopant | Host | Lifetime of light emission | External quantum efficiency | Color of light | |
| 1-20 | 100 | H-60 | 137 | 146 | blue | Present Invention |

As evident from Table 1, the blue light-emitting organic EL elements of the present invention using the hexa-coordinated ortho-metalated iridium complexes represented by the general formula (1) as the dopants in the light-emitting layers have higher external quantum efficiencies comparing to the comparative examples. Thus, the organic EL elements of the present invention are provided with longer lifetimes.

Example 3

<<Preparation of organic EL elements>>

Blue light-emitting organic EL elements 2-1 to 2-10 were prepared using wet process as follows.

[Preparation of organic EL element 2-1]

On a transparent supporting substrate made of glass having an area of 100 mm wide and 100 mm long and a thickness of 1.1 mm (NA45 from NH Techno Glass Corporation), a layer of indium tin oxide (ITO) having a thickness of 100 nm was formed, and patterning was then conducted to this layer to form an anode. The transparent supporting substrate on which the anode (ITO transparent electrode) was formed was subjected to an ultrasonic cleaning with isopropyl alcohol, drying in dry nitrogen gas, and five-minute UV-ozone cleaning.

On the anode and transparent supporting substrate, a thin film was formed with 70% poly(3,4-ethylenedioxythiofene)-polystyrene sulfonate PEDOT/PSS (Baytron P Al 4083 from Bayer AG) diluted with pure water by spin coating at 3000 rpm for 30 seconds followed by drying at 200 °C for an hour to form a first electron hole transporting layer having a thickness of 20 nm.

The substrate on which the first electron hole transporting layer was formed was placed under nitrogen atmosphere. Then, on the first electron hole transporting layer, a thin film was formed with a solution where 50mg of the above $\alpha$-NPD was dissolved in 10 ml of toluene by spin coating at 1500 rpm for 30 seconds followed by vacuum drying at 60 °C for an hour to form a second electron hole transporting layer having a thickness of 20 nm.

On the second electron hole transporting layer, a thin film was formed with a solution where 100 mg of the exemplary compound H-33 as the host and 10 mg of the above D-1 as the dopant were dissolved in 10 ml of butyl acetate by spin coating at 600 rpm for 30 seconds followed by vacuum drying at 60 °C for an hour to form a light-emitting layer having a thickness of 70 nm.

On the light-emitting layer, a thin film was formed with a solution where 50 mg of the above $Alq_3$ was dissolved in 10 ml of hexafluoroisopropanol (HFIP) by spin coating at 1000 rpm for 30 seconds followed by vacuum drying at 60 °C for an hour to form an electron transporting layer having a thickness of 30 nm.

Subsequently, the above substrate was fixed on a substrate holder of a vacuum deposition device. Thereafter, the vacuum chamber was depressurized to $4\times10^{-4}$ Pa, and then potassium fluoride was deposited on the electron transporting layer so as to form a cathode buffer layer having a thickness of 0.4 nm. On this cathode buffer layer, aluminum was deposited so as to form a cathode having a thickness of 110 nm. An organic EL element 2-1 was thus prepared.

[Preparation of organic EL elements 2-2 to 2-10]

Organic EL elements 2-2 to 2-10 were prepared by the same way as the organic EL element 2-1 was prepared except that D-1 as the dopant and/or H-33 as the host were replaced with the compounds as listed in Table 2.

<<Evaluation of organic EL elements>>

Respective lighting devices 2-1 to 2-10 were prepared using the respective organic EL elements 2-1 to 2-10 by the same ways as described in Example 2. External quantum efficiencies, lifetimes of light emission and color of the light were evaluated by the same ways as Example 2.

Results obtained from the above evaluations are shown in Table 2.

[Table 2]

| Organic EL element No. | Light-emitting layer | | Evaluation | | | Note |
|---|---|---|---|---|---|---|
| | Dopant | Host | Lifetime of light emission | External quantum efficiency | Color of light | |
| 2-1 | D-1 | H-33 | 100 | 100 | blue | Comparative Example |
| 2-2 | D-2 | H-33 | 101 | 101 | blue | Comparative Example |
| 2-3 | D-2 | H-61 | 103 | 102 | blue | Comparative Example |
| 2-4 | 16 | H-61 | 119 | 133 | blue | Present Invention |
| 2-5 | 26 | H-61 | 125 | 134 | blue | Present Invention |
| 2-6 | 52 | H-61 | 122 | 137 | blue | Present Invention |
| 2-7 | 71 | H-61 | 126 | 143 | blue | Present Invention |
| 2-8 | 80 | H-61 | 133 | 137 | blue | Present Invention |
| 2-9 | 99 | H-61 | 136 | 148 | blue | Present Invention |
| 2-10 | 100 | H-61 | 134 | 149 | blue | Present Invention |

As evident from Table 2, the blue light-emitting organic EL elements of the present invention using the hexa-coordinated ortho-metalated iridium complexes represented by the general formula (1) as the dopants in the light-emitting layers have higher external quantum efficiencies comparing to the comparative examples. Thus, the organic EL elements of the present invention are provided with longer lifetimes.

Example 4

<<Preparation of organic EL elements>>

White light-emitting organic EL elements 3-1 to 3-10 were prepared using deposition as follows.

[Preparation of organic EL element 3-1]

On a transparent supporting substrate made of glass having an area of 100 mm wide and 100 mm long and a thickness of 1.1 mm (NA45 from NH Techno Glass Corporation), a layer of indium tin oxide (ITO) having a thickness of 100 nm was formed, and then patterning was conducted to this layer to form an anode. The transparent substrate on which the anode (ITO transparent electrode) was formed was subjected to an ultrasonic cleaning with isopropyl alcohol, drying in dry nitrogen gas, and five-minute UV-ozone cleaning.

The transparent supporting substrate was then fixed on a substrate holder of a commercially-available vacuum deposition device. On the other hand, 200mg of copper phthalocyanine as the electron hole injecting material was placed in a molybdenum resistance heating boat; 200 mg of the above α-NPD as the electron hole transporting material was placed in another molybdenum resistance heating boat; 200 mg of the exemplary compound H-33 as the host was placed in another molybdenum resistance heating boat; 200 mg of the above D-1 as a blue light-emitting dopant was placed in another molybdenum resistance heating boat; 200 mg of $Ir(piq)_3$ shown later as a green light-emitting dopant was placed in another molybdenum resistance heating boat; 200 mg of $Ir(ppy)_3$ shown later as a red light-emitting dopant was placed in another molybdenum resistance heating boat; and 200 mg of the above $Alq_3$ as the electron transporting material was placed in another molybdenum resistance heating boat, and then all of these heating boats were attached to the above vacuum deposition device.

Thereafter, the vacuum chamber was depressurized to $4\times10^{-4}$ Pa, and then the heating boat in which copper phthalocyanine was placed was electrically heated so as to deposit copper phthalocyanine at a deposition rate of 0.1 nm/sec on the anode and transparent supporting substrate to form an electron hole injecting layer having a thickness of 20 nm.

Subsequently, the heating boat in which α-NPD was placed was electrically heated so as to deposit α-NPD at a deposition rate of 0.1 nm/sec on the above electron hole injecting layer to form an electron hole transporting layer having a thickness of 20 nm.

Then, the heating boat in which the exemplary compound H-33 as the host was placed and the respective boats in which D-1, $Ir(piq)_3$ and $Ir(ppy)_3$ as the dopants were placed respectively were electrically heated so as to co-deposit H-33 , D-1, $Ir(piq)_3$ and $Ir(ppy)_3$ on the above electron hole transporting layer at deposition rates of 0.1 nm/sec, 0.025 nm/sec, 0.007 nm/sec and 0.002 nm/sec, respectively to form a light-emitting layer having a thickness of 20 nm.

The heating boat in which $Alq_3$ was placed was electrically heated so as to deposit $Alq_3$ on the light-emitting layer at a deposition rate of 0.1 nm/sec to form an electron transporting layer having a thickness of 20 nm.

Lithium fluoride was then deposited on the electron transporting layer so as to form a cathode buffer layer having a thickness of 0.5 nm. Thereafter, aluminum film was deposited on the cathode buffer layer so as to form a cathode having a thickness of 110 nm. A white light-emitting organic EL element 3-1 as a comparative example was thus prepared.

[Preparation of organic EL elements 3-2 to 3-10]

Organic EL elements 3-2 to 3-10 were prepared by the same ways as the organic EL element 3-1 except that D-1 as the dopant and/or H-33 as the host were replaced with the compounds as listed in Table 3.

The structures of $Ir(ppy)_3$ as the green light-emitting dopant and $Ir(piq)_3$ as the red light-emitting dopant are as follows.

$Ir(ppy)_3$

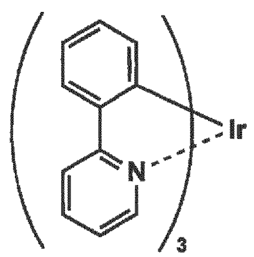

,

$Ir(piq)_3$

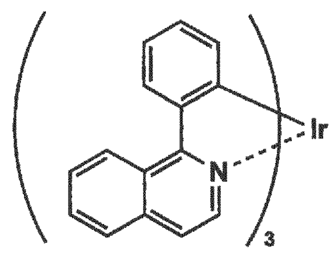

<<Evaluation of organic EL elements>>

Respective lighting devices 3-1 to 3-10 were manufactured using the respective organic EL elements 3-1 to 3-10 by the same ways as described in Example 2. Lifetimes of light emission and color of the light were evaluated by the same ways as Example 2, and driving voltages were evaluated as follows.

[Evaluation of driving voltage]

For each of the organic EL elements of the lighting devices, a driving voltage at room temperature at a constant current of 2.5 $mA/cm^2$ was measured. Relative values to a measured driving voltage of the organic EL element 3-1 defined as 100 were calculated for the other organic EL elements. The smaller value represents the lower voltage required for driving. Results obtained from the above evaluations are shown in Table 3.

[Table 3]

| Organic EL element No. | Light-emitting layer | | Evaluation | | | Note |
|---|---|---|---|---|---|---|
| | Dopant | Host | Lifetime of light emission | Driving voltage | Color of light | |
| 3-1 | D-1 | H-33 | 100 | 100 | white | Comparative Example |
| 3-2 | D-2 | H-33 | 101 | 102 | white | Comparative Example |
| 3-3 | D-2 | H-59 | 102 | 103 | white | Comparative Example |
| 3-4 | 16 | H-59 | 122 | 96 | white | Present Invention |
| 3-5 | 56 | H-59 | 126 | 97 | white | Present Invention |
| 3-6 | 68 | H-59 | 128 | 94 | white | Present Invention |
| 3-7 | 82 | H-59 | 136 | 98 | white | Present Invention |
| 3-8 | 92 | H-59 | 133 | 92 | white | Present Invention |
| 3-9 | 98 | H-59 | 132 | 95 | white | Present Invention |
| 3-10 | 100 | H-59 | 137 | 93 | white | Present |

As evident from Table 3, the white light-emitting organic EL elements of the present invention using the hexa-coordinated ortho-metalated iridium complexes represented by the general formula (1) as the dopants in the light-emitting layers are provided with longer lifetimes and lower driving voltages comparing to the comparative examples.

Example 5

<<Preparation of organic EL elements>>

White light-emitting organic EL elements 4-1 to 4-10 were prepared using deposition as follows.

[Preparation of organic EL element 4-1]

On a transparent supporting substrate made of glass having an area of 100 mm wide and 100 mm long and a thickness of 1.1 mm (NA45 from NH Techno Glass Corporation), a layer of indium tin oxide (ITO) having a thickness of 100 nm was formed, and patterning was then conducted to this layer to form an anode. The transparent substrate on which the anode (ITO transparent electrode) was formed was subjected to an ultrasonic cleaning with isopropyl alcohol, drying in dry nitrogen gas, and five-minute UV-ozone cleaning.

On the anode and transparent supporting substrate, a thin film was formed with 70% poly(3,4-ethylenedioxythiofene)-polystyrene sulfonate PEDOT/PSS (Baytron P Al 4083 from Bayer AG) diluted with pure water by spin coating at 3000 rpm for 30 seconds followed by drying at 200 °C for an hour to form a first electron hole transporting layer having a thickness of 20 nm.

The transparent supporting substrate on which the first electron hole transporting layer was formed was placed under nitrogen atmosphere. Then, on the first electron hole transporting layer, a thin film was formed with a solution where 50mg of the above $\alpha$-NPD was dissolved in 10 ml of toluene by spin coating at 1500 rpm for 30 seconds followed by vacuum drying at 60 °C for an hour to form a second electron hole transporting layer having a thickness of 20 nm.

On the second electron hole transporting layer, a thin film was formed with a solution where 100 mg of the exemplary compound H-33, 20 mg of the above D-1, 0.5 mg of the above $Ir(ppy)_3$ and 0.2 mg of the above $Ir(piq)_3$ were dissolved in 10 ml of butyl acetate by spin coating at 600 rpm for 30 seconds followed by vacuum drying at 60 °C for an hour to form a light-emitting layer having a thickness of 70 nm.

Then, on the light-emitting layer, a thin film was formed with a solution where 50 mg of the above $Alq_3$ was dissolved in 10 ml of hexafluoroisopropanol (HFIP) by spin coating at 1000 rpm for 30 seconds followed by vacuum drying at 60 °C for an hour to form an electron transporting layer having a thickness of 30 nm.

Subsequently, the transparent supporting substrate on which the above layers were formed was fixed on a substrate holder of a vacuum deposition device. Thereafter, the vacuum chamber was depressurized to $4 \times 10^{-4}$ Pa, and then potassium fluoride was deposited on the electron transporting layer so as to form a cathode buffer layer having a thickness of 0.4 nm. On this cathode buffer layer, aluminum was deposited to form a cathode having a thickness of 110 nm. An organic EL element 4-1 was thus prepared.

[Preparation of organic EL elements 4-2 to 4-10]

Organic EL elements 4-2 to 4-10 were prepared by the same way as the organic EL element 4-1 was prepared except that D-1 as the dopant and/or H-33 as the host were replaced with the compounds as listed in Table 4.

<<Evaluation of organic EL elements>>

Respective lighting devices 4-1 to 4-10 were prepared using the respective organic EL elements 4-1 to 4-10 by the same ways as described in Example 2. Lifetimes of light emission, driving voltages and color of the light were evaluated by the same ways as Example 4. Result obtained from the above evaluations are shown in Table 4.

[Table 4]

| Organic EL element No. | Light-emitting layer | | Evaluation | | | Note |
|---|---|---|---|---|---|---|
| | Dopant | Host | Lifetime of light emission | Driving voltage | Color of light | |
| 4-1 | D-1 | H-30 | 100 | 100 | white | Comparative Example |
| 4-2 | D-2 | H-30 | 101 | 101 | white | Comparative Example |
| 4-3 | D-2 | H-62 | 102 | 110 | white | Comparative Example |
| 4-4 | 22 | H-62 | 132 | 88 | white | Present Invention |
| 4-5 | 26 | H-62 | 133 | 89 | white | Present Invention |
| 4-6 | 52 | H-62 | 132 | 88 | white | Present Invention |
| 4-7 | 80 | H-62 | 136 | 79 | white | Present Invention |
| 4-8 | 98 | H-59 | 137 | 77 | white | Present Invention |
| 4-9 | 99 | H-59 | 143 | 77 | white | Present Invention |
| 4-10 | 100 | H-59 | 144 | 74 | white | Present Invention |

As evident from Table 4, the white light-emitting organic EL elements of the present invention using the hexa-coordinated ortho-metalated iridium complexes represented by the general formula (1) as the dopants in the light-emitting layers are provided with longer lifetimes and lower driving voltages comparing to the comparative examples.

Example 6

<<Preparation of organic EL elements>>

White light-emitting organic EL elements 5-1 to 5-10 having multiple light-emitting layers were prepared using wet process and deposition as follows.

[Preparation of organic EL element 5-1]

On a transparent supporting substrate made of glass having an area of 100 mm wide and 100 mm long and a thickness of 1.1 mm (NA45 from NH Techno Glass Corporation), a layer of indium tin oxide (ITO) having a thickness of 100 nm was formed, and patterning was then conducted to this layer to form an anode. The transparent substrate on

which the anode (ITO transparent electrode) was formed was subjected to an ultrasonic cleaning with isopropyl alcohol, drying in dry nitrogen gas, and five-minute UV-ozone cleaning.

On the anode and transparent supporting substrate, a thin film was formed with 70% poly(3,4-ethylenedioxythiofene)-polystyrene sulfonate PEDOT/PSS (Baytron P Al 4083 from Bayer AG) diluted with pure water by spin coating at 3000 rpm for 30 seconds followed by drying at 200 °C for an hour to form a first electron hole transporting layer having a thickness of 20 nm.

The substrate on which the first electron hole transporting layer was formed was placed under nitrogen atmosphere. Then, on the first electron hole transporting layer, a thin film was formed with a solution where 50mg of the above α-NPD was dissolved in 10 ml of toluene by spin coating at 1500 rpm for 30 seconds followed by vacuum drying at 60 °C for an hour to form a second electron hole transporting layer having a thickness of 20 nm.

On the second electron hole transporting layer, a thin film was formed with a solution where 100 mg of the exemplary compound H-11 as the host and 10 mg of the above D-1 as the dopant were dissolved in 10 ml of butyl acetate by spin coating at 2000 rpm for 30 seconds followed by vacuum drying at 60 °C for an hour to form a first light-emitting layer having a thickness of 35 nm.

The transparent supporting substrate having the first light-emitting layer was then fixed on a substrate holder of a vacuum deposition device. On the other hand, 200 mg of the exemplary compound H-11 as the host was placed in a molybdenum resistance heating boat; 200 mg of the above $Ir(piq)_3$ was placed in another molybdenum resistance heating boat; 200 mg of the above $Ir(ppy)_3$ was placed in another molybdenum resistance heating boat; and 200 mg of the above $Alq_3$ as the electron transporting material was placed in another molybdenum resistance heating boat, and then all of these heating boats were attached to the above vacuum deposition device.

Thereafter, the vacuum chamber was depressurized to $4\times10^{-4}$ Pa, and then the heating boats in which the exemplary compound H-11, $Ir(piq)_3$ and $Ir(ppy)_3$ respectively were placed were electrically heated so as to co-deposit H-11, $Ir(piq)_3$ and $Ir(ppy)_3$ on the first light-emitting layer at deposition rates of 0.1 nm/sec, 0.010 nm/sec and 0.002 nm/sec, respectively to form a second light-emitting layer having a thickness of 35 nm.

The heating boats in which $Alq_3$ was placed was then electrically heated so as to deposit $Alq_3$ on the second light-emitting layer at a deposition rate of 0.1 nm/sec so as to form an electron transporting layer having a thickness of 20 nm.

Thereafter, potassium fluoride was deposited on the electron transporting layer so as to form a cathode buffer layer having a thickness of 0.5 nm. On this cathode buffer layer, aluminum was deposited so as to form a cathode having a thickness of 110 nm. An organic EL element 5-1 was thus prepared.

[Preparation of organic EL elements 5-2 to 5-10]

Organic EL elements 5-2 to 5-10 were prepared by the same way as the organic EL element 5-1 was prepared except that D-1 as the dopant and/or H-11 as the host were replaced with the compounds as listed in Table 5.

<<Evaluation of organic EL elements>>

Respective lighting devices 5-1 to 5-10 were prepared using the respective organic EL elements 5-1 to 5-10 by the same ways as described in Example 2. External quantum efficiencies, lifetimes of light emission and color of the light were evaluated by the same ways as Example 2, and long-term stabilities were evaluated as follows.

(Long-term stability)

The above lighting devices using the organic EL elements were stored at 70 °C under 60%RH. Thereafter, power efficiencies before the storage and after the storage were obtained, and power efficiency ratios were obtained by the following equation as indicators for long-term stability.

$$\text{Long-term stability (\%)} = (\text{power efficiency after the storage} / \text{power efficiency before the storage}) \times 100$$

CS-1000 (a spectroradiometer light measurement instrument from Konica Minolta, Inc.) was used to measure front luminance and angle dependency of luminance of each of the organic EL elements, and power efficiency was obtained at a front luminance of 1000 $cd/m^2$ for each of the organic EL elements.

Results obtained from the above evaluations are shown in Table 5.

[Table 5]

| Organic EL element No. | Light-emitting layer | | Evaluation | | | | Note |
|---|---|---|---|---|---|---|---|
| | Dopant | Host | Lifetime of light emission | External quantum efficiency | Long-term stability | Color of light | |
| 5-1 | D-1 | H-11 | 100 | 100 | 54 | white | Comparative Example |
| 5-2 | D-2 | H-11 | 101 | 101 | 50 | white | Comparative Example |
| 5-3 | D-2 | H-60 | 101 | 99 | 50 | white | Comparative Example |
| 5-4 | 26 | H-60 | 137 | 122 | 56 | white | Present Invention |
| 5-5 | 52 | H-60 | 141 | 124 | 74 | white | Present Invention |
| 5-6 | 68 | H-60 | 142 | 133 | 70 | white | Present Invention |
| 5-7 | 82 | H-60 | 143 | 121 | 74 | white | Present Invention |
| 5-8 | 89 | H-60 | 141 | 122 | 72 | white | Present Invention |
| 5-9 | 97 | H-60 | 136 | 137 | 77 | white | Present Invention |
| 5-10 | 100 | H-60 | 133 | 135 | 75 | white | Present Invention |

As evident from Table 5, the white light-emitting organic EL elements of the present invention using the hexa-coordinated ortho-metalated iridium complexes represented by the general formula (1) as the dopants in the light-emitting layers have higher external quantum efficiencies and thus longer lifetimes are provided comparing to the comparative examples. In addition, the white light-emitting organic EL elements of the present invention show low decrease rates of power efficiencies and thus have superior long-term stabilities even after long-term storage under high temperature and high humidity.

Example 7

<<Preparation of organic EL elements>>

[Preparation of organic EL element 6-1]

On a transparent supporting substrate made of glass having an area of 100 mm wide and 100 mm long and a thickness of 1.1 mm (NA45 from NH Techno Glass Corporation), a layer of indium tin oxide (ITO) having a thickness of 100 nm was formed, and patterning was then conducted to this layer to form an anode. The transparent substrate on which the anode (ITO transparent electrode) was formed was subjected to an ultrasonic cleaning with isopropyl alcohol, drying in dry nitrogen gas, and five-minute UV-ozone cleaning.

On the anode and transparent supporting substrate, a thin film was formed with 70% poly(3,4-ethylenedioxythiofene)-polystyrene sulfonate PEDOT/PSS (Baytron P Al 4083 from Bayer AG) diluted with pure water by spin coating at 3000 rpm for 30 seconds followed by drying at 200 °C for an hour to form a first electron hole transporting layer having a thickness of 20 nm.

The substrate on which the first electron hole transporting layer was formed was placed under nitrogen atmosphere. Then, on the first electron hole transporting layer, a thin film was formed with a solution where 50mg of the above

α-NPD was dissolved in 10 ml of toluene by spin coating at 1500 rpm for 30 seconds followed by vacuum drying at 60 °C for an hour to form a second electron hole transporting layer having a thickness of 20 nm.

On the second electron hole transporting layer, a thin film was formed with a solution where 100 mg of the exemplary compound H-11 and 10 mg of the above D-1 were dissolved in 10 ml of butyl acetate by spin coating at 2000 rpm for 30 seconds followed by vacuum drying at 60 °C for an hour to form a first light-emitting layer having a thickness of 35 nm.

The transparent supporting substrate having the first light-emitting layer was formed was fixed on a substrate holder of a vacuum deposition device. On the other hand, 200 mg of the exemplary compound H-60 as the host was placed in a molybdenum resistance heating boat; 200 mg of the above $Ir(piq)_3$ was placed in another molybdenum resistance heating boat; 200 mg of the above $Ir(ppy)_3$ was placed in another molybdenum resistance heating boat; and 200 mg of the above $Alq_3$ was placed in another molybdenum resistance heating boat, and then all of these heating boats were attached to the above vacuum deposition device.

Thereafter, the vacuum chamber was depressurized to $4\times10^{-4}$ Pa, and then the heating boats in which the exemplary compound H-60, $Ir(piq)_3$ and $Ir(ppy)_3$ were placed respectively were electrically heated so as to co-deposit the H-60, Ir $(piq)_3$ and $Ir(ppy)_3$ on the first light-emitting layer at deposition rates of 0.1 nm/sec, 0.010 nm/sec and 0.002 nm/sec, respectively to form a second light-emitting layer having a thickness of 35 nm.

The heating boat in which the above $Alq_3$ was placed was then electrically heated so as to deposit $Alq_3$ on the second light-emitting layer at a deposition rate of 0.1 nm/sec to form an electron transporting layer having a thickness of 20 nm.

Thereafter, lithium fluoride was deposited on the electron transporting layer so as to form a cathode buffer layer having a thickness of 0.5 nm. On this cathode buffer layer, aluminum was deposited so as to form a cathode having a thickness of 110 nm. An organic EL element 6-1 was thus prepared.

[Preparation of organic EL elements 6-2 to 6-10]

Organic EL elements 6-2 to 6-10 were prepared by the same way as the organic EL element 6-1 was prepared except that D-1 as the dopant and/or H-11 as the host were replaced with the compounds as listed in Table 6, and/or H-60 as the host was replaced with the compound as listed in Table 6.

<<Evaluation of organic EL elements>>

Respective lighting devices 6-1 to 6-10 were prepared using the respective organic EL elements 6-1 to 6-10 by the same ways as described in Example 2. External quantum efficiencies, lifetimes of light emission, long-term stabilities and color of the light were evaluated by the same ways as Example 6.

Results obtained from the above evaluations are shown in Table 6.

[Table 6]

| Organic EL element No. | First light-emitting layer | | Second light-emitting layer | Evaluation | | | | Note |
|---|---|---|---|---|---|---|---|---|
| | Dopant | B host | RG host | Lifetime of light emission | External quantum efficiency | Long-term stability | Color of light | |
| 6-1 | D-1 | H-11 | H-60 | 100 | 100 | 51 | white | Comparative Example |
| 6-2 | D-2 | H-11 | H-60 | 101 | 95 | 43 | white | Comparative Example |
| 6-3 | D-2 | H-59 | H-60 | 102 | 99 | 55 | white | Comparative Example |
| 6-4 | 16 | H-59 | H-60 | 122 | 144 | 77 | white | Present Invention |
| 6-5 | 52 | H-59 | H-60 | 122 | 143 | 78 | white | Present Invention |
| 6-6 | 56 | H-59 | H-60 | 133 | 154 | 76 | white | Present Invention |

(continued)

| Organic EL element No. | First light-emitting layer | | Second light-emitting layer | Evaluation | | | | Note |
|---|---|---|---|---|---|---|---|---|
| | Dopant | B host | RG host | Lifetime of light emission | External quantum efficiency | Long-term stability | Color of light | |
| 6-7 | 71 | H-59 | H-60 | 142 | 149 | 77 | white | Present Invention |
| 6-8 | 80 | H-59 | H-62 | 150 | 156 | 84 | white | Present Invention |
| 6-9 | 98 | H-59 | H-62 | 147 | 166 | 83 | white | Present Invention |
| 6-10 | 100 | H-59 | H-62 | 152 | 166 | 83 | white | Present Invention |

As evident from Table 6, the white light-emitting organic EL elements of the present invention using the hexa-coordinated ortho-metalated iridium complexes represented by the general formula (1) as the dopants in the light-emitting layers have higher external quantum efficiencies, and thus longer lifetimes are provided comparing to the comparative examples. In addition, the white light-emitting organic EL elements of the present invention show low decrease rate of power efficiencies and thus have superior long-term stabilities even after long-term storage under high temperature and high humidity.

Example 8

The organic EL elements prepared in Examples 2 to 7 were used in display devices by a common method. These display devices were evaluated by a common method, and superior properties of the organic EL elements were observed.

**Claims**

1. An organic electroluminescent element comprising constituent layers, an anode and a cathode, the constituent layers provided between the anode and the cathode and comprising at least one light-emitting layer,
wherein at least one layer of the constituent layers comprises a hexa-coordinated ortho-metalated iridium complex represented by the following general formula (1)

General formula (1)

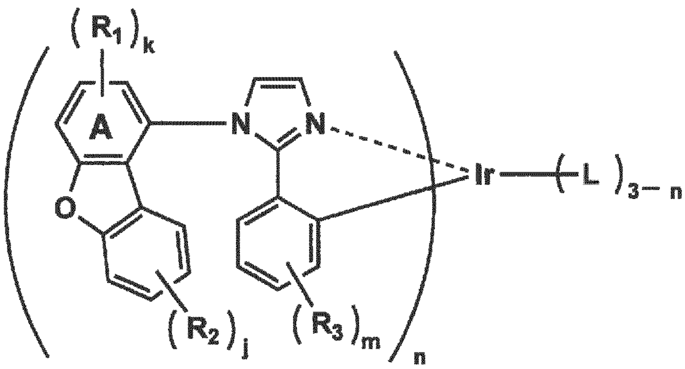

and
wherein in the general formula (1), $R_1$ represents an alkyl group; $R_2$ and $R_3$ each represents a substituent group; n represents an integer from 1 to 3; k represents an integer from 1 to 3; j and m each represents an integer from 0

to 4; and L represents a monoanionic bidentate ligand having coordinate covalent bonds to Ir; **characterized in that**:

the total carbon number summed over all of the substituents $(R_1)_k$ on a ring A is five or less.

**2.** The organic electroluminescent element of Claim 1, wherein the hexa-coordinated ortho-metalated iridium complex represented by the general formula (1) is a hexa-coordinated ortho-metalated iridium complex represented by the following general formula (2)

General formula (2)

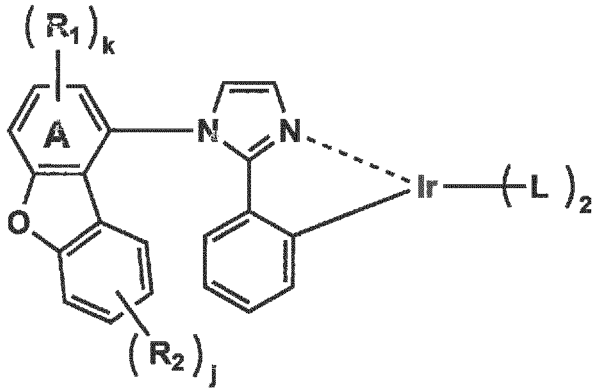

wherein in the general formula (2), $R_1$ represents an alkyl group; the total carbon number summed over all of the substituents $(R_1)_k$ on the ring A is five or less; $R_2$ represents a substituent group; k represents an integer from 1 to 3; j represents an integer from 0 to 4; and L represents a monoanionic bidentate ligand having coordinate covalent bonds to Ir.

**3.** The organic electroluminescent element of Claim 2, wherein the hexa-coordinated ortho-metalated iridium complex represented by the general formula (2) is a hexa-coordinated ortho-metalated iridium complex represented by the following general formula (3)

General formula (3)

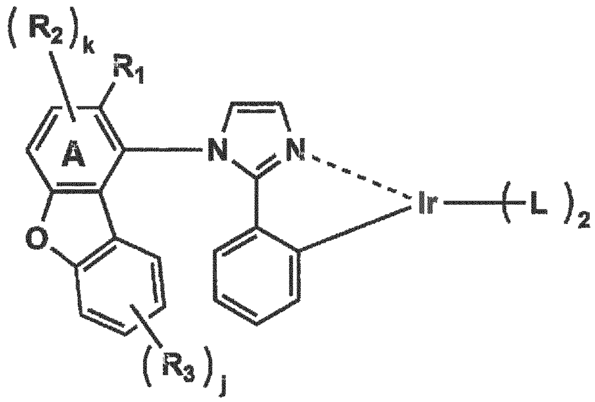

wherein in the general formula (3), $R_1$ and $R_2$ each represents an alkyl group; the total carbon number summed over all of the substituents $R_1$ and $(R_2)_k$ on the ring A is five or less; $R_3$ represents a substituent group; k represents an integer from 0 to 2; j represents an integer from 0 to 4; and L represents a monoanionic bidentate ligand having coordinate covalent bonds to Ir.

**4.** The organic electroluminescent element of Claim 3, wherein the hexa-coordinated ortho-metalated iridium complex represented by the general formula (3) is a hexa-coordinated ortho-metalated iridium complex represented by the

following general formula (4)

General formula (4)

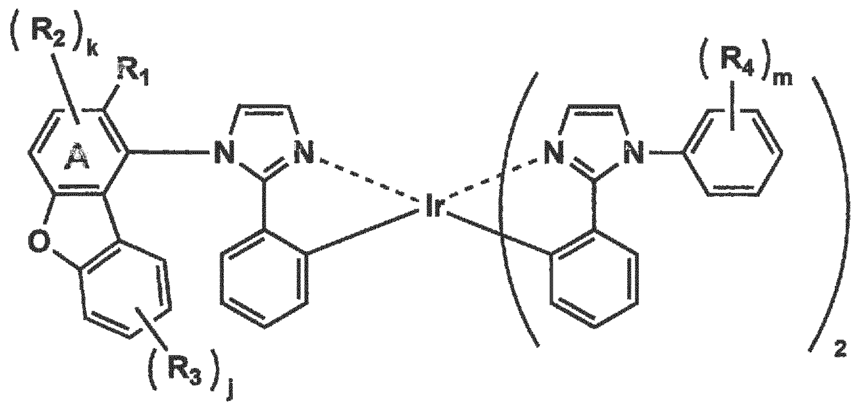

wherein in the general formula (4), $R_1$ and $R_2$ each represents an alkyl group; the total carbon number summed over all of the substituents $R_1$ and $(R_2)_k$ on the ring A is five or less; $R_3$ and $R_4$ each represents a substituent group; k represents an integer from 0 to 2; j represents an integer from 0 to 4; and m represents an integer from 0 to 5.

**5.** The organic electroluminescent element of Claim 4, wherein the hexa-coordinated ortho-metalated iridium complex represented by the general formula (4) is a hexa-coordinated ortho-metalated iridium complex represented by the following general formula (5)

General formula (5)

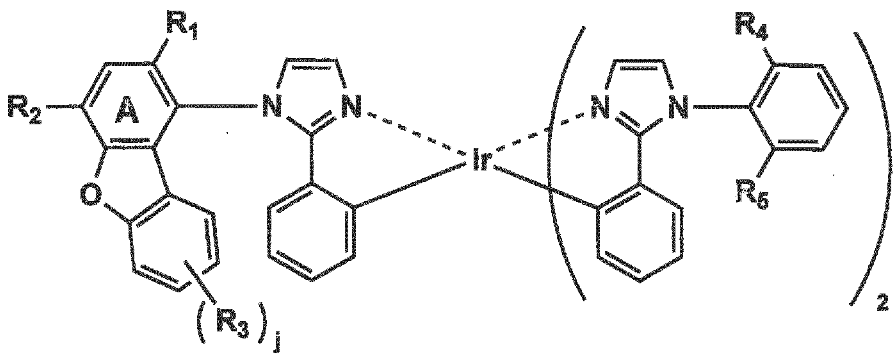

wherein in the general formula (5), $R_1$ and $R_2$ each represents an alkyl group; the total carbon number summed over both of the substituents $R_1$ and $R_2$ on the ring A is five or less; $R_3$ to $R_5$ each represents a substituent group; and j represents 1 or 2.

**6.** The organic electroluminescent element of any one of Claims 1 to 5 wherein the light-emitting layer comprises the hexa-coordinated ortho-metalated iridium complex represented by the general formula (1).

**7.** The organic electroluminescent element of any one of Claims 1 to 6 wherein the electroluminescent element emits white light.

**8.** A display device comprising the organic electroluminescent element of any one of Claims 1 to 7.

**9.** A lighting device comprising the organic electroluminescent element of any one of Claims 1 to 7.

**Patentansprüche**

1. Organisches Elektrolumineszenzelement, welches konstituierende Schichten, eine Anode und eine Kathode umfasst, wobei die konstituierenden Schichten zwischen der Anode und der Kathode angeordnet sind und mindestens eine lichtemittierende Schicht umfassen,
wobei mindestens eine Schicht der konstituierenden Schichten einen hexa-koordinierten ortho-metallierten Iridiumkomplex nach der folgenden allgemeinen Formel (1)

Allgemeine Formel (1)

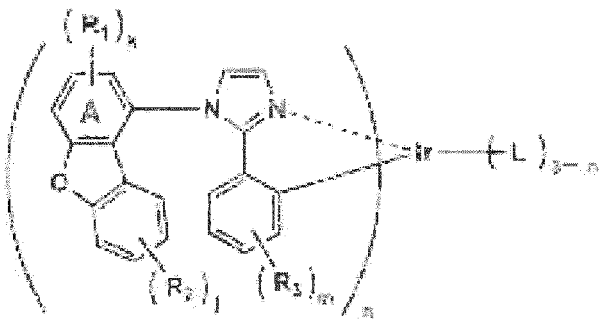

und worin in der allgemeinen Formel (1) $R_1$ eine Alkylgruppe ist; $R_2$ und $R_3$ jeweils eine Substituentengruppe sind; n eine ganze Zahl von 1 bis 3 ist; k eine ganze Zahl von 1 bis 3 darstellt; j und m jeweils eine ganze Zahl von 0 bis 4 sind; und L für einen monoanionischen zweizähnigen Liganden mit koordinierten kovalenten Bindungen zu Ir steht, **dadurch gekennzeichnet, dass** die Gesamtkohlenstoffzahl summiert über alle der Substituenten $(R_1)_k$ an dem Ring A fünf oder weniger ist.

2. Das organische Elektrolumineszenzelement nach Anspruch 1, wobei der hexakoordinierte ortho-metallierte Iridiumkomplex nach der allgemeinen Formel (1) ein hexa-koordinierter ortho-metallierter Iridiumkomplex nach der folgenden allgemeinen Formel (2) ist

Allgemeine Formel (2)

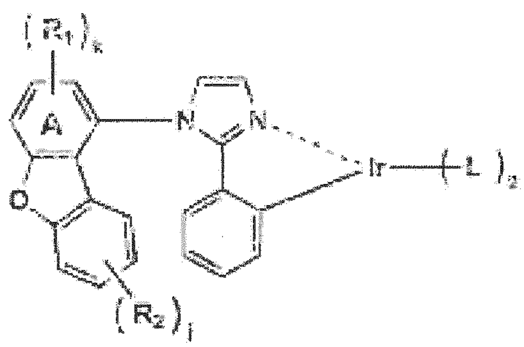

wobei in der allgemeinen Formel (2) $R_1$ eine Alkylgruppe ist; die Gesamtkohlenstoffzahl summiert über alle der Substituenten $(R_1)_k$ an dem Ring A fünf oder weniger ist; $R_2$ eine Substituentengruppe ist; k eine ganze Zahl von 1 bis 3 ist; j eine ganze Zahl von 0 bis 4 ist; und L für einen monoanionischen zweizähnigen Liganden mit koordinierten kovalenten Bindungen zu Ir steht.

3. Das organische Elektrolumineszenzelement nach Anspruch 2, wobei der hexakoordinierte ortho-metallierte Iridiumkomplex nach der allgemeinen Formel (2) ein hexa-koordinierter ortho-metallierter Iridiumkomplex nach der folgenden allgemeinen Formel (3) ist

Allgemeine Formel (3)

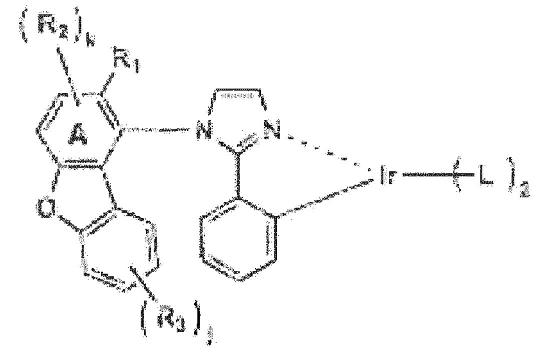

wobei in der allgemeinen Formel (3) $R_1$ und $R_2$ jeweils eine Alkylgruppe sind; die Gesamtkohlenstoffzahl summiert über alle der Substituenten $R_1$ und $(R_2)_k$ an dem Ring A fünf oder weniger ist; $R_3$ eine Substituentengruppe ist; k eine ganze Zahl von 0 bis 2 ist; j eine ganze Zahl von 0 bis 4 ist; und L für einen monoanionischen zweizähnigen Liganden mit koordinierten kovalenten Bindungen zu Ir steht.

**4.** Das organische Elektrolumineszenzelement nach Anspruch 3, wobei der hexakoordinierte ortho-metallierte Iridiumkomplex nach der allgemeinen Formel (3) ein hexa-koordinierter ortho-metallierter Iridiumkomplex nach der folgenden allgemeinen Formel (4) ist

Allgemeine Formel (4)

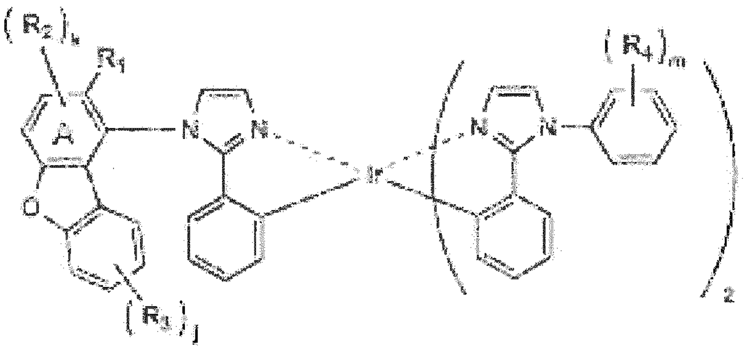

wobei in der allgemeinen Formel (4) $R_1$ und $R_2$ jeweils eine Alkylgruppe sind; die Gesamtkohlenstoffzahl summiert über alle der Substituenten $R_1$ und $(R_2)_k$ an dem Ring A fünf oder weniger ist; $R_3$ und $R_4$ jeweils eine Substituentengruppe sind; k eine ganze Zahl von 0 bis 2 ist; j eine ganze Zahl von 0 bis 4 ist; und m eine ganze Zahl von 0 bis 5 ist.

**5.** Das organische Elektrolumineszenzelement nach Anspruch 4, wobei der hexakoordinierte ortho-metallierte Iridiumkomplex nach der allgemeinen Formel (4) ein hexa-koordinierter ortho-metallierter Iridiumkomplex nach der folgenden allgemeinen Formel (5) ist

Allgemeine Formel (5)

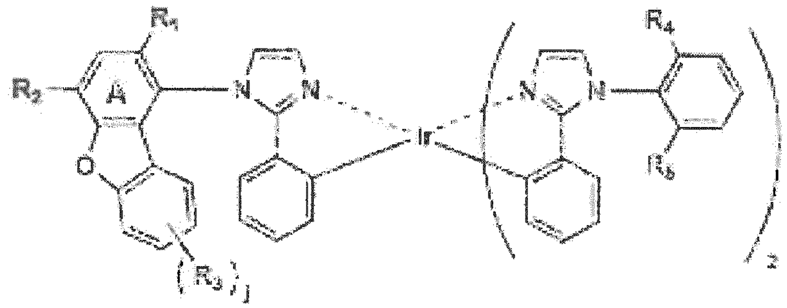

wobei in der allgemeinen Formel (5) $R_1$ und $R_2$ jeweils eine Alkylgruppe sind; die Gesamtkohlenstoffzahl summiert über beide Substituenten $R_1$ und $R_2$ an dem Ring A fünf oder weniger ist; $R_3$ bis $R_5$ jeweils eine Substituentengruppe sind; und j 1 oder 2 ist.

**6.** Das organische Elektrolumineszenzelement nach einem der Ansprüche 1 bis 5, wobei die licht-emittierende Schicht den hexa-koordinierten ortho-metallierten Iridiumkomplex nach der allgemeinen Formel (1) umfasst.

**7.** Das organische Elektrolumineszenzelement nach einem der Ansprüche 1 bis 6, wobei das Elektrolumineszenzelement weißes Licht emittiert.

**8.** Anzeigevorrichtung, umfassend das organische Elektrolumineszenzelement nach einem der Ansprüche 1 bis 7.

**9.** Beleuchtungsvorrichtung, umfassend das organische Elektrolumineszenzelement nach einem der Ansprüche 1 bis 7.

## Revendications

**1.** Élément électroluminescent organique comprenant des couches constitutives, une anode et une cathode, les couches constitutives étant prévues entre l'anode et la cathode et comprenant au moins une couche lumineuse, où au moins une couche des couches constitutives comprend un complexe d'iridium ortho-métallé hexa-coordonné représenté par la formule générale (1) suivante

Formule générale (1)

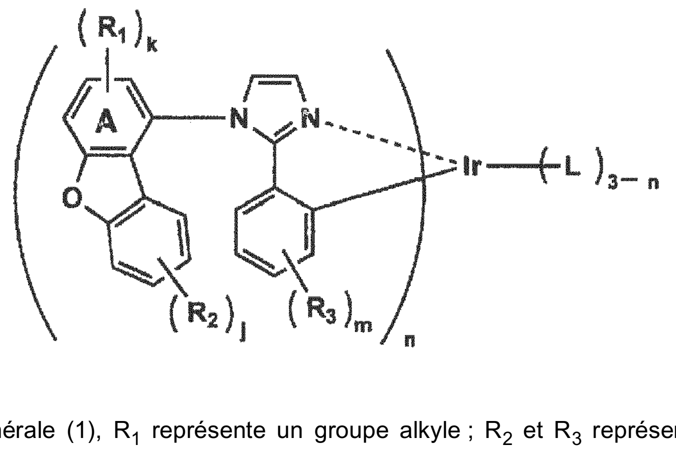

et
où, dans la formule générale (1), $R_1$ représente un groupe alkyle ; $R_2$ et $R_3$ représentent chacun un groupe substituant ; n représente un nombre entier de 1 à 3 ; k représente un nombre entier de 1 à 3 ; j et m représentent chacun un nombre entier de 0 à 4 ; et L représente un ligand bidenté monoanionique ayant des liaisons covalentes de coordination avec Ir ; **caractérisé en ce que** :

le nombre total d'atomes de carbone dans tous les substituants $(R_1)_k$ sur un noyau A est inférieur ou égal à cinq.

**2.** Élément électroluminescent organique de la revendication 1, dans lequel le complexe d'iridium ortho-métallé hexa-coordonné représenté par la formule générale (1) est un complexe d'iridium ortho-métallé hexa-coordonné représenté par la formule générale (2) suivante

Formule générale (2)

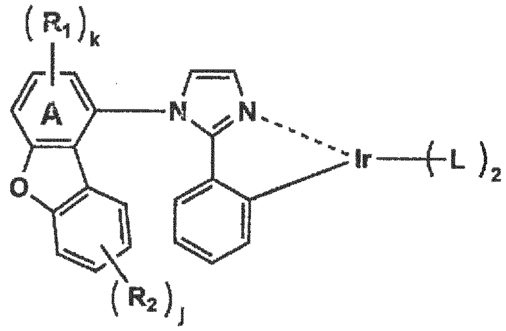

où, dans la formule générale (2), $R_1$ représente un groupe alkyle ; le nombre total d'atomes de carbone dans tous les substituants $(R_1)_k$ sur le noyau A est inférieur ou égal à cinq ; $R_2$ représente un groupe substituant ; k représente un nombre entier de 1 à 3 ; j représente un nombre entier de 0 à 4 ; et L représente un ligand bidenté monoanionique ayant des liaisons covalentes de coordination avec Ir.

**3.** Élément électroluminescent organique de la revendication 2, dans lequel le complexe d'iridium ortho-métallé hexa-coordonné représenté par la formule générale (2) est un complexe d'iridium ortho-métallé hexa-coordonné représenté par la formule générale (3) suivante

Formule générale (3)

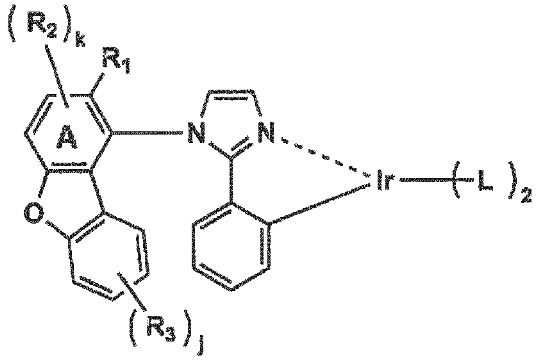

où, dans la formule générale (3), $R_1$ et $R_2$ représentent chacun un groupe alkyle ; le nombre total d'atomes de carbone dans tous les substituants $R_1$ et $(R_2)_k$ sur le noyau A est inférieur ou égal à cinq ; $R_3$ représente un groupe substituant ; k représente un nombre entier de 0 à 2 ; j représente un nombre entier de 0 à 4 ; et L représente un ligand bidenté monoanionique ayant des liaisons covalentes de coordination avec Ir.

**4.** Élément électroluminescent organique de la revendication 3, dans lequel le complexe d'iridium ortho-métallé hexa-coordonné représenté par la formule générale (3) est un complexe d'iridium ortho-métallé hexa-coordonné représenté par la formule générale (4) suivante

Formule générale (4)

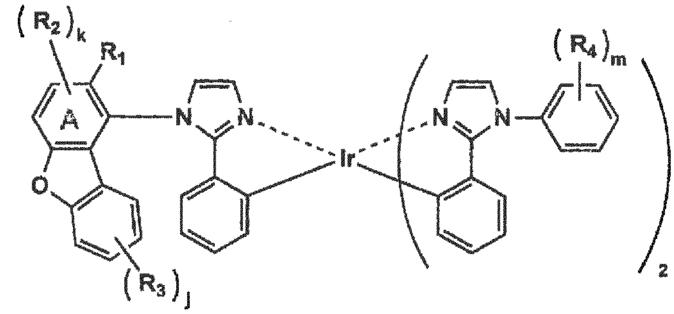

où, dans la formule générale (4), $R_1$ et $R_2$ représentent chacun un groupe alkyle ; le nombre total d'atomes de carbone dans tous les substituants $R_1$ et $(R_2)_k$ sur le noyau A est inférieur ou égal à cinq ; $R_3$ et $R_4$ représentent chacun un groupe substituant ; k représente un nombre entier de 0 à 2 ; j représente un nombre entier de 0 à 4 ; et m représente un nombre entier de 0 à 5.

**5.** Élément électroluminescent organique de la revendication 4, dans lequel le complexe d'iridium ortho-métallé hexa-coordonné représenté par la formule générale (4) est un complexe d'iridium ortho-métallé hexa-coordonné représenté par la formule générale (5) suivante

Formule générale (5)

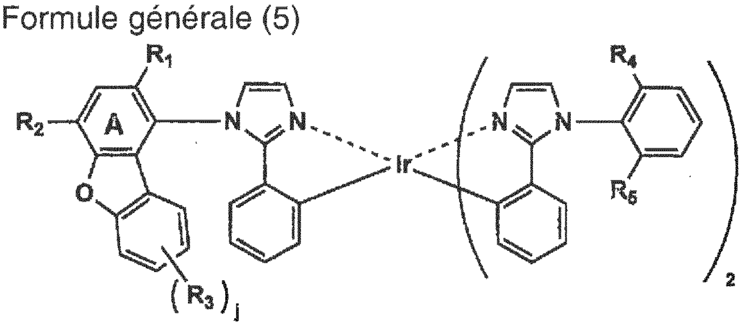

où, dans la formule générale (5), $R_1$ et $R_2$ représentent chacun un groupe alkyle ; le nombre total d'atomes de carbone dans les deux substituants $R_1$ et $R_2$ sur le noyau A est inférieur ou égal à cinq ; $R_3$ à $R_5$ représentent chacun un groupe substituant ; et j vaut 1 ou 2.

**6.** Élément électroluminescent organique de l'une quelconque des revendications 1 à 5, dans lequel la couche lumineuse comprend le complexe d'iridium ortho-métallé hexa-coordonné représenté par la formule générale (1).

**7.** Élément électroluminescent organique de l'une quelconque des revendications 1 à 6, dans lequel l'élément électroluminescent émet de la lumière blanche.

**8.** Dispositif d'affichage comprenant l'élément électroluminescent organique de l'une quelconque des revendications 1 à 7.

**9.** Dispositif d'éclairage comprenant l'élément électroluminescent organique de l'une quelconque des revendications 1 à 7.

FIG.1

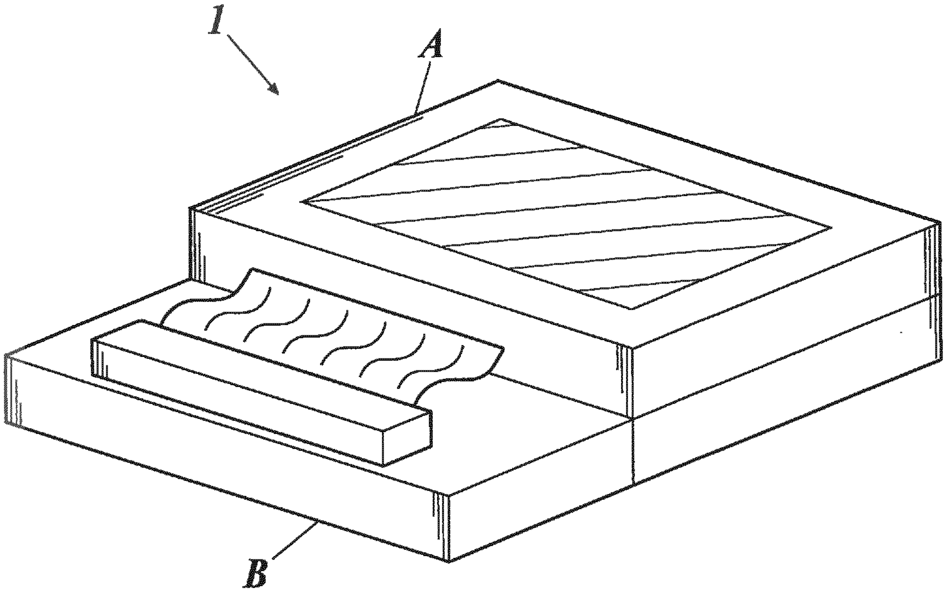


FIG.2

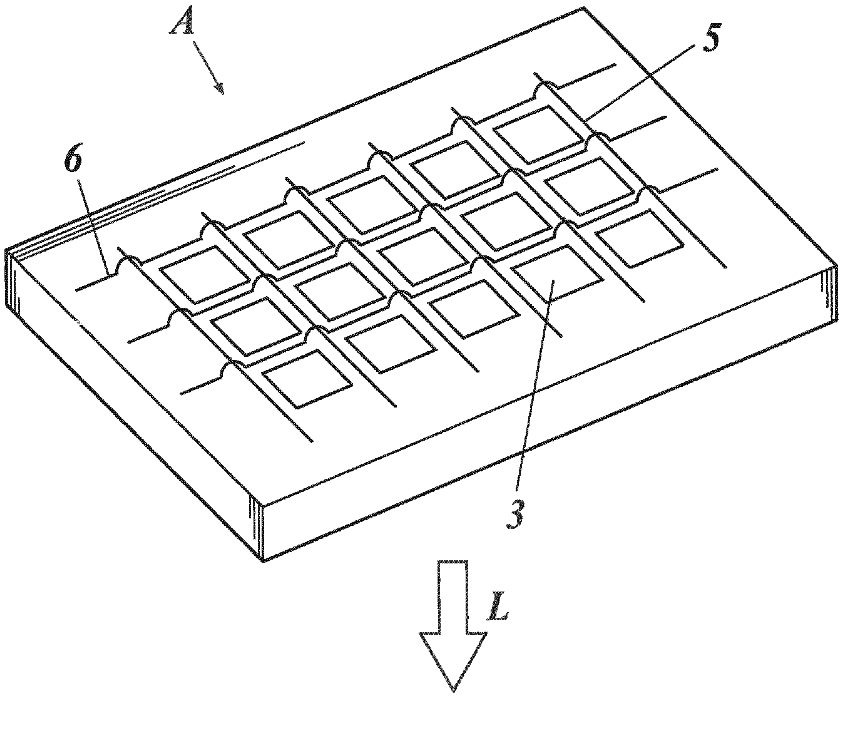

FIG.3

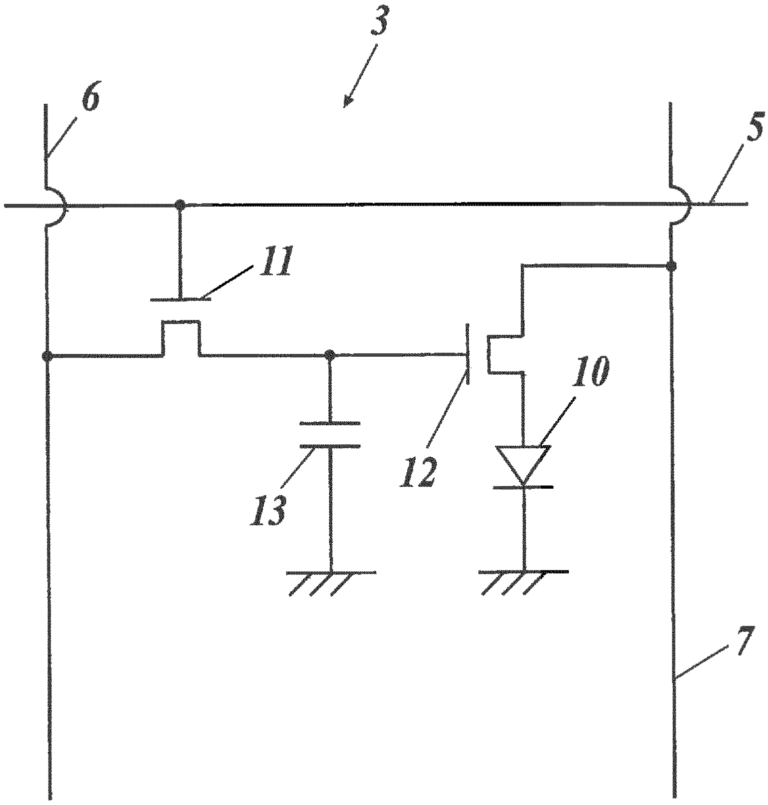

FIG.4

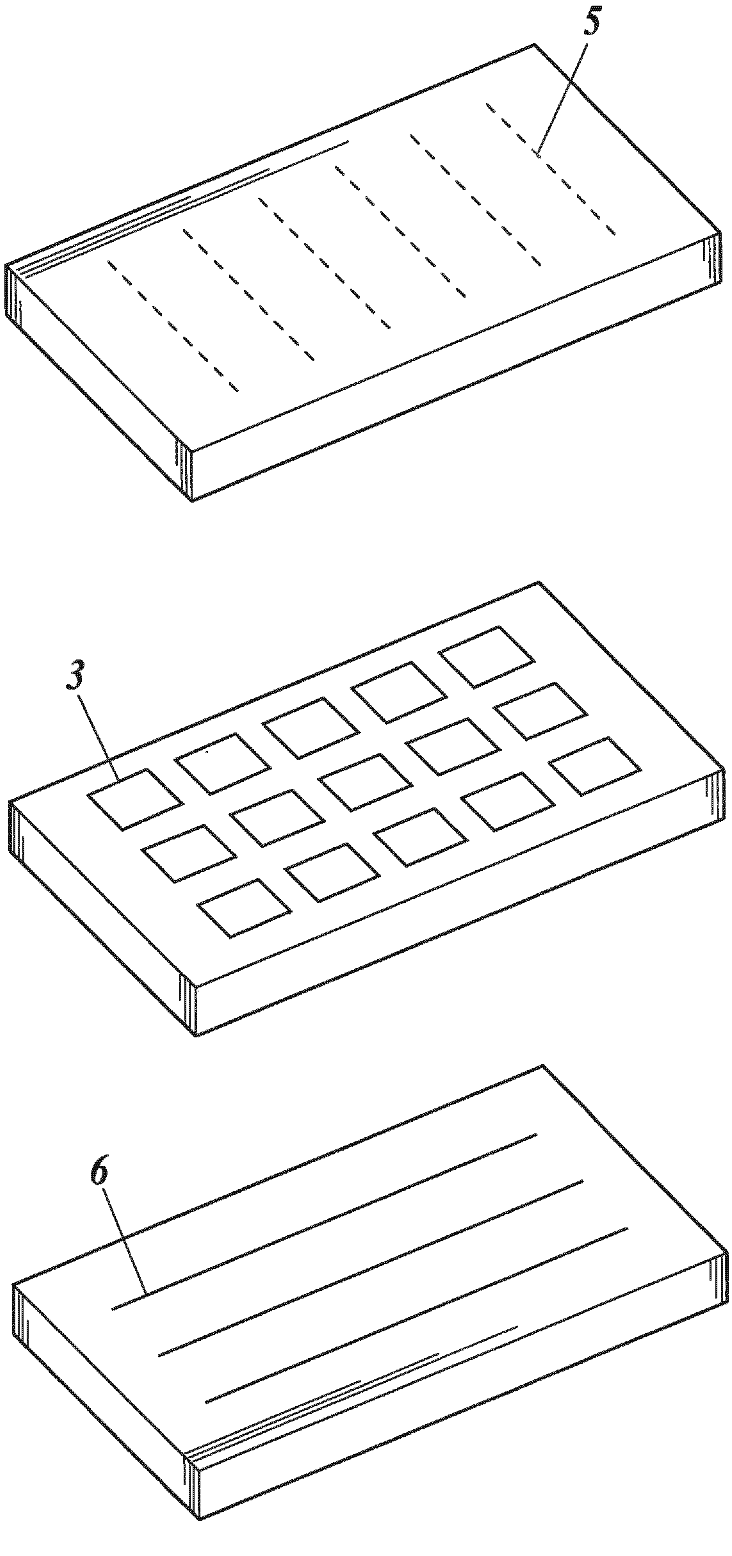

FIG.5

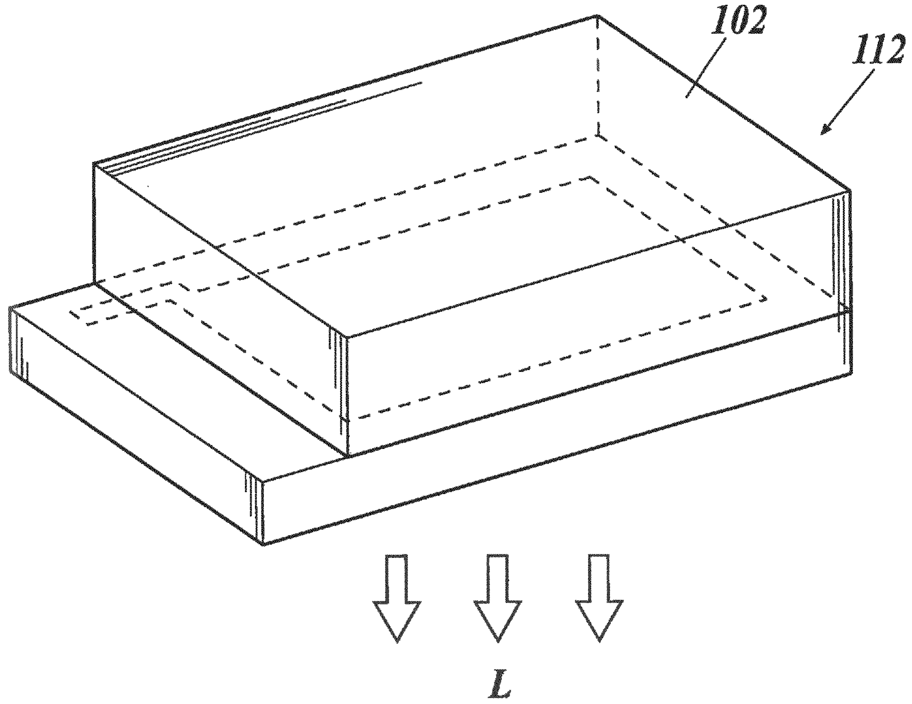


FIG.6

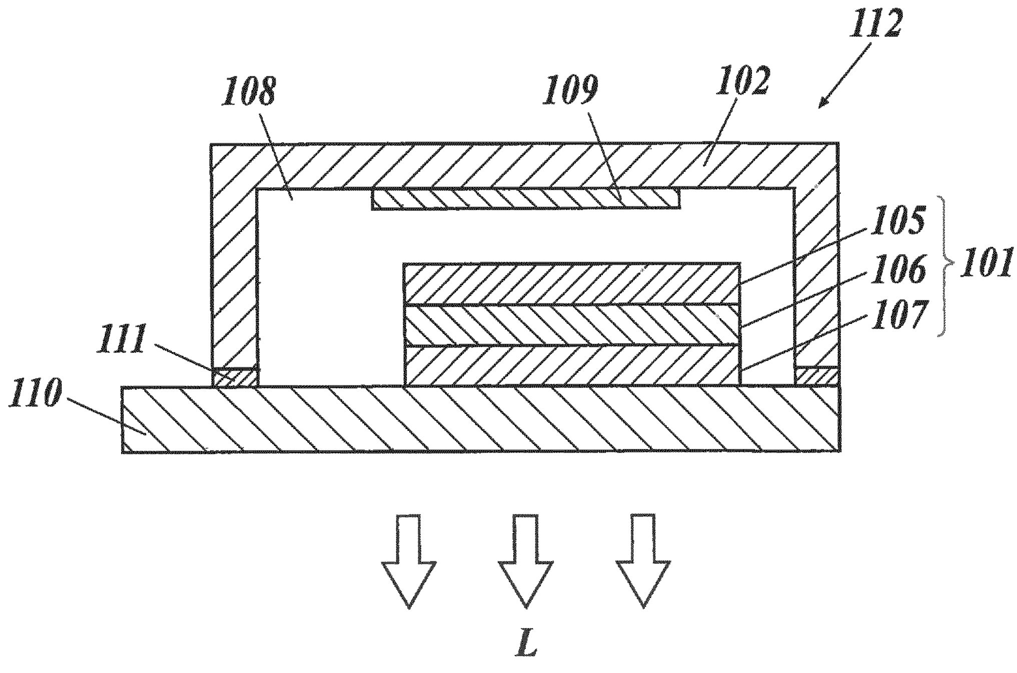

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 6097147 A
- JP 2005327526 A
- WO 2006046980 A
- WO 2005019373 A
- US 20110204333 A
- US 2011204333 A
- US 2011024333 A
- WO 0070655 A
- JP 2002280178 A
- JP 2001181616 A
- JP 2002280179 A
- JP 2001247859 A
- JP 2002299060 A
- JP 2001313178 A
- JP 2002302671 A
- JP 2001181617 A
- JP 2002280180 A
- JP 2001345183 A
- JP 2002324679 A
- WO 0215645 A
- JP 2002332291 A
- JP 2002050484 A
- JP 2002332292 A
- JP 2002083684 A
- JP 2002540572 A
- JP 2002117978 A
- JP 2002338588 A
- JP 2002170684 A
- JP 2002352960 A
- WO 0193642 A
- JP 2002050483 A
- JP 2002100476 A
- JP 2002173674 A
- JP 2002359082 A
- JP 2002175884 A
- JP 2002363552 A
- JP 2002184582 A
- JP 2003007469 A
- JP 2002525808 A
- JP 2003007471 A
- JP 2002525833 A
- JP 2003031366 A
- JP 2002226945 A
- JP 2002234894 A
- JP 2002235076 A
- JP 2002241751 A
- JP 2001319779 A
- JP 2001319780 A
- JP 2002062824 A
- JP 2002100474 A
- JP 2002203679 A
- JP 2002343572 A
- JP 2002203678 A
- JP 2001257076 A
- JP 2002308855 A
- JP 2001313179 A
- JP 2002319491 A
- JP 2001357977 A
- JP 2002334786 A
- JP 2002008860 A
- JP 2002334787 A
- JP 2002015871 A
- JP 2002334788 A
- JP 2002043056 A
- JP 2002334789 A
- JP 2002075645 A
- JP 2002338579 A
- JP 2002105445 A
- JP 2002343568 A
- JP 2002141173 A
- JP 2002352957 A
- JP 2002203683 A
- JP 2002363227 A
- JP 2002231453 A
- JP 2003003165 A
- JP 2002234888 A
- JP 2003027048 A
- JP 2002255934 A
- JP 2002260861 A
- JP 2002280183 A
- JP 2002302516 A
- JP 2002305083 A
- JP 2002305084 A
- JP 2002308837 A
- JP HEI945479 B
- JP HEI9260062 A
- JP HEI8288069 A
- JP 2003519432 A
- JP 2006135145 A
- JP HEI6325871 B
- JP HEI917574 A
- JP HEI1074586 A
- JP HEI11204258 B
- JP HEI11204359 A
- US 5061569 A
- JP HEI4308688 B
- JP HEI11251067 B
- JP HEI4297076 B

- JP 2000196140 A
- JP 2001102175 A
- JP 2004068143 A
- US 4774435 A
- JP SHO63314795 B
- JP HEI1220394 B
- JP SHO62172691 B
- JP 2001202827 A
- JP HEI11283751 B

**Non-patent literature cited in the description**


- **M. A. BALDO et al.** *Nature,* 1998, vol. 395, 151-154
- **M. A. BALDO et al.** *Nature,* 2000, vol. 403 (17), 750-753
- **C. ADACHI et al.** *Appl. Phys. Lett.,* 2001, vol. 79, 2082-2084
- **M. A. BALDO et al.** *Nature,* 2000, vol. 403-17
- the fourth series of Experimental Chemistry 7, Spectroscopy II. MARUZEN Co., Ltd, 1992, 398
- Electrode material. The frontier of Organic EL element and its industrialization. NTS Inc, 30 November 1998, 123-166
- The frontier of Organic EL element and its industrialization. NTS Inc, 30 November 1998, 237
- **M.J.FRISCH et al.** Gaussian98, Revision A.11.4. Gaussian Inc, 2002
- **J. HUANG et al.** *Applied Physics Letters,* 2002, vol. 80, 139
- *J. Appl. Phys.,* 2004, vol. 95, 5773
- Handbook of Color Science. University of Tokyo Press, 1985, 108